(19) Europäisches Patentamt
European Patent Office
Office européen des brevets

(11) EP 0 787 537 A1

(12) EUROPEAN PATENT APPLICATION
published in accordance with Art. 158(3) EPC

(43) Date of publication:
**06.08.1997 Bulletin 1997/32**

(21) Application number: **95934846.7**

(22) Date of filing: **19.10.1995**

(51) Int. Cl.[6]: **B08B 3/08**

(86) International application number:
**PCT/JP95/02149**

(87) International publication number:
**WO 96/12571 (02.05.1996 Gazette 1996/20)**

(84) Designated Contracting States:
**DE ES FR GB IT NL**

(30) Priority: **19.10.1994 JP 253487/94**
**19.10.1994 JP 253488/94**
**19.10.1994 JP 253489/94**
**19.10.1994 JP 253490/94**
**19.10.1994 JP 253491/94**
**19.10.1994 JP 253492/94**
**10.04.1995 JP 84066/95**
**02.05.1995 JP 108410/95**
**02.05.1995 JP 108411/95**
**02.05.1995 JP 108412/95**

(71) Applicants:
- **KABUSHIKI KAISHA TOSHIBA**
  **Kawasaki-shi, Kanagawa-ken 210 (JP)**
- **TOSHIBA SILICONE CO., LTD.**
  **Tokyo 106 (JP)**

(72) Inventors:
- **KUMAGAI, Masaru**
  **Yokohama-shi Kanagawa 221 (JP)**
- **SHIMOZAWA, Hiroshi**
  **Kanagawa 216 (JP)**
- **OGUNI, Naoyuki**
  **Kanagawa 223 (JP)**
- **INADA, Minoru**
  **Kanagawa 235 (JP)**
- **SAITO, Nobuhiro**
  **Gunma 373 (JP)**
- **YAMAFUJI, Shigeo**
  **Shizuoka 412 (JP)**
- **SHIMIZU, Chiyuki**
  **Gunma 373 (JP)**
- **UMEHARA, Kazunori**
  **Tokyo 168 (JP)**

(74) Representative: **Henkel, Feiler, Hänzel & Partner**
**Möhlstrasse 37**
**81675 München (DE)**

# (54) CLEANING AGENT, METHOD AND EQUIPMENT

(57) A cleaning agent which can substitute for chlorofluorocarbon or chlorinated solvents, a method of cleaning therewith, and equipment therefor. In particular, a method of cleaning electronics parts such as printed boards or mounted parts or metallic parts which makes it possible to remove various contaminants from the parts and dry the same to the extent comparative to that of the method of cleaning with chlorofluorocarbon or chlorinated solvents, and a cleaning agent and equipment therefor. Examples of the cleaning agent include polar cleaning agents with a solubility parameter of 9 or above or a permittivity of 4 or above, mixtures thereof with other cleaning agents with a solubility parameter of less that 9 and a permittivity of less than 4, and cleaning agents containing as the active ingredient an azeotropic or pseudoazeotropic composition containing a low-molecular-weight siloxane compound. The cleaning method is characterized by comprising at least one step selected from the group consisting of the step of cleaning the object with a polar cleaning agent having a solubility parameter of 9 or above or a permittivity of 4 or above, the step of rinsing the object with a mixture of the above polar cleaning agent with another cleaning agent having a solubility parameter of less than 9 and a permittivity of less than 4, and the drying step.

FIG. 5

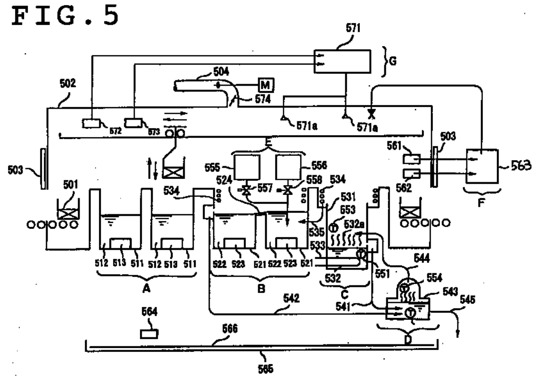

EP 0 787 537 A1

Printed by Rank Xerox (UK) Business Services
2.14.12/3.4

## Description

### TECHNICAL FIELD

The present invention relates to a cleaning agent replacing solvents of flons or chlorides, a cleaning method, and a cleaning apparatus.

### BACKGROUND ART

In manufacturing processes, various dirts attach to electronic parts such as an HIC, modules, substrates on which electronic parts are mounted; metal thin films such as lead frames for use in a transistor, hoop materials; bearings; precision component parts; and the like. The dirts include water-mixed machining oils or solvent-mixed oils such as resist agent, flux, solder paste, cutting oil, quenching oil, rolling oil, press oil, die cutting oil, drawing oil, assembling oil, wire-drawing oil, dust and the like.

For example, the process of manufacturing a printed circuit board comprises the step of manufacturing a substrate (bare board) and the step of mounting integrated circuits and electronic component parts on the substrate. In the step of manufacturing the substrate, acid, alkali or the like to be used in printing and etching works attach to various component parts. In the step of mounting the integrated circuits and the electronic component parts on the substrate, dirt such as soldering or flux to be used to solder them to the substrate attach thereto. Dirty substances required to be removed from electronic parts or the like are active agents contained in the flux; $CuCl_2$ which is a product of the reaction of the active agents and an oxide films of parent material; and salts of organic acids such as $(RCOO)_2Cu$. Because these substances are polar materials, those present on the electronic parts or the like cause leak, migration, reduction in insulation resistance value, corrosion of pins or wires because they absorb moisture. In addition, in the process of manufacturing semiconductors, mixing of ionized substances with component parts is a serious problem, thus causing "sodium panic". Further, dirty components which remained on processed metal parts cause them to be corroded or changed in color. Thus, it is necessary to remove dirty components from electronic parts or the like before a subsequent process is carried out or during manufacturing.

As cleaning agents for removing dirty components from electronic parts or the like, solvents of flons represented by flon 113 and organic solvents such as trichloroethane, trichloroethylene, tetrachloroethylene, carbon tetrachloride have been widely used. But in recent years, it was discovered that flon discharged to the atmospheric air destroys the ozone layer and gives a serious influence to human body and biological system. Therefore, in the near future, flon 12, flon 113 and the like will be abolished worldwide. Further, the use of chlorinated organic solvents such as trichloroethylene or tetrachloroethylene will be prohibited in the near future because they pollute soil and underground water.

Under these circumstances, there are growing demands for the reduction of the use amount of the above-described chlorinated organic solvents and for the development of alternate cleaning agents which enable the chlorinated organic solvents to be abolished wholly. The alternate cleaning agents are required to have improved degreasing and drying properties and flame-retardancy and incombustibility. Under these circumstances, the use of the following alternate cleaning agents are considered recently: A mixture of flon 113 and isopropyl alcohol; a mixture of flon 113 and methyl ethyl ketone; azeotropic compositions consisting of flon 234 and aliphatic lower alcohols such as ethanol; alcohols such as isopropyl alcohol; ketones such as acetone; and ethers.

The use amount of the chlorinated organic solvents can be reduced by using mixtures of the chlorinated organic solvents and organic solvents or using azeotropic compositions, but the use thereof cannot be abolished wholly. For example, even though flon 234 whose ozone depletion coefficient is smaller than that of flon 113 is used, it merely reduces the degree of destruction of the ozone layer, thus not satisfying the demand for the alternate cleaning agents. The organic solvents such as alcohols, ketones, and ethers deteriorate objects made of plastic and the like. Further, these organic solvents are combustible, thus causing danger in storage and use. In addition, some compounds thereof are poisonous to the human body.

Therefore, attempts for cleaning many kinds of industrial products with water, alkaline solvents or other kinds of solvents are being made. As methods of cleaning printed circuits boards, a method of removing water-soluble flux with pure water (first method); removing flux with a solvent and then rinsing the solvent with water (second method); and cleaning it with organic solvents such as solvents of hydrocarbons.

The above-described first and second cleaning methods are capable of removing polar substances, but deteriorate electric resistance such as insulation resistance of electric component parts due to the permeation of water into glass epoxy substrates or paper phenol substrates. Moreover, these methods do not have fine drying functions, thus causing rust, color changes or stains on precision component parts. Thus, these methods degrade the appearances and characteristics thereof.

When the electrical and drying characteristics of objects are considered, it is preferable to use nonpolar solvents such as solvents of hydrocarbons. But they are incapable of favorably cleaning ionized and polar substances and very dirty components. That is, the element constituting the characteristic necessary for cleaning objects and that constituting the characteristic necessary for drying them are opposite to each other. Hence, it is very difficult to select alternate agents appropriate for cleaning electronic parts and precision parts, although researches for cleaning them with water, alkaline solvents or other kinds of solvents are being made.

As described above, the conventional cleaning methods using water or solvent/water proposed currently to replace the flon solvent are capable of removing polar substances from objects favorably, but deteriorate electrical characteristics of electric component parts and moreover, degrade the appearances and characteristics thereof. The nonpolar solvents such as those of hydrocarbons are incapable of favorably cleaning ionized, polar substances, and very dirty objects.

Such being the case, there is a growing demand for the development of a cleaning method capable of favorably removing various kinds of dirts such as ionized and polar substances from objects and satisfying the demanded drying property, namely, keeping the original appearances and characteristics of objects after they are dried.

Silicone solvents represented by low molecular weight polyorganosiloxanes are superior in drying property and nonaqueous and not harmful to environment and human body. Further, they are capable of cleaning precision parts. Thus, it is expected that they are the cleaning agent which can replace the flon solvent. The characteristics of the silicone solvents are shown in table 1.

Table 1

| | CFC113 | Water | IPA | Methylene chloride | Low-molecular siloxane |
|---|---|---|---|---|---|
| Degree of poison to human body | ○ | ○ | △ | X | ○ |
| ODP | X | ○ | ○ | X | ○ |
| GWP | X | ○ | X | △ | ○ |
| VOC regulation | X | ○ | X | X | ○ |
| Drying characteristics (stains) | ○ | X | X | △ | ○ |
| Influence on plastic elastomer *1 | ○ | ○ | X | X | ○ |
| Influence on metal | ○ | X | ○ | △ | ○ |
| Recycle | ○ | X*2 | X*3 | ○ | ○ |
| Flammability | ○ | ○ | X | ○ | X |

○: Favorable characteristics because unpoisonous, no regulations are imposed thereon, and gives no influences.
△: Characteristic intermediate between those expressed by ○ and X.
X: Unfavorable characteristics because poisonous, regulations are imposed thereon, and gives influences.

Note
*1: Solvent attack and influence by swell.
*2: Large-scale equipment of active carbon, reverse osmosis film, and ion exchange cause waste water treatment to be difficult.
*3: It is difficult to separate IPA from water by distillation because mixture of IPA and water forms azeotropic composition.

As shown in table 1, the replacing solvents of halogenated hydrocarbons other than the low molecular weight siloxane compound leave stains on dried objects. In a cleaning system in which water is used as a cleaning agent, technical problems have not been solved: Inexpensive effluent equipments have not been developed, means for preventing objects from being rusted have not developed, means for preventing electrical characteristics of electric component parts from deteriorating. On the other hand, the low molecular weight siloxane compound represented by low molecular weight polyorganosiloxanes is superior in its drying property, not harmful to environment and human body, and can be used to clean precision parts of various industrial fields. But the low molecular weight siloxane compound is flammable and thus it is necessary to take a safety measure against fire in using it.

In utilizing a cleaning agent replacing the chlorinated organic solvent as a cleaning agent in industry, it is necessary

to consider its drying characteristic as the final step of cleaning. Vapor drying which utilizes vapor of a solvent is fine. Vapor drying treats an object at a high drying speed and allows the object to have a fine finish, thus cleaning precision component parts finely. Ideally, a cleaning agent can be used in all of cleaning, rinsing, and drying processes as accomplished by flon 113 and trichloroethane. But as described above, flon 113 and trichloroethane destroy environment. Therefore, researches are being made to develop cleaning agents having a composition consisting of an incombustible solvent having a fine drying property and a combustible solvent mixed with the incombustible solvent.

As described above, perfluorocarbons and perfluoroethers are not so harmful to human body as other solvents and do not destroy the ozone layer, because these substances do not contain chlorine. But the problem of these substances is that they are incapable of removing fat and oil and incompatible with organic solvents. Thus, their cleaning performance cannot be improved even though they are mixed with organic solvents. Further, they are expensive and some of them have a favorable drying property and hence a high vapor pressure. Accordingly, much losses of liquid are caused by vaporization and thus they cost high.

Azeotropic or pseudo-azeotropic compositions are preferably used as cleaning agents. Because a fractional distillation does not occur in the azeotropic composition when it boils, it is capable of eliminating the flammability of a combustible solvent. In addition, a cleaning agent contaminated with a dirt component can be recovered without change in its composition by utilizing a vapor cleaning apparatus.

As the above-described compositions, a uniform liquid mixed composition consisting of hexamethyldisiloxane compatibilized with perfluoro hydrocarbons or perfluoro ethers is disclosed in Laid-Open Japanese Patent Publication HEI6-71238. But the mixed liquid composition disclosed therein does not have a degreasing property appropriate for removing fat and oil to a high degree. Thus, it cannot be used for all of cleaning, rinsing, and drying processes unless it is improved in its composition.

As azeotropic or pseudo-azeotropic composition, an azeotropic mixed composition consisting of 2-trifluoromethyl-1,1,1,2-tetrafluorobutane, methanol, and ethanol or isopropanol is disclosed in Laid-Open Japanese Patent Publication(TOKUHYOU) HEI6-509836. An azeotropic or pseudo-azeotropic composition consisting of hexamethyldisiloxane, methanol, and 2-propanol or ethanol is disclosed in Laid-Open Japanese Patent Publication HEI5-339275 and HEI6-88098.

The above-described azeotropic compositions or the pseudo-azeotropic compositions have, however, problems that they are incapable of removing oily dirt to a high degree and further, absorb moisture when they are used continuously, because they contain hydrophilic polar solvents such as methanol, ethanol, and isopropanol. Consequently, it is likely that they generate stains on objects or rust on metal parts. Moreover, it is necessary to make them incombustible and improve their drying property.

As described above, the conventional cleaning agents consisting of azeotropic compositions or pseudo-azeotropic compositions proposed to replace the chlorinated organic solvent are not as fine as the solvents of flons in their degreasing and drying properties. Further, they are required to be flame-retardant or incombustible.

Such being the case, there is a growing demand for the development of azeotropic compositions or pseudo-azeotropic compositions and the development of cleaning agents which contain them as their effective component, does not destroy the ozone layer and deteriorate plastic objects, can be used in cleaning process through drying process similarly to flon 113 and 1,1,1-trichloroethane, is not changed in its composition, and are flame-retardant or incombustible.

When solvents of halogenated hydrocarbons are used, normally, objects are dewatered and dried after they are plated or cleaned with water to dry them without stains being left thereon. Alcohols in particular, isopropyl alcohol (IPA) is used currently for this purpose. But IPA has a high heat of vaporization and absorbs moisture from atmospheric air, thus generating stains conspicuously on dried objects.

Because a mixture of alcohols such as IPA and water forms an azeotropic composition, alcohols cannot be separated from water by distillation. Thus, they cannot be recovered. Further, because alcohols have low vapor densities, they are lost in a great degree due to volatility and in addition, they dry slowly. Thus, even after objects are dried by vapor, they are required to be dried by hot air depending on a case.

As a method of solving the above-described problems, there is proposed a dewatering method in which a mixture of perfluorohexane and trifluoroethanol is used. Because the perfluorohexane is not hydrophilic, the mixture does not have a favorable dewatering property. Perfluorohexane and trifluoroethanol are not compatible with each other in a liquid state. Therefore, it is necessary to keep the mixture liquid and further, its condensed liquid wets the surface of an object nonuniformly, which may generate stains on object.

Attempts for using trifluoroethanol as a degreasing cleaning agent are made, it has a low solubility in fat and oil and rosin because it has a very strong polarity due to electronic attractive effect of a trifluoro radical. Thus, trifluoroethanol is not suitable as the degreasing cleaning agent.

The present invention has been made to overcome the above-described problems. It is accordingly a first object of the present invention to provide a cleaning agent, a cleaning method, and a cleaning apparatus having dirt-removing and drying properties as finely as a cleaning method and a cleaning apparatus by using solvents of flons and chlorinated solvents in cleaning electronic component parts such as printed circuit boards and component parts to be mounted thereon or metal component parts.

It is a second object of the present invention to provide a cleaning method and a cleaning apparatus allowing a flammable low molecular weight siloxane compound to be used safely and effectively.

It is a third object of the present invention to provide a cleaning agent which does not destroy the ozone layer and deteriorate plastic objects, has preferable cleaning and drying properties, is not changed in its composition, and is flame-retardant or incombustible or which contains an azeotropic or pseudo-azeotropic composition capable of preventing water from being contained therein.

It is a fourth object of the present invention to provide a dewatering cleaning method and a cleaning apparatus capable of drying objects at a high speed without stains being left thereon as favorably as solvents of flons and chlorinated solvents.

## DISCLOSURE OF THE INVENTION

A first cleansing method of the present invention comprises at least one step selected from the group consisting of cleaning an object with a polar cleaning agent having a solubility parameter not less than nine or a dielectric constant not less than four, rinsing the object by means of a mixed cleaning agent containing the polar cleaning agent having the solubility parameter not less than nine or the dielectric constant not less than four and a cleaning agent having a solubility parameter less than nine and a dielectric constant less than four, and drying the object by means of a mixed cleaning agent containing the polar cleaning agent having the solubility parameter not less than nine or the dielectric constant not less than four and a cleaning agent having a solubility parameter less than nine and a dielectric constant less than four.

The dirt meant by the present invention includes work oil, greece, wax, flux or the like required to be cleaned. The present invention is intended to clean an object which has been stained with work oil, greece, wax, flux or the like or an object having a portion which contacts the dirt. The kind of objects to be cleaned are not limited to a specific one, but metal, semi-metal, ceramic, plastic and the like are intended to be cleaned by the method of the present invention. As metal and semi-metal, iron, aluminum, silicon, copper, stainless steel and the like are exemplified. As ceramic, silicon nitride, silicon carbide, aluminum oxide, glass, porcelain are exemplified. As plastic, polyamide, polyimide, epoxy resin, polyolefin, polyester, acrylic resin are exemplified. Composite materials of the above materials are also intended to be cleaned by the present invention. More specifically, electronic parts such as printed circuit boards, parts to be mounted thereon, electric parts, semiconductor parts, liquid crystal parts, metal parts, surface treatment parts, parts of precision mechanical equipments, optical parts, glass parts, ceramic parts, plastic parts, and the like.

Cleaning described in the present specification means that the concentration of dirt which has attached to an object is minimized or removed therefrom. Rinsing described in the present specification means that the concentration of a cleaning agent which has attached to the object is minimized or removed therefrom. Drying means that the cleaning agent or a rinsing agent is vaporized from the object or removed therefrom. AS the drying method, natural drying, vacuum drying, hot air drying, vapor drying, and a agent replacement by means of a solvent having a high vapor pressure than the agent are exemplified.

The cleaning agent to be used in the first cleaning method will be described below.

A polar cleaning agent to be used in the first cleaning method means a cleaning agent comprising polar molecules. As factors relating to polarity include solubility parameter (hereinafter referred to as $\delta$), dielectric constant, dipole moment, molecular polarization, dissociation constant, and molecular refractive index. In the present invention, a polar cleaning agent having a $\delta$ not less than nine or a dielectric constant not less than four can be used. Preferably, the dipole moment is in the range of 1 - 5D which is a boundary region.

The solubility parameter involved in the present invention is defined by the following formula (1):

$$\delta = (\Delta E/V)^{1/2} \qquad (1)$$

where $\Delta E$ stands for molecular cohesive energy (cal/mol) and V for molecular volume (ml/mol.) Thus, the solubility parameter, namely, $\delta$ is equivalent to the square root of the cohesive energy density.

When the mixture of two components entails no change in volume, the heat of solution, namely, $\Delta Hm$ which is generated when the first and second components are mixed with each other and dissolved is expressed by the following formula (2) as proposed by J. H. Hildebrand:

$$\Delta Hm = Vm\,(\delta_1 - \delta_2)^2 \times \phi_1 \times \phi_2 \qquad (2)$$

where Vm stands for the total volume (ml) of the mixture, $\phi$ for volumetric proportion, and the subscripts 1 and 2 represent the first and second components, respectively. The formula (2) indicates that the heat of solution, $\Delta Hm$, of the first and the second component decreases and the compatibility thereof gains in excellence in proportion as the difference between $\delta_1$ and $\delta_2$ decreases. For example, in the cleaning agent and cleaning method in accordance with the present invention, the dirt can be sufficiently remove by the cleaning agent when the difference between the solubility parame-

ters, $\delta$, of the dirt and the cleaning agent is not more than 3. The solubility parameter, $\delta$, can be determined by any of such known methods as the method of latent heat of vaporization and the method of molecular attraction constant. The method adopted for the determination of the solubility parameter, $\delta$, has no particular restriction. In any event, it suffices that the magnitude of the solubility parameter, $\delta$, determined by any of such methods should satisfy the conditions of the present invention. Generally, the magnitude determined by the method of latent heat of vaporization is used where the relevant substance permits determination of the boiling point thereof or that determined by the method of molecular attraction constant is used where the substance either defies determination of the boiling point or does not permit easy determination of the boiling point and has a known chemical structural formula.

The method of latent heat of vaporization comprises finding $\Delta H$ from the following formula (3), finding $\Delta E$ from the following formula (4) using the found magnitude of $\Delta H$, and finding $\delta$ from the following formula (5) which is derived from the formula (1). This method is most direct and permits exact calculation of $\delta$.

$$\Delta H_{25} = 23.7Tb + 0.020Tb^{2} - 2950 \quad (3)$$

$$\Delta E = \Delta H - RT \quad (4)$$

$$\delta = (\Delta E/V)^{1/2} = \{(d/M)\Delta E\}^{1/2} \quad (5)$$

wherein Tb stands for boiling point (K), R for gas constant (1.986 cal/mol), T for absolute temperature (K), d for density (g/ml), and M for molecular weight (g/mol).

In the case of a liquid paraffin as a base oil having a main component of $C_{10}H_{22}$, for example, since M = 142.29, Tb = 200°C (= 473 K), and d = 0.896 (g/ml), the solubility parameter, $\delta$, of the liquid paraffin is found as follows:

$$\Delta H_{25} = 23.7 \times 473 + 0.020 \times 473^{2} - 2950 = 12192.5$$

$$\Delta E = 12192.5 - 1.986 \times 298 = 11600.7$$

$$\delta = \{(0.896/142.29) \times 11600.7\}^{1/2} = 8.55$$

The solubility parameter of a compound containing a hydrogen bond ($\delta_C$) is obtained by adding the following parameter $\delta$ obtained as shown above. Alcohols; $\delta_C = \delta + 1.4$, esters; $\delta_C = \delta + 0.6$, and ketones; $\delta_C = \delta + 0.5$. No correction is necessary where the boiling point of a given compound exceeds 100°C.

The method of molecular attraction constant determines the solubility parameter $\delta$ on the basis of the characteristic values of the component functional groups (atoms or atomic groups) of the molecular unit of a given compound, namely, the total of molecular attractions (G) and the molecular volume. It proves to be useful for the determination of the solubility parameter $\delta$ such as of resin which, unlike solvents, is not easily vaporized. The solubility parameter $\delta$ is determined by the following formula (6).

$$\delta = \Sigma G/V = d \times \Sigma G/M \quad (6)$$

where G stands for a value equivalent to the product of the molecular cohesive energy multiplied by the molecular volume (molecular volume cohesive energy.) The empirical values of G of various compounds have been published by Small et al.

In the case of the sulfur in the sulfide oil as an extreme pressure agent, for example, since M = 32.07 and d = 2.07 (g/ml) and the value of G is 225 [cal-ml$^{1/2}$/mol] as reported by Small et al., the solubility parameter $\delta$ is found as follows:

$$\delta = 2.07 \times 225/32.07 = 14.5$$

Then, the solubility parameter of a mixture $\delta_m$ is generally determined as the additive average of the mole fractions of the solubility parameters $\delta$ of the components of the mixture in accordance with the following formula (7):

$$\delta_m = \Sigma X_i \delta_i \quad (7)$$

where the subscript i stands for an i'th component.

In the case of sulfide oil containing 0.43 mol of liquid paraffin as a base oil and 1 mole of sulfur, for example, the solubility parameter $\delta_m$ of this sulfide oil is determined as follows:

$$\delta_m = \{1/(1+0.43)\} \times 14.5 + \{0.43/(1+0.43)\} \times 8.58 = 12.7$$

The preferable range of the polar cleaning agent of the present invention is 9 - 14 in its δ or 4 - 45 in its dielectric constant at a temperature of 25°C. Favorably, the polar cleaning agent to be used to remove an activator component of flux and extreme pressure additives such as processing oil and machining oil has a range of 9 - 14 in its δ or 4 - 45 in its dielectric constant. More favorably, the δ is in the range of 10 - 13 or the dielectric constant is in the range of 10 - 30. The polar cleaning agent having the δ not less than nine or the dielectric constant not less than four is capable of removing ionized substances contained in flux, processing oil, and machining oil and nonionic oily substances simultaneously. The component of a polar cleaning agent having a δ less than 14 or a dielectric constant less than 45 is compatible with that of a cleaning agent having a δ less than 9 and a dielectric constant less than 4. Thus, the two cleaning agents are capable of forming a mixed cleaning agent which can be used as a rinsing agent or a vapor cleaning agent. Thus, the polar cleaning agent has a sufficient effect of removing dirt in rinsing and vapor drying processes to be carried out by a cleaning apparatus of the present invention.

The polar cleaning agents having a δ in the range of 9 - 14 or a dielectric constant 4 - 45 include at least one of alcohols, glycols, phenols, ketones, fatty acids, acid anhydrides, esters, amines, amides, quaternary ammonium salts, nitriles, morpholines, sulfoxides, sultones, phosphoric acids, derivatives of these substances, and N-methyl-2-pyrrolidone.

More specifically, as alcohols, methanol, ethanol, propanol, normal hexanol, 3,5,5-trimethylhexanol, 2-ethylhexanol, normal octanol, normal butanol, cyclohexanol, benzylalcohol are exemplified. As glycols, propyleneglycolmonoethylether, propyleneglycolmonobutylether, ethyleneglycolmonobutylether, and derivatives thereof are exemplified. As phenols, o-cresol, m-cresol, p-cresol, and derivatives thereof are exemplified. As ketones, acetophenone, acetone, methyl ethyl ketone, methyl isobutyl ketone, di-isobutyl ketone, cyclohexanone, and derivatives thereof are exemplified. As fatty acids and acid anhydrides, acetic acid, acetic anhydride, and derivatives thereof are exemplified. As esters, methyl acetate, ethyl acetate, butyl acetate, ethyl lactate, methyl lactate, diethyl oxalate, and derivatives thereof are exemplified. As amines, ethyl amine, N,N-dimethylnitroamine, and derivatives thereof are exemplified. As amides, N,N-dimethylacetamide, N,N-dimethylformamide, N,N-diethylformamide, N-ethylacetamide, and derivatives thereof are exemplified. As quaternary ammonium salt, tetramethylammonium and derivatives thereof are exemplified. As nitriles, isobutylnitrile, propionitrile, acetonitrile, and derivatives thereof are exemplified. As morpholines, ethylmorpholine, N-acetylmorpholine, N-formylmorpholine, and derivatives thereof are exemplified. As sulfoxides, dimethylsulphoxide and derivatives thereof are exemplified. As sultones, propanesultone and derivatives thereof are exemplified. As phosphoric acids, triethyl phosphate, tributyl phosphate and derivatives thereof are exemplified. The above-describe substances can be used singly or in combination thereof. Preferably, polar cleaning agents such as acetic anhydride and amines which react with each other are used singly.

The cleaning agents which have solubility parameters less than nine and dielectric constants less than four to be used in the first cleaning method include at least one of low molecular weight siloxane compound, hydrocarbons, fluorocarbons, ethers, and acetals.

The low molecular weight siloxane compound include at least one substance selected from straight-chain polyorganosiloxane and its derivatives expressed by:

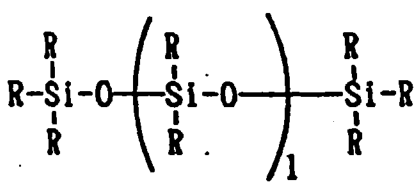

..... (i)

where groups expressed by R are substituted or unsubstituted monovalent organic groups identical to each other or different from each other; l is integers 0 - 5; and

cyclic polyorganosiloxane and its derivatives expressed by:

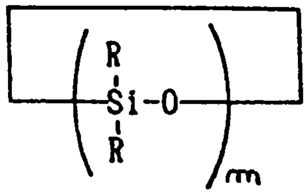 ..... (ii)

where groups expressed by R are substituted or unsubstituted monovalent organic groups identical to each other or different from each other; m is integers 3 - 7.

The groups (R) in the above formulas (i) and (ii) are monovalent organic groups substituted or unsubstituted and include monovalent unsubstituted hydrocarbon groups such as alkyl group including methyl group, ethyl group, propyl group, butyl group, and the like and phenyl group; monovalent replaced hydrocarbon groups such as trifluoromethyl group, 3,3,3-trifluoropropyl group. The R-groups of the end group shown in formula (i) include amino group, amide group, acrylic ester group, mercaptan group, and the like. Of the above R-groups shown in formulas (i) and (ii), methyl group is most favorable in view of stability of a system or a cleaning apparatus and keeping of volatility. As low molecular weight siloxane compound, hexamethyldisiloxane, octamethyltrisiloxane, octamethylcyclotetrasiloxane, and decamethylcyclopentasiloxane can be exemplified.

As hydrocarbons, aliphatic hydrocarbon compounds such as normal paraffin, isoparaffin, olefin, and the like; and alicyclic hydrocarbon compounds such as cycloparaffin, cycloolefin and the like.

Fluorocarbons include perfluorocarbons, hydrofluorocarbons, hydrochlorofluorocarbons, fluoroiodidecarbons, hydrofluoroethers, fluoroalcohols, and the like. Compounds flame-retardant and incombustible are preferably used. Hydrochlorofluorocarbons having a extreme low ozone depletion coefficient are preferable.

The following perfluorocarbons can be used:

1) Perfluoroalkanes expressed by a general formula:
$C_nF_{2n+2}$;
where n indicates integers 4 - 12.
2) Perfluoropolyethers as shown below:

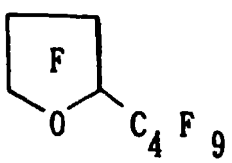 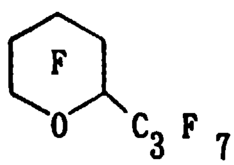 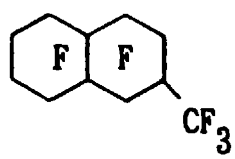 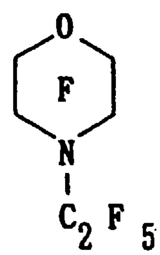

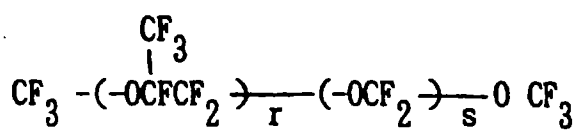

where r and s indicate given integers;
3) Perfluoroamines which form trifluoro radicals such as $(C_4F_9)_3N$, $(C_5F_{11})_3N$, $(C_2F_5)_3N$, $(C_2F_5)(C_3F_8)NF$, $(CF_3)_2NC_2F_5$, $(CF_3)_2NC_2F_4Br$, $(CF_3)_2NCF{=}CF_2$, $(CF_3)_2NCF_2CF_2H$, $(CF_3)_2NCF_2CF_3$, $C_5F_{10}NC_2F_5Br$, $OC_4F_8NCF_2$; and perfluoromorpholines;
4) Perfluoroether compounds expressed by a general formula:
$(C_XF_{2X+1})_2O$
where x indicates integers 1 - 7.
Of $(C_XF_{2X+1})_2O$, $(CF_3CF_2)_2O$ is preferable.

As hydrofluorocarbons, compounds expressed by the following general formulas can be used:

$$C_pH_qF_{2p+2-q},\ C_pH_qF_{2p-q},\ C_pH_qF_{2p-2-q}$$

where p is integers 1 - 10, q is integers 1 - 20.

That is, $C_5H_1F_{11}$, $C_5H_2F_{10}$, $C_5H_3F_9$, $C_4H_3F_7$, $C_6H_2F_{12}$ can be exemplified.

As fluoroiodidecarbons, $CF_3CF_2CF_2I$, $CH_2FI$, $CF_3CF_2CF_2CF_2I$, $CF_2I_2$, and $CF_3(CF_2)_4I$ can be exemplified.

As hydrofluoroethers, compounds expressed by the following general formula can be used:

$$(C_tH_{2t+1-u}F_u\text{-})\text{-O-}(\text{-}C_vH_{2v+1-w}F_w)$$

where t, u, and v are given integers and preferably, u = 2t+1 , w=0.

That is, $C_3F_7OCH_3$, $C_4F_9OCH_3$, $C_5F_{11}OCH_3$, $C_3F_7OC_2H_5$, $C_4F_9OC_2H_5$, and $C_5F_{11}OC_2H_5$ can be exemplified.

Polar cleaning agents have high solubilities in hydrofluoroethers. Thus, hydrofluoroethers can be used as favorable solvents to form mixed cleaning agents.

Ethers composing cleaning agents which have solubility parameters less than nine and dielectric constants less than four include di-n-propylether and its derivatives. Acetals composing cleaning agents which have solubility parameters less than nine and dielectric constants less than four include methylal and its derivatives. Low molecular weight siloxane compound, hydrocarbons, and fluorocarbons are preferably used as cleaning agents having solubility parameters less than nine and dielectric constants less than four.

Low molecular weight siloxane compound, hydrocarbons, fluorocarbons, ethers, and acetals can be used singly or in combination thereof as the cleaning agents having solubility parameters less than nine and dielectric constants less than four. Table 2 shows examples of polar cleaning agents having solubility parameters not less than nine or dielectric constants not less than four. Table 3 shows examples of cleaning agents which have solubility parameters less than nine and dielectric constants less than four and δ values, dielectric constants, and dipole moments thereof. The dielectric constants of substances shown in tables 2 and 3 are at 25°C except the substances marked by *1 - *4 in the column of dielectric constants in tables 2 and 3.

Table 2

| Material name Polar cleaning agent | δ Value | Dielectric constant | Dipole moment |
|---|---|---|---|
| 3,5,5-Trimethylhexol | 10 ~ 11 | | |
| 3- Methoxy -3-methyl-1-butanol | 9.3 | | |
| n-Hexanol | 10.77 | 13.3 | |
| 2-Metyhlcyclohexanol | | 13.3*1 | 1.95 |
| Isopentylalcohol | 10.0 | 14.7 | 1.82 |
| Ethanol | 12.78 | 23.8 | 1.68 |
| Ethyleneglycolmonomethylether | 11.4 | 16.93 | 2.04 |
| o-Cresol | 10.2 | 11.5 | 1.41 |
| Acetophenone | 10.6 | 17.39 | 2.96 |
| Acetic anhydride | 10.3 | 20.7*2 | 2.82 |
| Ethlylacetate | 9.1 | 6.02*1 | 1.88 |
| Isopropylalcohol | 11.44 | 18.3 | 1.68 |
| Ethylamine | 10.0 | 8.7*4 | 1.09 |
| N,N-Dimethylnitroamine | 13.1 | | |
| N,N-Dimethylacetamide | 10.8 | 37.78 | 3.72 |
| N-Ethylacetamide | 12.3 | | |
| N,N-Diethylformamide | 12.1 | | |
| Morophotline | 10.8 | 7.42 | 1.50 |
| N-Acetylmorpholine | 11.6 | | |
| N-Formylmorpholine | 13.0 | | |
| Isobutyronitrile | 9.8 | 20.4*3 | 3.61 |
| Propionitrile | 10.8 | | |
| Acetonitrile | 11.9 | | |
| Dimethylsulfoxide | 12.0 | 48.9 | 4.3 |
| N-Methyl-2-pyrrolidone | 11.3 | | |
| Ethyllactate | 10.0 | 13.1*1 | |
| Butyllactate | 9.4 | | |
| Propanesultone | | | 4.70 |
| Triethylphosphate | | | 3.07 |
| Unit of Dipole moment : D | | | |

Note :
*1 : at 20 °C
*2 : at 19 °C
*3 : at 24 °C
*4 : at 0°C

Table 3

| Material name Cleaning agent | δ Value | Dielectric constant | Dipole moment |
|---|---|---|---|
| Octamethylcyclotetrasiloxane | 6.0 | 2.39 | 1.09 |
| IPsolvent | 7.3 | 2 | |
| Shellsol $D_{40}$ | 7.6 | 2.1 | 0 |
| Octamethyltrisiloxane | 6.0 | 2.30 | 0.99 |
| Naphtesol | 8.0 | 2 | |
| Hexamethyldisiloxane | 6.2 | 2.17 | 0.79 |
| Dodecane | 6.6 | 2.016*1 | |
| Perfluorocarbon | 5.5~6.0 | 1.7~1.9 | |
| Hydrochlorofluorocarbon | 6~7 | | |
| Di-n-propylether | 7.8 | 3.3 | |
| Methylal | | 2.7 | 0~0.45 |
| Hydrofluorocarbon | 5~7 | | |
| Unit of Dipole moment : D | | | |

Note :
*1 : at 20 °C,

In the first cleaning method, objects are cleaned, using the above-described polar cleaning agents. Thus, dirt such as ionized, polar substances, and unionized oily substances can be removed preferably from objects.

In the first cleaning method, after the cleaning step is carried out, the step of rinsing an object and/or drying the object are carried out, using a mixed cleaning agent containing the above-described polar cleaning agent and a cleaning agent, namely, a nonpolar cleaning agent or a cleaning agent having a low degree of polarity (hereinafter referred to as nonpolar cleaning agent) having a solubility parameter less than nine and a dielectric constant less than four. The rinsing step and the drying step may be performed subsequently to the cleaning step, using the polar cleaning agent or it is possible to omit the execution of the rinsing step or the drying step depending on the quantity and kind of dirt which has attached to the object.

The mixed cleaning agent to be used in the rinsing step and/or the drying step is incombustible or flame-retardant. Incombustibility and flame retardancy are defined as described below according to evaluated results of flammability.

That is, the flammability of each mixed cleaning agent is evaluated by measuring its flash point in accordance with JIS-K-2265 by means of a tag-closed type flash point measuring device and a Cleveland open type flash point measuring device. If the flash point of a mixed cleaning agent cannot be measured by the tag-closed type flash point measuring device and the Cleveland open type flash point measuring device, the mixed cleaning agent is defined as an incombustible one, whereas if the flash point of a mixed cleaning agent cannot be measured by the tag-closed type flash point measuring device or the Cleveland open type flash point measuring device, the mixed cleaning agent is defined as a flame-retardant one.

A mixed cleaning agent containing the above-described polar cleaning agent and the nonpolar cleaning agent is used as a rinsing agent and a vapor drying agent so that the rinsing agent and the vapor drying agent perform a liquid replacement and a drying operation and dissolve therein dirt components contained in the polar cleaning agent delivered from a cleaning tank. Thus, the mixed cleaning agent is capable of accomplishing superior precision cleaning satisfying both drying and dirt-removing performance.

The component of the polar cleaning agent to be used in the rinsing process and the drying process is not necessarily identical to that of the polar cleaning agent to be used in the cleaning process. Preferably, the polar cleaning agent to be used in the rinsing and drying processes has a higher vapor pressure than that to be used in the cleaning process, and the boiling point of the polar cleaning agent to be used in the rinsing and drying processes is lower than that of the nonpolar cleaning agent.

It is preferable that the polar cleaning agent is compatible with the nonpolar cleaning agent. For example, fluorocarbons to be used as the nonpolar cleaning agent are not compatible with the polar cleaning agent, whereas low molecular weight polyorganosiloxanes to be also used as the nonpolar cleaning agent are compatible with most of the polar

cleaning agents. Fluorocarbons and low molecular weight polyorganosiloxanes are compatible with each other at an arbitrary mixing ratio. Therefore, it is possible to form a mixed cleaning agent in which components are uniformly mixed with each other and not separated from each other by adding an appropriate amount of the polar cleaning agent to the nonpolar cleaning agent consisting of two components, namely, fluorocarbons and low molecular weight polyorganosiloxanes.

Preferably, the mixed cleaning agent consists of an azeotropic composition or a pseudo-azeotropic composition. The azeotropic property is exhibited by making an appropriate selection of the kind of the polar cleaning agent and of the mixing ratio. The azeotropic composition is a mixture in which the composition of a liquid phase and that of a gas phase are coincident with each other and which can be distilled without change in its composition. A phenomenon in which the composition of a liquid phase and that of a gas phase are approximate to each other is called pseudo-azeotropic composition although an azeotropic composition is not formed. The pseudo-azeotropic composition means a phenomenon that a boiling curve and a condensation curve are approximate to each other; a phenomenon that volatilities of respective component are approximate to each other; or a phenomenon that boiling points of respective component are proximate to each other in a boiling point graph. A mixture which forms such a pseudo-azeotropic composition is called a pseudo-azeotropic composition.

In the mixed cleaning agent to be used in the first cleaning method, it is not necessary to mix a large weight percentage of the polar cleaning agent with a nonpolar cleaning agent so that the polar cleaning agent does not damage the drying property of the mixed cleaning agent, although the mixing ratio of the polar cleaning agent to the whole amount of the mixed cleaning agent is different depending on whether it is used in the rinsing process or in the drying process. Favorably, the mixing ratio of the polar cleaning agent to the whole amount of mixed cleaning agent is in the range of 0.1 - 30 in weight percentage. In this range, the mixed cleaning agent is capable of smoothly removing dirty components in the polar cleaning agent delivered from the cleaning tank. More favorably, the mixing ratio of the polar cleaning agent to the whole amount of mixed cleaning agent is in the range of 1 - 20 in weight percentage.

Preferably, the mixed cleaning agent to be used in the rinsing and the drying process is incombustible or flame-retardant. In particular, the mixed cleaning agent to be used in the drying process is incombustible or flame-retardant. The mixed cleaning agent containing fluorocarbons as its main component is incombustible and flame-retardant. When the mixed cleaning agent contains flammable low molecular weight polyorganosiloxanes, it can be allowed to be incombustible and flame-retardant by mixing fluorocarbons with low molecular weight polyorganosiloxanes.

A specific drying method is not used in the drying process of the first cleaning method, but selected from vapor drying, hot air drying, vacuum drying or natural drying method. These drying methods can be singly used or in combination thereof, depending on the shape or the like of an object to be cleaned. In particular, when precision parts are cleaned, preferably, vapor drying providing a comparatively clear finish is preferably used. It is preferable to use the above-described mixed cleaning agent in the vapor drying. The nonpolar cleaning agent containing fluorocarbons as its main component can be preferably used as a vapor drying agent for precision parts. The mixture of fluorocarbons and low molecular weight polyorganosiloxanes is compatible with the polar cleaning agent, thus providing a fine drying property.

When fluorocarbons and low molecular weight polyorganosiloxanes are used in combination thereof to form a cleaning agent, preferably, 10 - 10,000 parts by weight of fluorocarbons is mixed with 100 parts by weight of low molecular weight polyorganosiloxanes. A cleaning agent consisting of not less than 10 parts by weight of fluorocarbons and 100 parts by weight of low molecular weight polyorganosiloxanes is allowed to be incombustible or flame-retardant. The polar cleaning agent can be prevented from being separated from the nonpolar cleaning agent consisting of less than 10,000 or more favorably 20 - 5,000 of fluorocarbons with respect to 100 parts by weight of low molecular weight polyorganosiloxanes.

In the first cleaning method, after an object is cleaned with the polar cleaning agent, the rinsing process and the drying process are carried out, using the mixed cleaning agent containing the nonpolar cleaning agent or the cleaning agent having a low degree of polarity as the main component. Thus, the first cleaning method has a favorable cleaning (dirt removal property or the like) property and drying property for objects including precision parts such as electronic parts.

In carrying out the first cleaning method, the number of cleaning tanks and that of rinsing tanks of the cleaning apparatus can be selected depending on the quantity and kind of dirt which has attached to an object. Rinsing means and drying means can be appropriately provided in various modes depending on necessity and purpose.

It is preferable to recycle the cleaning agent to be used in the cleaning means, the rinsing means, and the drying means of the cleaning apparatus for carrying out the first cleaning method. In particular, when the cleaning apparatus has a plurality of cleaning tanks and rinsing tanks, liquid which has become dirty is reclaimed by a distilling device and returned to the last cleaning tank and/or the last rinsing tank when a plurality of the cleaning tank and/or a plurality of the rinsing tanks are provided, because the cleaning tanks and the rinsing tanks are connected with each other by cascade (overflow) system. In this manner, the longevity of the cleaning agent can be prolonged, and the running cost can be reduced greatly. When the cleaning agent consists of a plurality of components mixed with each other, it is preferable that the boiling points thereof are proximate to each other. More specifically, the boiling points of the components of the cleaning agent to be used in the cleaning process is lower than 373K to allow the mixing ratio between the components

thereof to be stable.

The second cleaning method of the present invention comprises the step of cleaning an object with a polar cleaning agent having a solubility parameter not less than nine or a dielectric constant not less than four; and the step of rinsing and/or drying the object with a cleaning agent containing hydrofluoroether expressed by $C_tF_uOC_vH_{2v+1}$ (t, u, and v are given integers) as its effective component.

As in the case of the first cleaning method, preferably, the mixed cleaning agent is used in the rinsing process and/or the drying process of the second cleaning method. But instead of the mixed cleaning agent, it is possible to use a cleaning agent containing hydrofluoroether as its effective component. Hydrofluoroethers can be combined with the polar cleaning agents to be used in the cleaning process which is carried out before the rinsing process and/or the drying process are carried out, thus providing a preferable rinsing and/or drying property. Hydrofluoroethers which can be favorably used in the second cleaning method include $C_3F_7OCH_3$, $C_4F_9OCH_3$, $C_5F_{11}OCH_3$, $C_3F_7OC_2H_5$, $C_4F_9OC_2H_5$, $C_5F_{11}OC_2H_5$. $C_5F_{11}OCH_3$ and $C_5F_{11}OC_2H_5$ are more favorable than the other hydrofluoroethers. In this case, hydrofluoroethers are used singly or in the form of a mixture of hydrofluoroether and hydrocarbons or low molecular weight polyorganosiloxanes. Favorably, 10 - 100 weight percentages of hydrofluoroethers and more favorably, 50 - 100 weight percentages thereof ares mixed with hydrocarbons or low molecular weight polyorganosiloxanes. As the polar cleaning agent to be used in the second cleaning method, those to be used in the first cleaning method can be used.

The third cleaning method comprises at least one of the steps of cleaning, rinsing, and drying an object, using a cleaning agent containing a low molecular weight siloxane compound, and at least one of fluorocarbons and a polar cleaning agent having a solubility parameter not less than nine or a dielectric constant not less than four.

The fourth cleaning method comprises the steps of cleaning, rinsing, and drying an object, using a cleaning agent containing a low molecular weight siloxane compound, fluorocarbons, and a polar cleaning agent having a solubility parameter not less than nine or a dielectric constant not less than four.

The definition of dirt to be removed from objects; objects; cleaning, rinsing, and drying; the solubility parameter; the dielectric constant; the preferable polar cleaning agents; the kind of low molecular weight siloxane compounds, and the kind of fluorocarbons is the same as that described in the first cleaning method.

The respective components of the cleaning agent, namely, fluorocarbons, the low molecular weight siloxane compound, and the polar cleaning agents having solubility parameters not less than nine or dielectric constants not less than four have the following roles.

Fluorocarbons are preferable materials of the cleaning agent for use in a vapor cleaning agent in performing the drying process, because fluorocarbons are incombustible liquids and have low evaporation latent heat. But dirty components, for example, processing oil or flux do not dissolve in fluorocarbons. The solubility of dirty components in the polar cleaning agent having a solubility parameter not less than nine or a dielectric constant not less than four is high but the polar cleaning agent has a disadvantage that it leaves stains on an object or remain thereon in the drying process. Low molecular weight siloxane compounds are compatible with both fluorocarbons and the polar cleaning agent and have a superior drying property. Accordingly, a mixture of fluorocarbons, the polar cleaning agent, and a low molecular weight siloxane compound can be used as a cleaning agent having a fine dirt-removing and drying properties because they do not separate from each other and maintain their respective advantages. Consequently, the cleaning agent of the present invention can be used in the cleaning, rinsing, and drying processes.

In the cleaning agent to be used in the third and fourth cleaning methods, preferably, the polar cleaning agent having a solubility parameter not less than nine or a dielectric constant not less than four is contained in the mixture in the range of 0.1 - 30 weight percentages with respect to the whole amount thereof, although the mixing weight percentage of the polar cleaning agent is varied according to whether it is used in the cleaning process, the rinsing process or the drying process. When the polar cleaning agent is used in the rinsing process or the drying process, it is not necessary to mix it in a high weight percentage with a nonpolar substance but is used in a range in which it does not deteriorate the drying property of the mixed cleaning agent. Thus, in the range of 0.1 - 30 weight percentages, dirty components delivered from the cleaning tank to the rinsing tank or the drying tank can be smoothly removed. More favorably, the mixing weight percentage of the polar cleaning agent with respect to the whole amount of the mixed cleaning agent is in the range of 1 - 20.

Preferably, 10 - 10,000 parts by weight of fluorocarbons are mixed with 100 parts by weight of the low molecular weight siloxane compound, although the weight percentage fluorocarbons is varied according to whether it is used in the cleaning process, the rinsing process or the drying process of the third and fourth cleaning methods. More favorably, not more than 10,000 parts by weight of fluorocarbons are mixed with 100 parts by weight of the low molecular weight siloxane compound, and most favorably, not more than 5,000 parts by weight of the former are mixed with 100 parts by weight of the latter. In this range, fluorocarbons can be prevented from separating from the polar cleaning agent. The mixture of fluorocarbons and the low molecular weight siloxane compound has a favorable drying property, when not less than 10 parts by weight of the former is mixed with 100 parts by weight of the latter. Flame-retardant or incombustible fluorocarbons are preferable because they allow a mixed cleaning agent consisting of fluorocarbons and the low molecular weight siloxane compound to be flame-retardant or incombustible in the rinsing and drying processes, although the low molecular weight siloxane compound is flammable. In order for the mixed cleaning agent to be incombustible, preferably, not less than 400 parts by weight of fluorocarbons are mixed with 100 parts by weight of the low molecular weight siloxane compound.

Preferably, the mixed cleaning agent of the present invention consists of an azeotropic composition or a pseudo-azeotropic composition. The azeotropic property is exhibited by appropriately selecting the kind and the mixing ratio of the polar cleaning agent.

In the third cleaning method, at least one of the cleaning process, the rinsing process, and the drying process is carried out by using the above-described cleaning agent. The rinsing process may be carried out after the execution of the cleaning process terminates, and the drying process may be carried out after the execution of the rinsing process terminates. It is possible to omit the execution of the rinsing process and the drying process. As in the case of the fourth cleaning method, an object can be cleaned more favorably by performing all of the cleaning process, the rinsing process, and the drying process. In this case, the mixing ratios between the components of the cleaning agent to be used in the cleaning process, the rinsing process, and the drying process may be differentiated from each other.

A specific drying method is not used in the drying process of the third and fourth cleaning methods, but selected from vapor drying, hot air drying, vacuum drying or natural drying. These drying methods can be singly used or in combination thereof, depending on the shape or the like of an object to be cleaned. In particular, when precision parts are cleaned, preferably, vapor drying providing a comparatively clear finish is preferably used. The cleaning agent of the present invention can be preferably used in the vapor drying as well.

In the third and fourth cleaning method, at least one of the cleaning process, the rinsing process, and the drying process is carried out, using the cleaning agent satisfying drying and dirt-removing properties. Thus, the third and fourth cleaning methods are capable of accomplishing superior precision cleaning satisfying both drying and dirt-removing performance.

The same cleaning apparatus as that of first cleaning method may be used to carry out the third and fourth cleaning methods.

In the fifth cleaning method, a mixed cleaning agent containing a low molecular weight siloxane compound and fluorocarbons as its main component and being incombustible or flame-retardant is charged into a closed container so that the mixed cleaning agent is sprayed over an object.

The low molecular weight siloxane compound dissolves in fluorocarbons at a high solubility, and some low molecular weight siloxane compounds are soluble in each other. The present inventors have found that although the low molecular weight siloxane compound is flammable, a cleaning agent consisting of a mixture of the low molecular weight siloxane compound and fluorocarbons chemically inactive, namely, incombustible and flame-retardant can be allowed to be incombustible and flame-retardant.

The mixture of the low molecular weight siloxane compound and fluorocarbons is not necessarily azeotropic or pseudo-azeotropic. For example, when the mixture is used in an open state, i.e., when it is exposed to the atmospheric air, the consumption of one component is greater than that of the other one. As a result, there occurs a change in the mixing ratio between the two components, which may deteriorate the incombustibility of the mixture or the flame-retardancy thereof and degrading the cleaning property thereof. The present inventors have found that the mixing ratio between the low molecular weight siloxane compound and fluorocarbons can be prevented from being changed when the mixture is used as a spray agent which is stored in a closed container. The fifth cleaning method is devised based on the discovery.

The examples of the low molecular weight siloxane compound and fluorocarbons to be used in the fifth cleaning method are the same as those to be used in the first cleaning method. Some of fluorocarbons do not pollute the atmospheric air and hence are not harmful for the health. In addition, they do not burn and are effective for cutting off oxygen in the atmospheric air. Thus, the cleaning agent consisting of the low molecular weight siloxane compound and fluorocarbons which dissolve the low molecular weight siloxane compound therein and are incombustible and flame-retardant is used in the fifth cleaning method. The mixed cleaning agent is incombustible and flame-retardant.

Although the mixing ratio between fluorocarbons and the low molecular weight siloxane compound varies depending on whether the mixture of the two components is used in the cleaning, rinsing or drying process, it is preferable to mix 10 - 10,000 parts by weight of the former with 100 parts by weight of the latter. The cleaning agent consisting of not less than 10 parts by weight of fluorocarbons and 100 parts by weight of the low molecular weight siloxane compound is incombustible or flame-retardant. More favorably, 20 - 5,000 parts by weight of fluorocarbons is mixed with 100 parts by weight of the low molecular weight siloxane compound.

The mixed cleaning agent to be used in the fifth cleaning method contains the mixture of the low molecular weight siloxane compound and fluorocarbons as its main component. It is possible to add solvents such as a polar solvent, a hydrocarbon solvent, an ether solvent, an acetal solvent to the mixture of the low molecular weight siloxane compound and fluorocarbons. In addition, various kinds of additives such as a surface-active agent, a hydrophilic solvent or the like may be added to the mixture of the low molecular weight siloxane compound and fluorocarbons.

In the fifth cleaning method, the mixed cleaning agent is stored in a closed container such as a spray can so that the mixed cleaning agent is sprayed over an object from the closed container.

As described above, the mixing ratio between the low molecular weight siloxane compound and fluorocarbons can

be prevented from being changed by preserving it in the closed container such as the spray can. Thus, the mixed cleaning agent is allowed to keep its incombustibility or flame retardancy and cleaning property for a long time.

In the sixth cleaning method, a dewatering drying operation is performed, using a liquid not forming an azeotropic composition when it is mixed with water and having a heat of vaporization not more than 100 cal/g.

The present inventors have found that the heat of vaporization of trifluoroethanol compatible with water is as small as 84cal/g; a mixture of trifluoroethanol and water does not form an azeotropic composition; trifluoroethanol has very favorable dewatering drying properties; and liquids having a property similar to that of trifluoroethanol also have very favorable dewatering drying properties. The sixth cleaning method has been devised based on the above-described discovery.

The dewatering drying liquid to be used in the sixth cleaning method is compatible with water, and the mixture of the liquid and water does not from an azeotropic composition. Because the liquid has such a property, after water is replaced therewith, it can be easily separated from water and reclaimed therefrom by distillation. Accordingly, the liquid is capable of preventing water from forming stains on an object and has a long life, thus reducing the running cost.

Because the heat of vaporization of the liquid is not more than 100 cal/g, it does not absorb moisture from the atmospheric air when it becomes volatile after water is replaced therewith. Therefore, it does not generate stains on the object, thus providing a very favorable dewatering drying property.

Trifluoroethanol is a representative example of the liquid having the above-described property. Trifluoroethanol ($CF_3CH_2OH$, boiling point: 347K, flash point: 303K) is completely compatible with water; a mixture of trifluoroethanol and water does not form an azeotropic composition; and trifluoroethanol is as small as 84cal/g in its heat of vaporization, as described above. In addition, trifluoroethanol is small in its surface tension and uniformly wets the surface of an object. Thus, trifluoroethanol provides a high drying speed and a fine drying quality. The use of a dewatering drying liquid consisting of trifluoroethanol eliminates a troublesome liquid management. Trifluoroethanol can be very effectively used to dewater and dry a lens and glass which are difficult to clean.

The dewatering drying liquid consisting of trifluoroethanol can be preferably used in the sixth cleaning method. In addition, it is effective to mix fluorocarbons with trifluoroethanol in a range in which the former is dissolvable in the latter to allow the latter to be incombustible or flame-retardant. As fluorocarbons which dissolve in trifluoroethanol, perfluorocarbons, hydrofluorocarbons, and hydrofluoroethers to be used in the first cleaning method can be exemplified:

$C_5H_2F_{10}$ 、 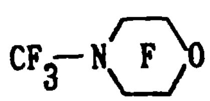 、 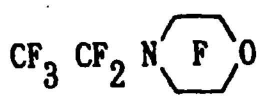

"Dewatering drying" in the sixth cleaning method means that the dewatering drying liquid is air-dried after water present on the surface of an object is replaced with a dewatering drying liquid by immersing the object therein, spraying it over the object or subjecting the object to the vapor thereof. It is possible to dry the dewatering drying liquid by hot air drying, vacuum drying or vapor drying in addition to natural air-drying. As vapor drying liquids, trifluoroethanol, a mixture of trifluoroethanol and perfluorocarbons, a mixture of trifluoroethanol and hydrofluorocarbons, and a mixture of trifluoroethanol and hydrofluoroethers can be used in the sixth cleaning method. If the dewatering drying liquid consists of trifluoroethanol, the mixture of trifluoroethanol and perfluorocarbons, the mixture of trifluoroethanol and hydrofluorocarbons or the mixture of trifluoroethanol and hydrofluoroethers, it is possible to use perfluorocarbons, hydrofluorocarbons or hydrofluoroethers dissolvable in trifluoroethanol as the vapor drying liquids.

Low molecular weight siloxane compounds which can be preferably used as vapor drying liquid include polyorganosiloxane expressed by the following general formula:

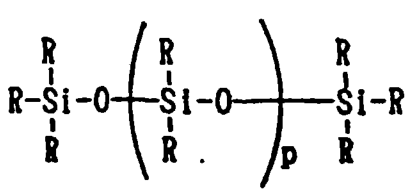

where P = 1, 2
or by the following general formula:

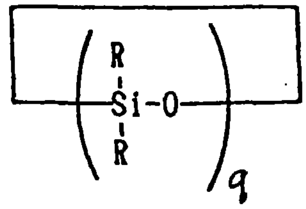

where Q is integers 4-8 and R is substituted or unsubstituted monovalent organic groups identical to each other or different from each other. More specifically, the low molecular weight siloxane compounds which can be preferably used as vapor drying liquid include hexamethyldisiloxane(MM), octamethyltrisiloxane (MDM), decamethyltetrasiloxane (MD2M), dodecamethylpentasiloxane (MD3M), octamethylcyclotetrasiloxane (D4), decamethylcyclopentasiloxane (D5), dodecamethylcyclohexasiloxane (D6) can be exemplified.

According to the dewatering drying method of the sixth cleaning method, a dewatering drying liquid containing trifluoroethanol or a mixture of trifluoroethanol and substances described above can be effectively used not only for a water-replacing operation (immersion, vibration, agitation, ultrasonic waver, spray), but also for a drying operation (hot air drying, spin drying, vapor drying, take-out drying, vacuum drying).

The cleaning agent of the present invention includes at least two substances selected from a low molecular weight siloxane compound, fluorocarbons, and a polar cleaning agent having solubility parameter not less than nine or dielectric constant not less than four. As the low molecular weight siloxane compound, fluorocarbons, and the polar cleaning agent, those to be used in the first through fifth cleaning methods may be used.

Of the cleaning agents of the present invention, description will be made below on those containing, as their effective component, an azeotropic composition or a pseudo-azeotropic composition both having preferable cleaning property and drying characteristic.

A cleaning agent containing a first azeotropic composition or a first pseudo-azeotropic composition as its effective component consists of hexamethyldisiloxane, tert-butanol, and perfluorocarbon expressed by perfluorohexane ($C_6F_{14}$).

A cleaning agent containing a second azeotropic composition or a second pseudo-azeotropic composition as its effective component consists of hexamethyldisiloxane, isopropyl acetate, and perfluorocarbon expressed by perfluorohexane ($C_6F_{14}$).

Preferably, the weight percentage of each component in each of the first azeotropic composition and the first pseudo-azeotropic composition is as follows: Hexamethyldisiloxane: 2 - 20; tert-butanol: 2 - 20; and perfluorocarbon expressed by ($C_6F_{14}$): 60 - 96. In this mixing ratio, an azeotropic composition or a pseudo-azeotropic composition having an azeotropic temperature of 321 - 326K (760mmHg) is obtained. The mixing ratio between the components of the azeotropic composition varies depending on a condition. The pseudo-azeotropic composition contains one or more kinds of components than the azeotropic composition in a range that the former has a characteristic similar to that of the latter without substantially deteriorating that of the latter.

The azeotropic property is exhibited when the boiling point of a mixture composing the azeotropic composition is lower or higher than that of each component. Accordingly, in most cases, only the mixing of components do not result in the formation of the azeotropic composition. When the boiling point of the mixture is lower than that of each component, a liquid consisting of components mixed with each other at a given ratio is distilled and fractions are repeatedly distilled or fractionated in several stage. The fractions of the azeotropic composition (mixture) obtained in this manner are not substantially changed when distillations are repeatedly carried out at a constant pressure. The pseudo-azeotropic composition can be obtained in a similar manner.

In the first azeotropic composition and pseudo-azeotropic composition, tert-butanol has a strong polarity and a high solubility in oil and fat and the like but has a great surface tension of 20.7dyn/cm (293K). Thus, it does not have a preferable permeability into objects to be cleaned . Further, solvent attack (phenomenon that plastic is cracked when it is subjected to solvent) may occur due to the presence of tert-butanol, depending on the kind or use condition of plastic to be cleaned.

Hexamethyldisiloxane has a small surface tension of 15.9 dyn/cm (293K) and hence a preferable permeability into objects to be cleaned but its Kauri butanol value (KB value) is as small as 15 and it has a weak cleaning power. There is, however, no possibility that hexamethyldisiloxane deteriorates objects to be cleaned. Further, hexamethyldisiloxane is compatible with tert-butanol and perfluorocarbon expressed by $C_6F_{14}$ at an arbitrary rate. Tert-butanol and perfluorocarbon $C_6F_{14}$ are hardly soluble in each other but the addition of hexamethyldisiloxane to a mixture thereof allows the three components to be compatible with each other to form a uniform composition. That is, hexamethyldisiloxane functions as an agent for allowing the other two components to be soluble in each other. The effect of the above function of hexamethyldisiloxane varies greatly depending on the kind of a polar solvent. Owing to the addition of hexamethyldisiloxane to tert-butanol of the present invention, tert-butanol is allowed to have a much higher solubility in perfluorocarbon

expressed by $C_6F_{14}$ than lower alcohols such as methanol or ethanol.

Because perfluorocarbon expressed by $C_6F_{14}$ does not have cleaning power, it is not suitable as a cleaning agent. But perfluorocarbon is superior in drying function because its heat of vaporization is about 21cal/g which is much smaller that of tert-butanol (about 131cal/g) and that of hexamethyldisiloxane (about 50cal/g). In addition, because perfluorocarbon is an incombustible liquid, it allows the flash point of a mixture of perfluorocarbon, tert-butanol which is a flammable liquid, and hexamethyldisiloxane which is also a flammable liquid to be higher than that of tert-butanol and hexamethyldisiloxane or that of a mixture of tert-butanol and hexamethyldisiloxane, thus allowing the mixture of the three substances to be flame-retardant or incombustible.

Each of the first azeotropic composition and the first pseudo-azeotropic composition consist of hexamethyldisiloxane, tert-butanol, and perfluorocarbon expressed by $C_6F_{14}$. They have the characteristic of each of the three components. That is, each of the first azeotropic composition and the first pseudo-azeotropic composition has a high solubility in fat and oil owing to tert-butanol; a high permeability into object to be cleaned owing to hexamethyldisiloxane; and a fine drying function owing to perfluorocarbon. Thus, a mixture consisting of each of the first azeotropic composition and the first pseudo-azeotropic composition is a preferable cleaning agent which can be used as one cleaning agent from cleaning through drying processes. As a cleaning agent which can be used from the cleaning through drying processes, it is important that it has degreasing property, drying property, and does not vary in its composition during use, and can be recovered by means of distillation or the like. The cleaning agent consisting of the first azeotropic composition or the first pseudo-azeotropic composition has a property of becoming azeotropic at a temperature in the range of 321K - 326K at 760mmHg. Therefore, the mixing ratio among the components thereof does not vary substantially during use and can be recovered by means of distillation or the like. Accordingly, the cleaning agent can be used as one cleaning agent from cleaning and drying processes.

Preferably, the weight percentage of each component in each of the second azeotropic composition and the second pseudo-azeotropic composition is as follows: Hexamethyldisiloxane: 2 - 20; isopropyl acetate: 2 - 20; and perfluorocarbon expressed by ($C_6F_{14}$); 60 - 96. In this mixing ratio, an azeotropic composition and a pseudo-azeotropic composition having an azeotropic temperature of 323 - 328K (760mmHg) is obtained. The mixing ratio among the components of the azeotropic composition varies depending on a condition. The second azeotropic and pseudo-azeotropic compositions can be obtained in a manner similar to that for obtaining the first azeotropic and pseudo-azeotropic compositions.

In the second azeotropic and pseudo-azeotropic compositions, isopropyl acetate has a strong polarity and a high solubility in fat and oil but has a great surface tension of 22.1 dyn/cm (295K). Thus, it does not have a preferable permeability into object to be cleaned. Further, solvent attack may occur due to the presence of isopropyl acetate, depending on the kind or use condition of plastic to be cleaned. Perfluorocarbon expressed by $C_6F_{14}$ has the characteristic as described above. But perfluorocarbon is superior in its drying function because its heat of vaporization is about 21 cal/g which is much lower that of isopropyl acetate (about 77cal/g) and that of hexamethyldisiloxane (about 50cal/g.) In addition, because perfluorocarbon is an incombustible liquid, it allows the flash point of the mixture of perfluorocarbon, isopropyl acetate which is a flammable liquid, and hexamethyldisiloxane which is also a flammable liquid to be higher than that of isopropyl acetate and hexamethyldisiloxane or that of a mixture of isopropyl acetate and hexamethyldisiloxane, thus allowing the mixture of the three components to be flame-retardant or incombustible.

Hexamethyldisiloxane has the above-described characteristic and is compatible with isopropyl acetate and perfluorocarbon expressed by $C_6F_{14}$ at a given rate. Isopropyl acetate and perfluorocarbon $C_6F_{14}$ are hardly soluble in each other but the addition of hexamethyldisiloxane to the mixture thereof allows the three components to be compatible with each other to form a uniform an azeotropic or pseudo-azeotropic composition. That is, hexamethyldisiloxane functions as an agent for allowing the other two components to be soluble in each other. The effect of the above function of hexamethyldisiloxane varies greatly depending on the kind of a polar solvent. Owing to the addition of hexamethyldisiloxane to isopropyl acetate, it is allowed to have a much higher solubility in perfluorocarbon expressed by $C_6F_{14}$ than lower alcohols such as methanol or ethanol.

Each of the second azeotropic and pseudo-azeotropic compositions consisting of hexamethyldisiloxane, isopropyl acetate, and perfluorocarbon expressed by $C_6F_{14}$ has the characteristic of each of the three components. That is, each of the second azeotropic and pseudo-azeotropic compositions has a high solubility in fat and oil owing to isopropyl acetate; a high permeability into object to be cleaned owing to hexamethyldisiloxane; and a fine drying function owing to perfluorocarbon. Thus, the mixture consisting of each of the second azeotropic composition and the second pseudo-azeotropic composition is a preferable cleaning agent which can be used as one cleaning agent in cleaning, rinsing, and drying processes.

As described above, because the cleaning agent of the present invention has both dirt-removing and drying properties, it can be used from cleaning, rinsing, and drying processes. Therefore, needless to say, the cleaning agent can be used in only a cleaning process, a rinsing process or a drying process. Because the cleaning agent of the present invention does not contain chlorinated organic solvents as its basic component, it does not destroy the ozone layer. Further, as made in the description of the azeotropic composition and the pseudo-azeotropic composition, the mixing ratio between or among the components of the cleaning agent can be prevented from being changed, and the cleaning agent is allowed to be flame-retardant or incombustible.

A cleaning agent containing a third azeotropic composition and a third pseudo-azeotropic composition as their effective component consists of hexamethyldisiloxane, tert-butanol, and perfluorocarbon expressed by perfluoroheptane $C_7F_{16}$.

A cleaning agent containing a fourth azeotropic composition and a fourth pseudo-azeotropic composition as its effective component consists of hexamethyldisiloxane, isopropyl acetate, and perfluorocarbon expressed by perfluoroheptane $C_7F_{16}$.

Preferably, the weight percentage of each component in each of the third azeotropic composition and the third pseudo-azeotropic composition is as follows: Hexamethyldisiloxane: 5 - 25; tert-butanol: 5 - 25; and perfluorocarbon expressed by $C_7F_{16}$: 60 - 90. In this mixing ratio, an azeotropic composition or a pseudo-azeotropic composition having an azeotropic temperature of 337 - 344K (760mmHg) is obtained. The mixing ratio between the components of the azeotropic composition varies depending on a condition. The pseudo-azeotropic composition contains one or more kinds of components than the azeotropic composition in a range that the former has a characteristic similar to that of the latter without substantially deteriorating that of the latter.

The third azeotropic composition and the third pseudo-azeotropic composition can be obtained by a multi-stage rectification method, similarly to the first and second azeotropic compositions and pseudo-azeotropic compositions.

In the third azeotropic composition and the third pseudo-azeotropic composition, hexamethyldisiloxane is compatible with tert-butanol at the normal room temperature at a given rate and compatible with perfluorocarbon expressed by $C_7F_{16}$ at a temperature higher than 308K at an arbitrary rate. Tert-butanol and perfluorocarbon $C_7F_{16}$ are hardly soluble in each other but the addition of hexamethyldisiloxane to a mixture thereof allows the three components to be compatible with each other to form a uniform azeotropic and pseudo-azeotropic composition. That is, hexamethyldisiloxane functions as an agent for allowing the other two components to be soluble in each other. The effect of the above function of hexamethyldisiloxane varies greatly depending on the kind of a polar solvent. Owing to the addition of hexamethyldisiloxane to the tert-butanol of the present invention, tert-butanol is allowed to have a much greater solubility in perfluorocarbon expressed by $C_7F_{16}$ than lower alcohols such as methanol or ethanol.

Because perfluorocarbon expressed by $C_7F_{16}$ does not have cleaning power, it is not suitable as a cleaning agent. But perfluorocarbon is superior in drying function because its heat of vaporization is about 21cal/g which is much lower that of tert-butanol (about 131cal/g) and that of hexamethyldisiloxane (about 50cal/g). In addition, because perfluorocarbon is an incombustible liquid, it allows the flash point of a mixture of perfluorocarbon, tert-butanol which is a flammable liquid, and hexamethyldisiloxane which is also a flammable liquid to be higher than that of tert-butanol and hexamethyldisiloxane or that of a mixture of tert-butanol and hexamethyldisiloxane, thus allowing the mixture of the three substances to be flame-retardant or incombustible.

Each of the third azeotropic composition and the third pseudo-azeotropic composition consisting of hexamethyldisiloxane, tert-butanol, and perfluorocarbon expressed by $C_7F_{16}$ has the characteristic of each of the three components. That is, each of the third azeotropic composition and the third pseudo-azeotropic composition has a high solubility in fat and oil owing to tert-butanol; a high permeability owing to hexamethyldisiloxane; and a fine drying characteristic owing to perfluorocarbon. Thus, the liquid consisting of each of the third azeotropic composition and the third pseudo-azeotropic composition is a preferable cleaning agent which can be used as one cleaning agent from the cleaning through drying processes.

Preferably, the weight percentage of each component in each of the fourth azeotropic composition and the fourth pseudo-azeotropic composition is as follows: Hexamethyldisiloxane: 5 - 25; isopropyl acetate: 5 - 25; and perfluorocarbon expressed by $C_7F_{16}$: 50 - 90. In this mixing ratio, an azeotropic composition or a pseudo-azeotropic composition having an azeotropic temperature of 337 - 345K (760mmHg) is obtained. The mixing ratio between the components of the azeotropic composition varies depending on a condition. The fourth azeotropic and pseudo-azeotropic compositions can be obtained in a manner similar to that for obtaining the third azeotropic and pseudo-azeotropic compositions.

In the fourth azeotropic composition and the fourth pseudo-azeotropic composition, because perfluorocarbon expressed by $C_7F_{16}$ allows the flash point of a mixture of perfluorocarbon, isopropyl acetate which is a flammable liquid, and hexamethyldisiloxane which is also a flammable liquid to be higher than that of isopropyl acetate and hexamethyldisiloxane or that of a mixture of isopropyl acetate and hexamethyldisiloxane, thus allowing the mixture of the three substances to be flame-retardant or incombustible.

Hexamethyldisiloxane has the above-described characteristics and is compatible with isopropyl acetate at the normal room temperature at an arbitrary rate and compatible with perfluorocarbon expressed by $C_7F_{16}$ at a temperature higher than 308K at an arbitrary rate. Isopropyl acetate and $C_7F_{16}$ are hardly soluble in each other but the addition of hexamethyldisiloxane to a mixture thereof allows the three components to be compatible with each other to form a uniform azeotropic or pseudo-azeotropic composition. That is, hexamethyldisiloxane functions as an agent for allowing the other two components to be soluble in each other. The effect of the above function of hexamethyldisiloxane varies greatly depending on the kind of a polar solvent. Owing to the addition of hexamethyldisiloxane to isopropyl acetate of the present invention, isopropyl acetate is allowed to have a much greater solubility in perfluorocarbon expressed by $C_7F_{16}$ than lower alcohols such as methanol or ethanol.

Each of the fourth azeotropic composition and the fourth pseudo-azeotropic composition consisting of hexamethyldisiloxane, isopropyl acetate, and perfluorocarbon expressed by $C_7F_{16}$ has the characteristic of each of the three components. That is, each of the fourth azeotropic composition and the fourth pseudo-azeotropic composition has a high solubility in fat and oil owing to isopropyl acetate; a high permeability owing to hexamethyldisiloxane; and a fine drying characteristic owing to perfluorocarbon $C_7F_{16}$. Thus, the liquid consisting of each of the fourth azeotropic composition and the fourth pseudo-azeotropic composition is a preferable cleaning agent which can be used as one cleaning agent from the cleaning through drying processes.

As described above, because the cleaning agent of the present invention has both dirt-removing and drying properties, it can be used from the cleaning through drying processes. Therefore, needless to say, the cleaning agent can be used in each of the cleaning, rinsing, and drying processes. Because the cleaning agent of the present invention does not contain chlorinated organic solvents as its basic component, it does not destroy the ozone layer. Further, as made in the description of the azeotropic composition and the pseudo-azeotropic composition, the mixing ratio between the components of the cleaning agent can be prevented from being changed, and the cleaning agent is allowed to be flame-retardant or incombustible.

A cleaning agent containing a fifth azeotropic composition or a fifth pseudo-azeotropic composition as its effective component consists of hexamethyldisiloxane, tert-butanol, and perfluorocarbon expressed by perfluoromorpholine.

A cleaning agent containing a sixth azeotropic composition and a sixth pseudo-azeotropic composition as its effective component consists of hexamethyldisiloxane, isopropyl acetate, and perfluorocarbon expressed by perfluoromorpholine.

As perfluoromorpholine to be used in the fifth and sixth azeotropic compositions and the fifth and sixth pseudo-azeotropic compositions, perfluoro-N-alkylmorpholine is preferable and perfluoro-N-methylmorpholine expressed by $C_5F_{11}NO$ is preferable.

Preferably, the weight percentage of each component in each of the fifth azeotropic composition or the fifth pseudo-azeotropic composition is as follows: Hexamethyldisiloxane: 1 - 20; tert-butanol: 1 - 20; and perfluoromorpholine 60 - 98. In this mixing ratio, an azeotropic composition or a pseudo-azeotropic composition having an azeotropic temperature of 313 - 322K (760mmHg) is obtained. The mixing ratio between the components of the azeotropic composition varies depending on a condition. The pseudo-azeotropic composition contains one or more kinds of components than the azeotropic composition in a range that the former has a characteristic similar to that of the latter without substantially deteriorating that of the latter.

The fifth azeotropic composition or the fifth pseudo-azeotropic composition can be obtained by a multi-stage rectification method, similarly to the first and second azeotropic and pseudo-azeotropic compositions.

Because perfluoromorpholine of the fifth azeotropic composition or the fifth pseudo-azeotropic composition does not have cleaning power, it is not suitable as a cleaning agent. But perfluoromorpholine is superior in drying function because its heat of vaporization is about 21cal/g which is much lower that of tert-butanol (about 131cal/g) and that of hexamethyldisiloxane (about 50cal/g). In addition, because perfluoromorpholine is an incombustible liquid, it allows the flash point of a mixture of perfluoromorpholine, tert-butanol which is a flammable liquid, and hexamethyldisiloxane which is also a flammable liquid to be higher than that of tert-butanol and that of hexamethyldisiloxane, thus allowing the mixture of the three substances to be flame-retardant or incombustible.

Hexamethyldisiloxane is compatible with tert-butanol and perfluoromorpholine at an arbitrary rate. Tert-butanol and perfluoromorpholine are hardly soluble in each other, but the addition of hexamethyldisiloxane to a mixture thereof allows the three substances to be compatible with each other to form a uniform an azeotropic or pseudo-azeotropic composition. That is, hexamethyldisiloxane functions as an agent for allowing the other two substances to be soluble in each other. The effect of the above function of hexamethyldisiloxane varies greatly depending on the kind of a polar solvent. Owing to the addition of hexamethyldisiloxane to tert-butanol, tert-butanol is allowed to have a much larger solubility in perfluoromorpholine than lower alcohols such as methanol or ethanol. The fifth azeotropic composition and the fifth pseudo-azeotropic composition have the advantage of each of hexamethyldisiloxane, tert-butanol, and perfluoromorpholine.

Preferably, the weight percentage of each component in each of the sixth azeotropic composition and the sixth pseudo-azeotropic composition is as follows: Hexamethyldisiloxane: 1 - 20; isopropyl acetate: 1 - 20; and perfluoromorpholine 60 - 98. In this mixing ratio, an azeotropic composition or a pseudo-azeotropic composition having an azeotropic temperature of 315 - 322K (760mmHg) is obtained. The mixing ratio between the components of the azeotropic composition varies depending on a condition. The pseudo-azeotropic composition contains one or more kinds of components than the azeotropic composition in a range that the former has a characteristic similar to that of the latter without substantially deteriorating that of the latter.

The sixth azeotropic composition and the sixth pseudo-azeotropic composition can be obtained by a multi-stage rectification method, similarly to the first and second azeotropic and pseudo-azeotropic compositions.

Because perfluoromorpholine is an incombustible liquid, it allows the flash point of a mixture of perfluoromorpholine, isopropyl acetate which is a flammable liquid, and hexamethyldisiloxane which is also a flammable liquid to be higher than that of isopropyl acetate and that of hexamethyldisiloxane, thus allowing the mixture of the three substances to be flame-retardant or incombustible.

Hexamethyldisiloxane is compatible with isopropyl acetate and perfluoromorpholine ($C_5F_{11}NO$) at an arbitrary rate. Isopropyl acetate and perfluoromorpholine are hardly soluble in each other but the addition of hexamethyldisiloxane to a mixture thereof allows the three substances to be compatible with each other to form a uniform an azeotropic composition or a pseudo-azeotropic composition. That is, hexamethyldisiloxane functions as an agent for allowing the other two substances to be soluble in each other. The effect of the above function of hexamethyldisiloxane varies greatly, depending on the kind of a polar solvent. Owing to the addition of hexamethyldisiloxane to isopropyl acetate, isopropyl acetate is allowed to have a much larger solubility in perfluoromorpholine than lower alcohols such as methanol or ethanol. The sixth azeotropic composition and the sixth pseudo-azeotropic composition have the advantage of each of hexamethyldisiloxane, isopropyl acetate, and perfluoromorpholine.

The cleaning agents comprising any of the first through sixth azeotropic or pseudo-azeotropic compositions may contain cleaning components or azeotropic stabilizers in addition to the azeotropic compositions or the pseudo-azeotropic compositions of the present invention in a range in which the cleaning components and the azeotropic stabilizers do not deteriorate the cleaning and drying properties of the cleaning agents of the present invention.

The cleaning agents comprising any of the first through sixth azeotropic or pseudo-azeotropic compositions may be mixed with perfluorocarbons selected from $C_6F_{14}$, $C_7F_{16}$, $C_8F_{18}$, perfluoromorpholine; fluorocarbons selected from hydrofluorocarbons and hydrochlorofluorocarbons; tert-butanol or isopropyl acetate mixed with substances selected from alcohols, ketones, ethers, esters, amines, hydrocarbon compounds or the like.

Stabilizers may be added to the cleaning agents comprising any of the first through sixth azeotropic or pseudo-azeotropic compositions to prevent the components of the cleaning agents from being decomposed by ultraviolet rays or the like. The stabilizers include epoxide such as glycidol and cyclohexeneoxide; ethers such as 1,4-dioxane, 1,3,5-trioxane; unsaturated hydrocarbons such as 1-pentene and 1-hexene; and acrylic ester such as methyl acrylate and ethyl acrylate. Preferably, 0.1-5 wt% of the stabilizers are added to the total weight of the cleaning agent. The stabilizers can be added to the cleaning agent singly or in combination thereof.

The cleaning agent of the present invention is applicable to objects made of metals, semi-metals, ceramics, plastics, and the like. The metals and semi-metals include iron, aluminum, silicon, copper, stainless steel, and the like. Ceramics include silicon nitride, silicon carbide, aluminum oxide, glass, porcelain, and the like. Plastics include polyamide, polyimide, epoxy resin, polyolefin, polyester, acrylic resin, and the like. The object also includes complexes of above described materials. Objects to which the cleaning agent can be applied include electronic parts such as printed circuit boards, electric parts, semiconductor parts, metal parts, surface treatment parts, precision parts, optical parts, glass parts, ceramic parts, plastic parts, and the like.

A cleaning agent containing a seventh azeotropic composition and a seventh pseudo-azeotropic composition as its effective component consist of hexamethyldisiloxane and tert-butanol.

A cleaning agent containing an eighth azeotropic composition and an eighth pseudo-azeotropic composition as its effective component consist of hexamethyldisiloxane and isopropyl acetate.

Preferably, the weight percentage of each component in each of the seventh azeotropic composition and the seventh pseudo-azeotropic composition is as follows: Hexamethyldisiloxane: 44 - 50 and tert-butanol: 50 - 60. In this mixing ratio, an azeotropic composition or a pseudo-azeotropic composition having an azeotropic temperature of 350 - 355K (760mmHg) is obtained. The mixing ratio between the components of the azeotropic composition varies depending on a condition. The seventh azeotropic composition and the seventh pseudo-azeotropic composition can be obtained by a multi-stage rectification method, similarly to the first and second azeotropic and pseudo-azeotropic compositions.

In the seventh azeotropic composition or the seventh pseudo-azeotropic composition, because hexamethyldisiloxane is compatible with tert-butanol at the normal room temperature at an arbitrary rate, a uniform azeotropic or pseudo-azeotropic composition can be formed.

Each of the seventh azeotropic composition and the seventh pseudo-azeotropic composition consisting of hexamethyldisiloxane and tert-butanol has the characteristic of each of the two substances. That is, each of the seventh azeotropic composition and the seventh pseudo-azeotropic composition has a high solubility in fat and oil owing to tert-butanol and an excellent permeability and a high drying speed owing to hexamethyldisiloxane, and prevents water from being contained therein, thus preventing plastics from deteriorating. Thus, the seventh azeotropic composition and pseudo-azeotropic compositions can be used preferably as a cleaning agent.

Preferably, the weight percentage of each component in each of the eighth azeotropic and eighth pseudo-azeotropic composition is as follows: Hexamethyldisiloxane: 40 - 46 and isopropyl acetate: 54 - 60. In this mixing ratio, an azeotropic composition or a pseudo-azeotropic composition having an azeotropic temperature of 355 - 358K (760mmHg) is obtained. The mixing ratio between the components of the azeotropic composition varies depending on a condition. The eighth azeotropic and pseudo-azeotropic compositions can be obtained in a manner similar to that for obtaining the first azeotropic and pseudo-azeotropic compositions.

In the eighth azeotropic and pseudo-azeotropic compositions, hexamethyldisiloxane is compatible with isopropyl acetate at the normal room temperature at an arbitrary rate, thus forming a uniform azeotropic or pseudo-azeotropic composition. Each of the eighth azeotropic composition and the eighth pseudo-azeotropic composition consisting of hexamethyldisiloxane and isopropyl acetate has the characteristic of each of the two components. That is, each of the

eighth azeotropic composition and the eighth pseudo-azeotropic composition has a high solubility in fat and oil owing to isopropyl acetate and an excellent permeability and a high drying speed owing to hexamethyldisiloxane, and prevents water from being contained therein, thus preventing plastics from deteriorating. Thus, the eighth azeotropic composition and the eighth pseudo-azeotropic composition can be used preferably as a cleaning agent. Accordingly, a cleaning agent containing the eighth azeotropic composition or the eighth pseudo-azeotropic composition is very effective because it is not changed in the mixing ratio between the components thereof and superior in degreasing property, cleaning property, drying speed, and recovering property. In addition, the cleaning agent can be used singly from a cleaning process through a drying process.

The cleaning agent comprising any of the seventh and eighth azeotropic compositions or the seventh and eighth pseudo-azeotropic compositions may contain cleaning components or azeotropic stabilizers in addition to the azeotropic compositions or pseudo-azeotropic compositions of the present invention provided that the cleaning components or azeotropic stabilizers do not deteriorate the cleaning and drying properties of the cleaning agents. For example, tert-butanol or isopropyl acetate may be mixed with alcohols, ketones, ethers, esters, amines, hydrocarbon compounds or the like.

The stabilizers applicable to the cleaning agent comprising any of the first through sixth azeotropic or pseudo-azeotropic compositions can be added to the cleaning agent comprising the seventh and eighth azeotropic or pseudo-azeotropic compositions. The cleaning agent comprising the seventh and eighth azeotropic or pseudo-azeotropic compositions are applicable to the objects which can be cleaned by the cleaning agent comprising any of the first through sixth azeotropic or pseudo-azeotropic compositions.

A cleaning agent containing a ninth azeotropic composition and a ninth pseudo-azeotropic composition as its effective component consist of fluorocarbons and a polar cleaning agent having a solubility parameter not less than nine or a dielectric constant not less than four. Preferable azeotropic compositions or pseudo-azeotropic compositions include 95-90 wt% of $C_4F_9OCH_3$ and 5-10 wt% of methanol; 94-89 wt% of $C_4F_9OCH_3$ and 6-11 wt% of methanol or IPA; 87-81 wt% of $C_4F_9OCH_3$ and 13-19 wt% of methyl ethyl ketone; 71-64 wt% of $C_4F_9OCH_3$ and 29-36 wt% of ethyl formate.

The stabilizers applicable to the cleaning agent comprising any of the first through sixth azeotropic compositions or pseudo-azeotropic compositions can be added to the cleaning agent comprising the ninth azeotropic or pseudo-azeotropic composition. The cleaning agent comprising the ninth is applicable to objects which can be cleaned by the cleaning agent comprising any of the first through sixth azeotropic or pseudo-azeotropic compositions.

The first through ninth azeotropic compositions and pseudo-azeotropic compositions which are used as the effective component of the cleaning agents of the present invention may be used as paint solvents, reagent, various kinds of solvents.

The mixing ratio between the components of the cleaning agents containing the first through ninth azeotropic and pseudo-azeotropic compositions is determined based on a peak area of each component obtained by gas chromatography which analyzes the azeotropic fraction of each component. The mixing ratio was analyzed by gas chromatography in the following conditions: An apparatus (GD-14A(Detector TC-D)) used was manufactured by Shimazu Manufacturing Co., Ltd, column: 2m x 3mmϕ (manufactured by GL Science chromosorb Corp. WAWDMCS, mesh 60/80); filler: Silicone SE-30 10%; injection temperature: 523K; TC-D temperature: 523K; initial temperature: 323K; initial holding time: 0min; temperature rise speed: 10K/min; final temperature: 523K; final holding time: 0 min; electric current: 100mA; FR CR He: 40ml; and attenuation: 64.

The cleaning apparatus of the present invention will be described below.

A first cleaning apparatus comprises a body for carrying out at least one of cleaning, rinsing, and vapor-drying an object by means of a mixed cleaning agent consisting of a low molecular weight siloxane compound and incombustible or flame-retardant fluorocarbons; and a composition control mechanism for controlling the mixing ratio between the low molecular weight siloxane compound and fluorocarbons.

The same low molecular weight siloxane compound and fluorocarbons as those of the first cleaning method can be used in the first cleaning apparatus. The cleaning agent consisting of the low molecular weight siloxane compound to be used in the present invention may contain solvents such as a polar solvent, a hydrocarbon solvent, an ether solvent, an acetal solvent or the like. In addition, the cleaning agent may contain various kinds of additives such as a surface-active agent or a hydrophilic solvent.

It is necessary to take a safety countermeasure for preventing the occurrence of a fire or extinguishing a fire when a cleaning agent containing the flammable low molecular weight siloxane compound is used. Table 4 shows flash points and boiling points of representative low molecular weight siloxane compounds.

Table 4

| Name of solvent | Flash point (K) | Boiling point (K) |
|---|---|---|
| Octamethylcyclotetrasiloxane | 328 | 449 |
| Octamethyltrisiloxane | 308 | 426 |
| Hexamethyldisiloxane | 273 | 373 |

In order for combustible solvents to burn, the three elements of burning, namely, a combustible material, oxygen (oxides or the like), and a heat source (ignition energy) are indispensable. Unless the three elements are present simultaneously, burning does not occur and a fire which has occurred is incapable of continuing.

A combustible liquid starts to burn by inflammability and ignition. Inflammability is a phenomenon that an inflammable liquid starts to burn in flame due to the presence of small pilot flame over the inflammable liquid when the inflammable liquid is heated. This is because inflammable gas (vapor) generated from the surface of the inflammable liquid has mixed with oxygen at the lower limit concentration of the combustible range of the inflammable liquid. The lowest temperature at which the inflammable liquid is ignited is a flash point. Ignition is a phenomenon that the inflammable liquid starts to burn in flame due to oxidation heat even though there is no heat sources. The lowest temperature at which the inflammable liquid burns is an ignition point. Therefore, it is necessary to satisfy one of the following three conditions in order to use a flammable solvent safely.

1) A solvent is used below the lower limit of its combustible range and is not heated higher than the flash point thereof.
2) Generation of heat sources (electric spark, friction or the like) is prevented.
3) Oxygen is cut off. Further, a condition of "4) Extinguishing countermeasures are taken" increases in more safety.

Taking safety countermeasures as described above is effective to prevent fire from breaking out or extinguishing in using the flammable solvents. According to the present invention, a cleaning agent consists of a mixture of a flammable low molecular weight siloxane compound and fluorocarbons incombustible or flame-retardant to use the flammable low molecular weight siloxane compound safely.

That is, some of fluorocarbons do not pollute the atmospheric air and hence are not harmful to the health. In addition, they do not burn and are effective for cutting off oxygen in ambient air from a heat source. Incombustible or flame-retardant fluorocarbons which dissolve the low molecular weight siloxane compound therein is selected and mixed with a cleaning agent containing the low molecular weight siloxane compound. The mixture of the low molecular weight siloxane compound and fluorocarbons can be used as a cleaning agent incombustible and flame-retardant.

Although the mixing ratio between fluorocarbons and the low molecular weight siloxane compound varies depending on whether the mixture of the two substances is used in a cleaning process, a rinsing process or a drying process, it is preferable to mix 10 - 10,000 parts by weight of the former with respect to 100 parts by weight of the latter. A cleaning agent containing not less than 10 parts by weight of fluorocarbons and 100 parts by weight of the low molecular weight siloxane compound is incombustible or flame-retardant. More favorably, 20 - 5,000 parts by weight of fluorocarbons is mixed with 100 parts by weight of the low molecular weight siloxane compound.

The boiling points of fluorocarbons are different from each other, depending on their molecular structures. Preferably, the fluorocarbons to be used in the present invention have boiling points lower than the temperature at which a cleaning agent containing the low molecular weight siloxane compound is used. But it is possible to use fluorocarbons having boiling points almost equal to the temperature at which the cleaning agent containing the low molecular weight siloxane compound is used, in consideration of consumption of fluorocarbons due to their volatility.

As described above, there is a possibility that the incombustibility or the flame-retardancy of the mixture of the low molecular weight siloxane compound and fluorocarbons deteriorates when the former is consumed not less than the latter or vice versa, depending on whether the mixture of the two substances is used in the cleaning process, the rinsing process or the drying process. As a result, the mixing ratio between the two substances changes. In order to prevent such a disadvantage, the cleaning apparatus of the present invention has the mixing ratio control mechanism for controlling the mixing ratio between the low molecular weight siloxane compound and fluorocarbons.

In order to control the mixing ratio between the low molecular weight siloxane compound and fluorocarbons, it is necessary to measure the mixing ratio between the former and the latter continuously or intermittently. If the mixing ratio becomes out of a predetermined range, it is possible to keep the incombustibility and flame retardancy of the mixed cleaning agent because the mixed cleaning agent with a shortage amount of the low molecular weight siloxane compound or that of fluorocarbons.

The specific gravity, refractive index, boiling point, and condensation point of the mixture of the low molecular weight siloxane compound and fluorocarbons are changed according to the mixing ratio therebetween. Therefore, the mixing ratio can be easily controlled by measuring the above-described values of the mixture. The Si-O bond which is the chemical skeleton of the low molecular weight siloxane compound absorbs infrared rays having a very high wavenumber of 1,100cm$^{-1}$. Accordingly, the vapor density of the low molecular weight siloxane compound can be measured by measuring the degree of infrared rays absorbed by the Si-O bond present in the vapor of the mixed cleaning agent. Based on the vapor density of the low molecular weight siloxane compound, the mixing ratio between the low molecular weight siloxane compound and fluorocarbons can be obtained. The concentration of the low molecular weight siloxane compound can be easily measured by internal standard method or calibration curve method, using a dispersion type or an undispersing type spectrophotometer. The measured value can be easily fed back to a cleaning agent supply means of the cleaning apparatus.

That is, the mixing ratio control means of the first cleaning apparatus comprises a means for measuring the mixing ratio between the low molecular weight siloxane compound and fluorocarbons of the mixed cleaning agent; and a means for supplying the mixed cleaning agent with the low molecular weight siloxane compound or fluorocarbons by a shortage amount thereof according to a result measured by the mixing ratio measuring means. Adding to above described IR method, the mixing ratio measuring means has a means for measuring at least one of the specific gravity, refractive index, boiling point, and condensation point of the mixed cleaning agent.

Table 5 shows the specific gravity, refractive index, and boiling point of hexamethyldisiloxane as an example of the low molecular weight siloxane compound and those of perfluorocarbon $C_6F_{14}$ as an example of fluorocarbons. Fig. 9 shows the change in the boiling point and condensation point of the mixture of the low molecular weight siloxane compound and fluorocarbons which occurs according to the mixing ratio therebetween. Fig. 10 shows the change in the specific gravity of the mixture of the low molecular weight siloxane compound and fluorocarbons which occurs according to the mixing ratio therebetween. Fig. 11 shows the change in the refractive index of the mixture of the low molecular weight siloxane compound and fluorocarbons which occurs according to the mixing ratio therebetween.

Table 5

| | Specific gravity | Index of refraction | Boiling point (K) |
|---|---|---|---|
| Hexamethyldisiloxane | 0.76 | 1.373 | 373 |
| Perfluorocarbon $C_6F_{14}$ | 1.68 | 1.251 | 329 |

As apparent from Figs. 9, 10, and 11, the mixing ratio between the low molecular weight siloxane compound and fluorocarbons can be easily obtained by measuring the specific gravity, refractive index, boiling point, and condensation point of the mixture thereof.

As described above, in using the flammable low molecular weight siloxane compound as the cleaning agent of the cleaning apparatus, incombustible or flame-retardant fluorocarbons are mixed with the low molecular weight siloxane compound to allow the mixture to be incombustible or flame-retardant. In this manner, safety can be secured against fire. Further, the cleaning apparatus has the mechanism for controlling the mixing ratio between the low molecular weight siloxane compound and fluorocarbons to provide the cleaning apparatus with a safety measure and use the low molecular weight siloxane compound effectively.

The cleaning apparatus of the present invention is provided with means for preventing/suppressing the occurrence of fire or means for extinguishing it, based on the above-described conditions (1) - (4), thus enhancing safety against fire.

In a second cleaning apparatus of the present invention, a cleaning agent containing the low molecular weight siloxane compound is used. The cleaning apparatus comprises a means for measuring the density of the vapor of the low molecular weight siloxane compound generated from the cleaning agent, based on the degree of the infrared absorption of the Si-O bond of the low molecular weight siloxane compound; and a means for adjusting the temperature of the cleaning agent.

In a third cleaning apparatus of the present invention, a cleaning agent containing the low molecular weight siloxane compound is used. The gas or liquid of incombustible or flame-retardant fluorocarbons is charged into or placed in at least one of the inside of the cleaning apparatus, the periphery of the cleaning apparatus, the inside of devices constituting the cleaning apparatus, and the periphery of the devices.

In a fourth cleaning apparatus of the present invention, a cleaning agent containing a low molecular weight siloxane compound is used. The cleaning apparatus comprises a means for injecting an extinguishing agent consisting of gas of incombustible or flame-retardant fluorocarbons or liquid thereof to at least a part of the cleaning apparatus. The cleaning apparatus further comprises at least one of a flame detection means for driving the extinguishing agent injection means; a temperature detection means; and a pressure detection means.

In the second through fourth cleaning apparatuses, the cleaning agent containing the low molecular weight siloxane compound is used. The cleaning agent of the present invention includes a cleaning agent to be used to minimize the concentration of dirt or removes the dirt from an object; a rinsing cleaning agent to be used to minimize the concentration of the cleaning agent or removes the cleaning agent from the object; and a vapor drying agent to be used to vaporize the cleaning agent and the rinsing cleaning agent or remove them from the object.

The same low molecular weight siloxane compound as that to be used in the first cleaning method can be used in the second through fourth cleaning apparatuses.

The cleaning agent consisting of the low molecular weight siloxane compound to be used in the second through fourth cleaning apparatuses may contain solvents such as a polar solvent, a hydrocarbon solvent, an ether solvent, an acetal solvent or the like. In addition, the cleaning agent may contain various kinds of additives such as a surface-active agent or a hydrophilic solvent. The second through fourth cleaning apparatuses are effective when the cleaning agent containing the low molecular weight siloxane compound as its main component is used.

The low molecular weight siloxane compounds have flash points as shown in table 4. When a cleaning agent containing one of the low molecular weight siloxane compound is used, it is necessary to take the above-described four safety measures for preventing and suppressing the occurrence of fire or extinguishing fire.

In order to use a solvent at a temperature below its flash point, based on the first condition, it is necessary to control the temperature of the solvent. Merely the temperature control of the low molecular weight siloxane compound is insufficient. It is necessary to control the density of the vapor of the low molecular weight siloxane compound so that the density thereof is out of its combustion range. As described previously, the Si-O bond which is the chemical skeleton of the low molecular weight siloxane compound absorbs strongly infrared rays having a wave-number of 1,100$cm^{-1}$. Accordingly, the vapor density of the low molecular weight siloxane compound can be measured by measuring the degree of infrared rays absorbed by the Si-O bond present in the vapor of the mixed cleaning agent.

The second cleaning apparatus comprises a means for measuring the vapor density of the low molecular weight siloxane compound, based on the degree of infrared rays having a wave-number of 1,100$cm^{-1}$ absorbed by the Si-O bond. Because the means for measuring the vapor density of the low molecular weight siloxane compound operates with a high sensitivity, the vapor density of the low molecular weight siloxane compound can be controlled very accurately so that the vapor density of the low molecular weight siloxane compound is out of its combustion range. The cleaning agent containing the flammable low molecular weight siloxane compound can be used more safely in its incombustible range by using a means for measuring the concentration of oxygen in combination with the means for measuring the vapor density of the low molecular weight siloxane compound. Because the specific heat of the low molecular weight siloxane compound is low, cleaning operation can be accomplished at a temperature lower than the flash point of the low molecular weight siloxane compound by using a fuzzy control or the like.

In order to prevent the generation of a heat source based on the second condition, generally, the following means are adopted: "Flammables" in a work site where a cleaning agent is used, a noncontact relay is adopted on electric equipments to be mounted on a cleaning apparatus or motors or the like have flameproof constructions. Even though these means are adopted, it is impossible to completely prevent the generation of the heat source. In order to cut off oxygen from the heat source, based on the second condition, it is known that inactive gases such as nitrogen, argon, helium, neon, krypton, xenon, radon is supplied to the cleaning apparatus. Because these inactive gases have low densities and thus disperse and leak, they are very uneconomical and it is necessary to always supply the airtight cleaning apparatus with an inactive gas.

As a result of energetic researches of the present inventors, they have found that the low molecular weight siloxane compound is compatible with fluorocarbons such as perfluorocarbons, hydrofluorocarbons, hydrochlorofluorocarbons, fluoroiodidecarbons, fluoroalcohols, hydrofluoroethers and that some of them are soluble in each other. Because fluorocarbons are incombustible or flame-retardant, the gas or liquid of fluorocarbons is charged into or placed in the inside of the cleaning apparatus, the periphery of the cleaning apparatus, the inside of devices constituting the cleaning apparatus or the periphery of the devices. In this manner, the cleaning agent or the vapor thereof or oxygen can be cut off from a heat source.

The third cleaning apparatus has been devised based on the above-described discovery. The gas or liquid of incombustible or flame-retardant fluorocarbons is charged into or placed in at least one of the inside of the cleaning apparatus, the periphery of the cleaning apparatus, the inside of devices constituting the cleaning apparatus, and the periphery of the devices. The cleaning apparatus includes various peripheral devices. That is, the cleaning apparatus comprises peripheral devices such as electric devices including a liquid recovery device, control instruments, and driving instruments in addition to main devices such as a cleaning tank and a drying device. It is to be noted that the apparatus described below includes the cleaning apparatus and devices constituting the cleaning apparatus.

The generation of a heat source can be prevented by charging the gas of the incombustible or flame-retardant fluorocarbons into heat source generation devices such as the electric equipments. The gas or liquid of the incombustible or flame-retardant fluorocarbons is charged into or placed in the inside of the cleaning apparatus, the periphery of the cleaning apparatus, the inside of devices constituting the cleaning apparatus or the periphery of the devices. In this

manner, the penetration of oxygen into the cleaning apparatus can be prevented, and the density of the vapor of low molecular weight siloxane compound can be easily adjusted to its incombustible range. Fluorocarbons have high vapor pressures and vaporize readily. Thus, fluorocarbons placed in the inside and periphery of the cleaning apparatus provide the above-described effect and absorb low molecular weight siloxane compound which has leaked from the cleaning tank or pipes to form an incombustible or flame-retardant mixture, which allows the cleaning apparatus to be used safely.

Fluorocarbons have a high vapor density and hence does not disperse readily, i.e., it does not leak in a great amount from the cleaning apparatus. Further, fluorocarbons allow the inside of the cleaning apparatus airtight, thus effectively preventing oxygen from permeating thereinto from the ambient air.

In addition to the vapor of incombustible or flame-retardant fluorocarbons, the liquid thereof fluorocarbons may be charged in the periphery of various devices including the cleaning tank. In other words, the devices of the cleaning apparatus may be immersed in liquid of the incombustible or flame-retardant fluorocarbons to cut off the fluorocarbons from heat sources or oxygen. That is, the third cleaning apparatus has been devised based on such an aspect. Needless to say, it is possible to use inactive gas in combination with fluorocarbons.

The same incombustible or flame-retardant fluorocarbons as those to be used in the first cleaning method can be used in the third cleaning apparatus.

As the fourth condition, cooling extinguishing method, smothering extinguishing method, removal extinguishing method, and dilution extinguishing method are known. In smothering extinguishing method, the surface of a burning object is covered with an inactive gas such as carbon dioxide having a high vapor density than oxygen to cut off the object from oxygen. As described above, because the low molecular weight siloxane compound has a high solubility in fluorocarbons, the liquid or gas of fluorocarbons is preferable as an extinguishing agent.

In the fourth cleaning apparatus comprises the means for injecting an extinguishing agent consisting of the gas or liquid of incombustible or flame-retardant fluorocarbons to at least a part of the cleaning apparatus. The low molecular weight siloxane compound has a high solubility in fluorocarbons. Thus, the extinguishing agent consisting of the gas or liquid of incombustible or flame-retardant fluorocarbons prevents a fire from spreading to objects or dilutes the density of the vapor of the flammable low molecular weight siloxane compound to its incombustible range and cuts off oxygen from a heat source. Further, because fluorocarbons has a higher vapor density than an inactive gas such as carbon dioxide, it is capable of cutting off oxygen from the heat source. Because the low molecular weight siloxane compound has a high solubility in fluorocarbons, it can be used as an effective extinguishing agent.

As the incombustible or flame-retardant fluorocarbons to be used as an extinguishing agent in the fourth cleaning apparatus, the same fluorocarbons as those to be used in the third cleaning method can be used. In particular, fluorocarbons which generates trifluoro radicals having a favorable extinguishing effect can be preferably used.

The fifth cleaning apparatus which is related to the sixth cleaning method is used as a dewatering drying apparatus having a dewatering drying means using a liquid not forming an azeotropic composition when the liquid has mixed with water and having a heat of vaporization lower than 100 cal/g.

The dewatering drying apparatus has a dewatering drying means provided with a dewatering drying liquid such as trifluoroethanol. Preferably, the dewatering drying apparatus has a means, for example, a distillation means for removing water and dirty components which have mixed with the dewatering drying liquid regularly or intermittently. The distillation means can mount a vacuum means such as an aspirator. Thus, an effective dewatering cleaning with no stains on the object can be done by mounting the means for removing water.

According to the dewatering drying method and the dewatering drying apparatus of the present invention, liquid containing trifluoroethanol or a mixture of trifluoroethanol and the like can be effectively used not only for a water-replacing operation (immersion, vibration, agitation, ultrasonic waver, spray), but also for a drying operation (hot air drying, spin drying, vapor drying, lift drying, vacuum drying.)

## BRIEF DESCRIPTION OF THE DRAWINGS

Fig. 1 is a block diagram showing the construction of a dewatering drying apparatus according to an embodiment of the present invention;

Fig. 2 is a block diagram showing the construction of a dewatering drying apparatus according to another embodiment of the present invention;

Fig. 3 is a graph showing an example of a calibration curve used to quantitatively determine mixing ratio between components of an azeotropic composition;

Fig. 4 is a IR chart of a low molecular weight siloxane compound;

Fig. 5 is a block diagram showing the construction of a cleaning apparatus according to an embodiment of the present invention;

Fig. 6 is a block diagram showing the construction of a cleaning apparatus according to another embodiment of the present invention;

Fig. 7 is a block diagram showing a modification of the cleaning tank or the like of the cleaning apparatus shown in

Fig. 6;

Fig. 8 is a view showing another modification of the cleaning tank or the like of the cleaning apparatus shown in Fig. 6;

Fig. 9 is a graph showing the change in the boiling and condensation points of a mixture of a low molecular weight siloxane compound and fluorocarbons which occurs according to the change in the mixing ratio therebetween;

Fig. 10 is a graph showing the change in the specific gravity of the mixture of the low molecular weight siloxane compound and fluorocarbons which occurs according to the change in the mixing ratio therebetween; and

Fig. 11 is a graph showing the change in the refractive index of the mixture of low molecular weight siloxane compound and fluorocarbons which occurs according to the change in the mixing ratio therebetween.

BEST MODE FOR CARRYING OUT THE INVENTION

The detailed description of the embodiments of the present invention is described below.

Embodiments 1 - 34

First, description will be made on examples of a mixed cleaning agent to be used in the rinsing and drying processes of the first cleaning method of the present invention and evaluations of the characteristics of the mixed cleaning agents.

Perfluorocarbon ($C_6F_{14}$) and hexamethyldisiloxane were prepared as fluorocarbons and the low molecular weight siloxane compound, respectively. The two substances were mixed with each other at a mixing ratio (weight ratio) of 85/15 - 30/70, as shown in tables 7 and 8. Polar cleaning agents shown in tables 7 and 8 were added to the mixture to prepare mixed cleaning agents.

The solubility and flammability of dirty components of each mixed cleaning agent thus obtained were evaluated as follows: First, liquid paraffin (viscosity: 30cSt (298K)), isostearic acid, chlorinated paraffin (manufactured by Ajinomoto Co., Ltd.), and FLUX SR-210 (low residue type), (commercial name: manufactured by Senju Kinzoku Co., Ltd.) were prepared as a base oil, an oily agent, a extreme pressure agent, and flux, respectively. Each of these substances was added to 200g of the respective mixed cleaning agents at a concentration of five weight percentages to examine the solubility of each mixed cleaning agent visually. The solubility of each mixed cleaning agent was evaluated as follows. The results of the evaluation are shown in tables 7 and 8.

[Solubility of dirt]

A: completely dissolved in mixed cleaning agent within 30 seconds after addition.
B: completely dissolved in mixed cleaning agent in 30 - 60 seconds after addition.
C: dissolved in mixed cleaning agent in not less than 60 seconds after addition.
D: dirt was not dissolved in mixed cleaning agent.

The flammability of each mixed cleaning agent was evaluated by measuring the flash point thereof in accordance with JIS-K-2265, using a tag-closed type flash point measuring device and a Cleveland open type flash point measuring device. The flammability of each mixed cleaning agent is indicated in terms of incombustibility and flame-retardancy. The evaluated results are shown in tables 7 and 8.

[Measurement of flash point]

Incombustibility: Flash point of each mixed cleaning agent cannot be measured by tag-closed type flash point measuring device and Cleveland open type flash point measuring device. Flame retardancy: Flash point of each mixed cleaning agent cannot be measured by tag-closed type flash point measuring device or Cleveland open type flash point measuring device.

Table 7

| Embodiment | MM/PFC *1 (mixing ratio/weight) | Polar cleaning agent | | | | | Dirty substance | | | | Flammability |
|---|---|---|---|---|---|---|---|---|---|---|---|
| | | Kind | Amount (wt%) | δ value | ε *2 at 25℃ | Dipole moment | Oil *3 | Oil *4 | Oil *5 | Flux | |
| 1 | 15/85 | Acetone | 5 | 9.62 | 20.70 | 2.69 | ◎ | ○ | × | × | Incombustibility |
| 2 | 15/85 | Methyl ethyl ketone | 15 | 9.45 | 18.51 | 2.76 | ◎ | ○ | × | × | Incombustibility |
| 3 | 30/70 | Tetrahydrofuran | 15 | – | 7.58 | 1.70 | ◎ | ◎ | △ | × | Flame-retardancy |
| 4 | 40/60 | t-Pentyl alcohol | 13 | – | 5.82 | 1.7 | ◎ | ◎ | △ | ○ | Flame-retardancy |
| 5 | 40/60 | Tetrahydrofuran | 15 | – | 5.44 | 1.87 | ◎ | ◎ | △ | ◎ | Flame-retardancy |
| 6 | 40/60 | 1,2-dimetoxyethane | 15 | – | 5.50 | 1.79 | ◎ | ◎ | △ | ◎ | Flame-retardancy |
| 7 | 40/60 | Acetic acid | 14 | – | 6.15 | 1.68 | ◎ | ◎ | △ | ◎ | Flame-retardancy |
| 8 | 40/60 | Isobutyl formate | 13 | – | 6.41 | 1.88 | ◎ | ◎ | △ | ○ | Flame-retardancy |
| 9 | 40/60 | Butyl acetate | 15 | 8.43 | 5.01 | 1.84 | ◎ | ◎ | ○ | ◎ | Flame-retardancy |
| 10 | 40/60 | Ethyl propionate | 15 | 8.77 | 5.65 | 1.74 | ◎ | ◎ | ○ | ◎ | Flame-retardancy |
| 11 | 40/60 | Ethyl acetate | 15 | – | 6.02 | 1.88 | ◎ | ◎ | ○ | ◎ | Flame-retardancy |
| 12 | 40/60 | Propyl acetate | 13 | 8.80 | 6.002 | 1.78 | ◎ | ◎ | ○ | ○ | Flame-retardancy |
| 13 | 40/60 | Diethyl sulfide | 14 | – | 5.72 | 1.61 | ◎ | ◎ | ○ | ○ | Flame-retardancy |
| 14 | 40/60 | Piperidine | 14 | – | 5.8 | 1.13 | ◎ | ◎ | ○ | ○ | Flame-retardancy |
| 15 | 50/50 | Morpholine | 16 | – | 7.42 | 1.5 | ◎ | ◎ | ○ | ○ | Flame-retardancy |
| 16 | 50/50 | Trifluoro acetate | 13 | – | 8.55 | 2.28 | ◎ | ◎ | ◎ | ○ | Flame-retardancy |
| 17 | 60/40 | 2-propanol | 12 | 11.94 | 20.3 | 1.68 | ◎ | ◎ | ◎ | △ | Flame-retardancy |

Note *1: MM;Hexamethyldisiloxane and PFC;Perfluorocarbon ($C_6F_{14}$)

*2: Dielectric constant , *3: Base oil, *4: Oily agent, *5: Extream pressure additives

Unit of Dipole moment : D

Table 8

| Embodiment | MM/PFC *1 (mixing ratio/weight) | Polar cleaning agent | | | | | Dirty substance | | | | Flammability |
|---|---|---|---|---|---|---|---|---|---|---|---|
| | | Kind | Amount (wt%) | δ value | ε *2 at 25℃ | Dipole moment | Oil | | | Flux | |
| | | | | | | | *3 | *4 | *5 | | |
| 18 | 60/40 | 3-pentanon | 12 | – | 19.77 | 2.70 | ◎ | ◎ | ◎ | △ | Flame-retardancy |
| 19 | 60/40 | 2-hexanon | 14 | 8.71 | 16.43 | 2.66 | ◎ | ◎ | ◎ | ◎ | Flame-retardancy |
| 20 | 60/40 | Methyl oxide | 14 | – | 15.6 | 2.84 | ◎ | ◎ | ◎ | ◎ | Flame-retardancy |
| 21 | 60/40 | 2-metoxyethanol | 11 | – | 16.93 | 2.04 | ◎ | ◎ | ◎ | △ | Flame-retardancy |
| 22 | 60/40 | Ethylenediamine | 16 | – | 12.6 | 1.90 | ◎ | ◎ | ◎ | ◎ | Flame-retardancy |
| 23 | 70/30 | 1-propanol | 20 | 12.18 | 22.2 | 1.657 | ◎ | ◎ | ◎ | ◎ | 344K |
| 24 | 70/30 | 2-pentanon | 20 | 8.76 | 21.96 | 2.70 | ◎ | ◎ | ◎ | ◎ | 333K |
| 25 | 70/30 | Butyronitrile | 20 | – | 20.3 | 3.57 | ◎ | ◎ | ◎ | ◎ | 346K |
| 26 | 70/30 | Isobutyronitrile | 20 | – | 20.4 | 3.61 | ◎ | ◎ | ◎ | ◎ | 346K |
| 27 | 70/30 | Nitroethane | 18 | – | 28.06 | 3.70 | ◎ | ◎ | ◎ | ◎ | 349K |
| 28 | 70/30 | Propyonitrile | 15 | 10.73 | 29.7 | 3.57 | ◎ | ◎ | ◎ | ◎ | 338K |
| 29 | 70/30 | Nitromethane | 10 | 12.7 | 35.87 | 3.46 | ◎ | ◎ | ○ | △ | 351K |
| 30 | 70/30 | Acetonitrile | 8 | 12.71 | 37.5 | 3.44 | ◎ | ◎ | ○ | △ | 328K |
| 31 | 15/85 | Ethyl acetate | 5 | – | 6.02 | 1.88 | ◎ | ◎ | ○ | × | Incombustibility |
| 32 | 30/70 | Ethanol | 14 | 12.78 | 23.8 | 1.68 | ◎ | ◎ | ◎ | △ | Flame-retardancy |
| 33 | 30/70 | Butylamine | 14 | 8.66 | 4.88 | 1.20 | ◎ | ◎ | ◎ | ○ | Flame-retardancy |
| 34 | 30/70 | Thiophene | 15 | – | 27.05 | 0.52 | ◎ | ◎ | ○ | △ | Flame-retardancy |

Note *1: MM;Hexamethyldisiloxane and PFC;Perfluorocarbon ($C_6F_{14}$)

*2: Dielectric constant , *3: Base oil, *4: Oily agent, *5: Extream pressure additives

Unit of Dipole moment : D

Embodiments 35 - 39 and Comparison Examples 1 - 3

Examples of the first cleaning method and evaluated results are described below.

After FLUX CRV-5V of RA type (commercial name) manufactured by Tamura Kaken Co., Ltd. was applied to comb-shaped substrates (JIS-Z-3197 2 type), a solvent was removed from each substrate at a pre-heating temperature 373-393K. Then, flux-applied substrates were baked at 503-533K for 30 seconds. The substrates were used as evaluating samples. The flux-cleaning operation was carried out at a temperature 313K and at an ultrasonic wave output of 400W/28kHz for five minutes, using two tanks, cleaning agents, rinsing agents, and vapor cleaning agents shown in table 9. Then, cleaning agents which attached to the substrates were rinsed for five minutes by using two tanks. Then, the rinsing agents were vapor-dried, whereas in comparison example 1, they were dried by hot air.

After the cleaning, rinsing, and drying operations were performed, amounts of residual ions, insulation resistances, white residues, and drying time periods were measured to evaluate the cleaning property and drying characteristic of each cleaning agent. The flammability of each vapor drying agent was evaluated, similarly to the first embodiment. The evaluated result is shown in table 10.

Table 9

| | Cleaning agent | Rinsing agent | Vapor drying agent |
|---|---|---|---|
| Embodiment 35 | Diethylene glycol monobutyl ether | Hexamethyldisiloxane(95)*1<br>Acetone(5) | Perfluorocarbon [$C_6F_{14}$](77)<br>Hexamethyldisiloxane(19)<br>Acetone(4) |
| Embodiment 36 | Butyl lactate | — | Perfluorocarbon [$C_6F_{14}$](74)<br>Hexamethyldisiloxane(18)<br>Ethyl acetate (8) |
| Embodiment 37 | Diethyleneglycol monobutyl ether (60)<br>Propyleneglycol monomethyl ether (40) | Octamethylcyclotetrasiloxane(90)<br>Acetone (10) | Perfluorocarbon [$C_8F_{18}$](90)<br>Hexamethyldisiloxane(9)<br>Acetone(1)) |
| Embodiment 38 | Ethyl acetate | Hydrofluorocarbon<br>[$C_5H_2F_{10}$](95)<br>I P A(5) | ← |
| Embodiment 39 | 3, 5, 5-trimethylhexanol | Perfluoromorpholine(40)<br>Hydrofluorocarbon<br>[$C_5H_1F_{11}$](40)<br>Hexamethyldisiloxane(15)<br>Ethanol(5) | ← |
| *2 1 | Isopropyl alcohol | Water | (Hot air drying) |
| *2 2 | Isoparaffin (90)<br>Octamethylcyclotetrasiloxane (5)<br>Diethylene glycol monobutyl ether (5) | Octamethylcyclotetrasiloxane | Perfluorocarbon [$C_8F_{18}$] |
| *2 3 | Propylene glycol monoethyl ether | Isoparaffin | Hexamethyldisiloxane |

Note *1 : Parenthesized numerical values indicate parts by weight *2 : Comparision Example

← : Indicates the same substance to left coloumn.

Table 10

| Embodiment | Ion residual amount ($\mu g$ $NaCl/in^2$) | Insulation resistance value ($\times 10^{13}$ Ω) | White residue | Drying timed period(second) | flammability of vapor cleaning agent | Ozone depletion coeficient |
|---|---|---|---|---|---|---|
| 35 | 3.2 | 1.0 | 0/20 | 30 | Flame-retardancy | 0 |
| 36 | 4.0 | 3.0 | 0/20 | 60 | Flame-retardancy | 0 |
| 37 | 2.1 | 5.3 | 0/20 | 26 | Incombustibility | 0 |
| 38 | 3.3 | 2.1 | 0/20 | 23 | Incombustibility | 0 |
| 39 | 2.4 | 1.9 | 0/20 | 25 | Incombustibility | 0 |
| ** 1 | 4.1 | 0.05 | 9/20 | >2000 | — | 0 |
| ** 2 | 13.9 | 0.15 | 15/20 | 25 | Incombustibility | 0 |
| ** 3 | 9.8 | 0.9 | 7/20 | 41 | 273K* | 0 |

*: Value measured by tag-closed type flash point measuring device

**: Comparision Example

As apparent from the evaluated results shown in table 10, the cleaning agent of the present invention is superior to that of the comparison examples 1, 2, and 3 in respect of the amount of residual ions, insulation resistances, white residues, and drying time periods. That is, the amount of residual ion of the former was smaller than that of the latter; the

insulation resistance of the former was higher than that of the latter; the former had no white residue; and the drying time period of the former was shorter than that of the latter. Apparently, the cleaning agent of the present invention is superior to that of the comparison examples 1, 2, and 3 in its cleaning and drying properties.

Embodiments 40 - 46 and Comparison Examples 4 - 6

Three grams of spindle oil was applied to steel plates (test pieces) each having a size of 30mm x 30mm x 1mm thickness, and the spindle oil-applied steel plates were baked in a heating oven of 423K for 48 hours to prepare test pieces. An operation of cleaning an oil and fat which attached to each of the test pieces was performed (cleaning by means of ultrasonic wave), using cleaning agents, and then rinsing and drying operations were carried out by means of rinsing agents and vapor cleaning agents shown in table 11 in drying conditions shown in table 11 to measure the amount of the oil and fat which remained on each test piece and drying time periods. The test pieces were immersed in 150ml of carbon tetrachloride, and ultrasonic wave was applied thereto to extract the oil and fat therefrom. Based on the extracted liquid, the amount of the oil and fat which remained on each test piece was measured by an oil content meter (OCMA-220; manufactured by Horiba Manufacturing Co., Ltd) to examine. The flammability of each vapor cleaning agent was evaluated. In examples in which the vapor drying was not carried out, the flammability of each rinsing agent was evaluated, similarly to the embodiment 1. Table 12 shows evaluated results.

Embodiments 47 - 50

The evaluated result of the second cleaning method and the cleaning agent of the present invention will be described below.

Using the test pieces to be used in embodiment 40 as the evaluating test pieces of embodiment 47 - 50, cleaning, rinsing, and vapor drying operations were performed in the same condition as that of embodiment 40 to evaluate the cleaning property of each test piece, except that the kind of each of the cleaning agents, the rinsing agents, and vapor drying agents was different from that of embodiment 40, as shown in table 11. Table 12 shows evaluated results.

As described above, the cleaning agent of the present invention and the first and second cleaning methods have dirty component removing powers equivalent to that of flon solvents or chlorinated solvents and in addition, preferable drying properties. Accordingly, the first and second cleaning methods are capable of cleaning electronic parts such as printed circuit boards, component parts mounted thereon, and the like, and metal component parts in place of the cleaning method to be carried out by using flon solvents or chlorinated solvents.

Table 11

| Embodiment | Cleaning agent | Rinsing agent | Drying agent |
|---|---|---|---|
| 40 | n-Hexanol | Hydrofluorocarbon *1(90)<br>Octamethyldisiloxane (95)<br>IPA (5) | Hot-air drying |
| 41 | Propylene glycol-monoethyl ether | Hexamethyldisiloxane (95)<br>IPA (5) | Natural- air drying |
| 42 | 3-metoxy-3methyl-1-butanol (50)<br>Ethyl lactate(50) | Perfluorocarbon *2(28)<br>Hexamethyldisiloxane (67)<br>Butyl acetate (5) | Vacuum drying |
| 43 | 2-Methyl-cyclohexanol | Perfluorocarbon *2(40)<br>Hexamethyldisiloxane (40)<br>IPA (20) | ← |
| 44 | Acetone (30)<br>Ethanol (70) | Perfluorocarbon *2(78)<br>Isoparaffin (19)<br>Acetone (1)<br>Ethanol (2) | Hot-air drying |
| 45 | Isopentyl alcohol | Hexamethyldisiloxane (95)<br>Methanol (5) | Fluoroiodide-carbon [$C_4F_9I$] (57)<br>Hexamethyl-disiloxane (40)<br>Acetone (3) |
| 46 | Ethyl acetate | $C_4F_9OCH_3$ (50)<br>Acetone (50) | ← |
| 47 | Ethyl-lactate | – | $C_4F_9OCH_3$ (90)<br>Hexamethyldisiloxane(5)<br>Ethyl acetate (5) |
| 48 | Diethylene glycol monobutyl ether | $C_4F_9OCH_3$ (100) | Natural air drying |
| 49 | Dipropylene glycol monomethyl ether | $C_4F_9OC_2H_5$ (100) | ← |
| 50 | Dipropylene glycol dimethyl ether | $C_3F_7OC_2H_5$ (90)<br>Hexamethyldisiloxane (10) | Natural air drying |

Note:

*: Parenthesized numerical values indicate parts by weight.

*1: $C_5H_2F_{10}$ *2: $C_6F_{14}$

Table 11-continue

| Comparison example | Cleaning agent | Rinsing agent | Drying agent |
|---|---|---|---|
| 4 | Isoparaffin | Isoparaffin (90) Acetone (10) | Perfluorocarbon [$C_8F_{18}$] |
| 5 | CFC113(96) Ethanol (4) | ← | ← |
| 6 | Uncleaned | | |

Note Parenthesized numerical values indicate parts by weight.

Table 12

| Embodiment | Remaining oil content (mg/g) | Drying timed period(second) | Ozone depletion coefficient | flammability |
|---|---|---|---|---|
| 40 | 0.010 | 41 | 0 | Incombustibility*1 |
| 41 | 0.006 | 73 | 0 | 275K *1 |
| 42 | 0.031 | 35 | 0 | Flame-retardancy*1 |
| 43 | 0.026 | 22 | 0 | Flame-retardancy*2 |
| 44 | 0.001 | 39 | 0 | Flame-retardancy*1 |
| 45 | 0.018 | 27 | 0 | Flame-retardancy*2 |
| 46 | 0. 015 | 35 | 0 | 293K *2 |
| 47 | 0.028 | 28 | 0 | Flame-retardancy*2 |
| 48 | 0.009 | 25 | 0 | Incombustibility*1 |
| 49 | 0.024 | 36 | 0 | Incombustibility*2 |
| 50 | 0.017 | 42 | 0 | Flame-retardancy*1 |
| ** 4 | 0.153 | 21 | 0 | Incombustibility*2 |
| ** 5 | 0.025 | 32 | 0.8 | Incombustibility*2 |
| ** 6 | 0.686 | - | 0 | - |

Note
*1: flammability of rinsing agent (measured by tag-closed type)
*2: flammability of vapor cleaning agent
**: Comparision Example

Embodiments 51 - 84

The embodiment of the third and fourth cleaning methods and the cleaning agent of the present invention will be described below.

First, perfluorocarbon ($C_6F_{14}$) and hexamethyldisiloxane prepared as fluorocarbons and the low molecular weight siloxane compound, respectively were mixed with each other at a mixing ratio (weight ratio) of 85/15 - 30/70, as shown

in tables 13 and 14 to prepare mixtures of the two components. Polar cleaning agents shown in tables 13 and 14 were added to each mixture to prepare mixed cleaning agents.

The solubility of dirty components and flammability of each of the mixed cleaning agents thus obtained were evaluated in a condition and a method similar to that of embodiment 1. Evaluated results are shown in tables 13 and 14.

Table 13

| Embodiment | MM/PFC *1 (mixing ratio/weight) | Polar cleaning agent: Kind | Amount (wt%) | δ value | ε *2 at 25°C | Dipole moment | Dirty substance: Oil *3 | Oil *4 | Oil *5 | Flux | Flammability |
|---|---|---|---|---|---|---|---|---|---|---|---|
| 51 | 15/85 | Acetone | 5 | 9.62 | 20.70 | 2.69 | ◎ | ○ | × | × | Incombustibility |
| 52 | 15/85 | Methyl ethyl ketone | 15 | 9.45 | 18.51 | 2.76 | ◎ | ○ | × | × | Incombustibility |
| 53 | 30/70 | Tetrahydrofuran | 15 | - | 7.58 | 1.70 | ◎ | ◎ | △ | × | Flame-retardancy |
| 54 | 40/60 | t-Pentyl alcohol | 13 | - | 5.82 | 1.7 | ◎ | ◎ | △ | ○ | Flame-retardancy |
| 55 | 40/60 | Tetrahydrofuran | 15 | - | 5.44 | 1.87 | ◎ | ◎ | △ | ◎ | Flame-retardancy |
| 56 | 40/60 | 1,2-dimetoxyethane | 15 | - | 5.50 | 1.79 | ◎ | ◎ | △ | ◎ | Flame-retardancy |
| 57 | 40/60 | Acetic acid | 14 | - | 6.15 | 1.68 | ◎ | ◎ | △ | ◎ | Flame-retardancy |
| 58 | 40/60 | Isobutyl formate | 13 | - | 6.41 | 1.88 | ◎ | ◎ | △ | ○ | Flame-retardancy |
| 59 | 40/60 | Butyl acetate | 15 | 8.43 | 5.01 | 1.84 | ◎ | ◎ | ○ | ◎ | Flame-retardancy |
| 60 | 40/60 | Ethyl propionate | 15 | 8.77 | 5.65 | 1.74 | ◎ | ◎ | ○ | ◎ | Flame-retardancy |
| 61 | 40/60 | Ethyl acetate | 15 | - | 6.02 | 1.88 | ◎ | ◎ | ○ | ◎ | Flame-retardancy |
| 62 | 40/60 | Propyl acetate | 13 | 8.80 | 6.002 | 1.78 | ◎ | ◎ | ○ | ○ | Flame-retardancy |
| 63 | 40/60 | Diethyl sulfide | 14 | - | 5.72 | 1.61 | ◎ | ◎ | ○ | ○ | Flame-retardancy |
| 64 | 40/60 | Piperidine | 14 | - | 5.8 | 1.13 | ◎ | ◎ | ○ | ○ | Flame-retardancy |
| 65 | 50/50 | Morpholine | 16 | - | 7.42 | 1.5 | ◎ | ◎ | ○ | ○ | Flame-retardancy |
| 66 | 50/50 | Trifluoro acetate | 13 | - | 8.55 | 2.28 | ◎ | ◎ | ◎ | ○ | Flame-retardancy |
| 67 | 60/40 | 2-propanol | 12 | 11.94 | 20.3 | 1.68 | ◎ | ◎ | ◎ | △ | Flame-retardancy |

Note *1: MM;Hexamethyldisiloxane and PFC;Perfluorocarbon ($C_6F_{14}$)

*2: Dielectric constant , *3: Base oil, *4: Oily agent, *5: Extream pressure additives

Unit of Dipole moment : D

Table 14

Table 1 4

| Embodiment | MM/PFC *1 (mixing ratio/weight) | Polar cleaning agent: Kind | Amount (wt%) | δ value | ε *2 at 25℃ | Dipole moment | Dirty substance: Oil *3 | Oil *4 | Oil *5 | Flux | Flammability |
|---|---|---|---|---|---|---|---|---|---|---|---|
| 68 | 60/40 | 3-pentanon | 12 | – | 19.77 | 2.70 | ◎ | ◎ | ◎ | △ | Flame-retardancy |
| 69 | 60/40 | 2-hexanon | 14 | 8.71 | 16.43 | 2.66 | ◎ | ◎ | ◎ | ◎ | Flame-retardancy |
| 70 | 60/40 | Methyl oxide | 14 | – | 15.6 | 2.84 | ◎ | ◎ | ◎ | ◎ | Flame-retardancy |
| 71 | 60/40 | 2-metoxyethanol | 11 | – | 16.93 | 2.04 | ◎ | ◎ | ◎ | △ | Flame-retardancy |
| 72 | 60/40 | Ethylenediamine | 16 | – | 12.6 | 1.90 | ◎ | ◎ | ◎ | ◎ | Flame-retardancy |
| 73 | 70/30 | 1-propanol | 20 | 12.18 | 22.2 | 1.657 | ◎ | ◎ | ◎ | ◎ | 344K |
| 74 | 70/30 | 2-pentanon | 20 | 8.76 | 21.96 | 2.70 | ◎ | ◎ | ◎ | ◎ | 333K |
| 75 | 70/30 | Butyronitrile | 20 | – | 20.3 | 3.57 | ◎ | ◎ | ◎ | ◎ | 346K |
| 76 | 70/30 | Isobutyronitrile | 20 | – | 20.4 | 3.61 | ◎ | ◎ | ◎ | ◎ | 346K |
| 77 | 70/30 | Nitroethane | 18 | – | 28.06 | 3.70 | ◎ | ◎ | ◎ | ◎ | 349K |
| 78 | 70/30 | Propyonitrile | 15 | 10.73 | 29.7 | 3.57 | ◎ | ◎ | ◎ | ◎ | 338K |
| 79 | 70/30 | Nitromethane | 10 | 12.7 | 35.87 | 3.46 | ◎ | ◎ | ○ | △ | 351K |
| 80 | 70/30 | Acetonitrile | 8 | 12.71 | 37.5 | 3.44 | ◎ | ◎ | ○ | △ | 328K |
| 81 | 15/85 | Ethyl acetate | 5 | – | 6.02 | 1.88 | ◎ | ◎ | ○ | × | Incombustibility |
| 82 | 30/70 | Ethanol | 14 | 12.78 | 23.8 | 1.68 | ◎ | ◎ | ◎ | △ | Flame-retardancy |
| 83 | 30/70 | Butylamine | 14 | 8.66 | 4.88 | 1.20 | ◎ | ◎ | ◎ | ○ | Flame-retardancy |
| 84 | 30/70 | Thiophene | 15 | – | 27.05 | 0.52 | ◎ | ◎ | ○ | △ | Flame-retardancy |

Note *1: MM;Hexamethyldisiloxane and PFC;Perfluorocarbon ($C_6F_{14}$)

*2: Dielectric constant , *3: Base oil, *4: Oily agent, *5: Extream pressure additives

Unit of Dipole moment : D

Embodiments 85 - 91 and Comparison Examples 7 - 12

The comb-shaped substrates used in embodiment 35 were prepared as evaluating samples. Operations of cleaning and rinsing the comb-shaped substrates were performed in a condition and a method similar to that of embodiment 35, using cleaning agents of embodiments 85 - 91 shown in table 15 and cleaning agents of comparison examples 7 - 12 shown in table 16, and then, a drying operation was carried out in conditions shown in tables 15 and 16. In examples in which vapor drying was carried out, a cleaning agent having the same composition as that of the cleaning agent used in the cleaning and rinsing processes was used. In comparison examples 11 and 12, cleaning and drying operations were performed, using cleaning agents, rinsing agents, and vapor drying agents shown in table 16.

After the cleaning, rinsing, and drying operations were performed, amounts of residual ions, insulation resistances, and white residues were measured to evaluate the cleaning property of each cleaning agent. The flammability of each vapor drying agent was evaluated, similarly to the first embodiment. The evaluated result is shown in table 17.

As apparent from the evaluated result shown in table 17, the cleaning agent of the present invention is superior to that of the comparison examples 1, 2, and 3 in respect of the amount of residual ions, insulation resistances, and white residues. That is, the amount of residual ion of the former was smaller than that of the latter; the insulation resistance of the former was higher than that of the latter; and the former had no white residue. Apparently, the cleaning agent of the present invention is superior to that of the comparison examples 7 through 12 in its cleaning and drying properties.

Table 15

| Embodiment | Composition of cleaning agent(weight part) | | | | | | Drying method |
|---|---|---|---|---|---|---|---|
| | Fluorocarbon | | siloxane | | Polar solvent | | |
| | Kind | Amount | Kind* | Amount | Kind | Amount | |
| 85 | $C_5H_2F_{10}$ | 60 | MM | 40 | IPA | 10 | Vapor |
| 86 | $C_5H_1F_{11}$ | 95 | MDM | 5 | Ethanol | 10 | Hot air |
| 87 | $C_6F_{14}$<br>$C_5H_2F_{10}$ | 40<br>40 | MM | 20 | Acetone | 10 | Natural air |
| 88 | $C_6F_{14}$ | 30 | MM | 70 | Methanol | 10 | Vacuum |
| 89 | $C_4F_9OCH_3$ | 84 | - | | MEK | 16 | Vapor |
| 90 | $C_4F_9OCH_3$ | 50 | - | - | Acetone | 50 | Vapor |
| 91 | - | - | MM | 50 | Acetone | 50 | Vapor |

*:MM = Hexamethyldisiloxane MDM= Octamethyltrisiloxane

Table 16

| comparison example | cleaning agent | rinsing agent | Drying agent |
|---|---|---|---|
| 7 | Hexamethyldisiloxane / Vapor drying | | |
| 8 | IPA / Vapor drying | | |
| 9 | Perfluorocarbon[$C_8F_{18}$] / Vapor drying | | |
| 10 | CFC113(96) + ethanol(4) / Vapor drying | | |
| 11 | Isoparaffin(90)<br>$D_4$ (5)<br>*1 (5) | $D_4$ (100)* | Perfluorocarbon<br>[$C_8F_{18}$](100) |
| 12 | *2 (100) | Isoparaffin(100) | MM (100) |

Note *1: Diethylene glycol monobutyl ether *2:Propylene glycol monoethyl ether

*: Parenthesized numerical values indicate parts by weight

$D_4$ : Octamethylcyclotetrasiloxane

Table 17

| Embod iment | Ion residual amount (μg NaCl/in$^2$ ) | Insulation resistance value (× $10^{13}$ Ω) | White residue | flammability of vapor cleaning agent | Ozone depletion coeficient |
|---|---|---|---|---|---|
| 85 | 3.2 | 5.8 | 0/20 | Flame-retardancy | 0 |
| 86 | 1.9 | 9.1 | 0/20 | Incombustibility | 0 |
| 87 | 4.2 | 3.0 | 0/20 | Flame-retardancy | 0 |
| 88 | 4.0 | 1.5 | 0/20 | Flame-retardancy | 0 |
| 89 | 1.6 | 7.2 | 0/20 | Flame-retardancy | 0 |
| 90 | 1.5 | 8.8 | 0/20 | 293K | 0 |
| 91 | 3.5 | 2.0 | 0/20 | 277K*1 | 0 |
| ** 7 | 13.0 | 0.08 | 15/20 | 273K*1 | 0 |
| **8 | 4.0 | 0.05 | 10/20 | 284.7K*1 | 0 |
| ** 9 | 19.0 | 0.01 | 20/20 | Incombustibility | 0 |
| ** 10 | 9.8 | 1.0 | 5/20 | Incombustibility | 0.8 |
| ** 11 | 13.9 | 13.9 | 15/20 | Incombustibility<-> | 0 |
| ** 12 | 9.8 | 9.8 | 7/20 | 273K *2 | 0 |

Note
*1: Value measured by tag-closed type flash point measuring point device
*2: flammability of vapor cleaning agent (measured by tag-closed type)
**: Comparision Example

Embodiments 92-106 and Comparison examples 13-16

Three grams of spindle oil was applied to steel plates each having a size of 30mm x 30mm x 1mm(thickness), and the spindle oil-applied steel plates were baked in a heating oven of 423K for 48 hours to prepare test pieces. Operations of cleaning (cleaning by means of ultrasonic wave) an oil and fat which attached to each of the test pieces was performed, using cleaning agents of embodiment 92 - 106 shown in table 18 and the same cleaning agents (comparison examples 13 - 16) as those of comparison examples 7 - 10 so as to measure the amount of the oil and fat which remained on each test piece: The test pieces were immersed in 150ml of carbon tetrachloride, and ultrasonic wave was applied thereto to extract the oil and fat which remained thereon. Based on the extracted liquid, the amount of the oil and fat which remained on each test piece was measured by an oil content meter (OCMA-220; manufactured by Horiba Manufacturing Co., Ltd). The flammability of each cleaning agent was evaluated similarly to embodiment 51. Table 19 shows evaluated results.

As described above, the cleaning agent of the present invention and that used in the third and fourth cleaning methods have dirty component removing power equivalent to that of flon solvents or chlorinated solvents and preferable drying properties. Thus, the cleaning agent can be used in each of the cleaning, rinsing, and drying processes. Using the cleaning agent, the third and fourth cleaning methods are capable of cleaning electronic component parts such as printed circuit boards, component parts mounted thereon, and the like, and metal component parts in place of the cleaning method in which flon solvents or chlorinated solvents are used.

Table 18

| Embodiment | Composition of cleaning agent(weight part) | | | | | | Drying method |
|---|---|---|---|---|---|---|---|
| | Fluorocarbon | | siloxane | | Polar solvent | | |
| | Kind | Amount | Kind* | Amount | Kind | Amount | |
| 92 | $C_6F_{14}$ | 90 | MM | 20 | Acetone | 4 | Vapor |
| 93 | $C_4F_9I$ | 80 | MM | 20 | Ethyl acetate | 5 | Vapor |
| 94 | $C_5H_2F_{10}$ | 80 | MM | 15 | Butyl acetate | 2 | Vapor |
| | | | MDM | 5 | Acetone | 2 | |
| 95 | $CF_3CF_2CHCl_2$ | 10 | MM | 90 | IPA | 5 | Vapor |
| 96 | $C_6F_{14}$ | 90 | MM | 5 | tert-butanol | 5 | Vapor |
| 97 | $C_6F_{14}$ | 90 | MM | 5 | Isopropyl acetate | 5 | Vapor |
| 98 | $C_7F_{16}$ | 85 | MM | 11 | tert-butanol | 12 | Vapor |
| 99 | $C_7F_{16}$ | 89 | MM | 11 | Isopropyl acetate | 11 | Vapor |
| 100 | $C_5F_{11}NO$ | 90 | MM | 5 | tert-butanol | 5 | Vapor |
| 101 | $C_5F_{11}NO$ | 90 | MM | 5 | Isopropyl acetate | 5 | Vapor |
| 102 | $C_4F_9OCH_3$ | 93 | - | - | Methanol | 7 | Vapor |
| 103 | $C_4F_9OCH_3$ | 91 | - | - | Ethanol | 9 | Vapor |
| 104 | $C_4F_9OCH_3$ | 92 | - | - | IPA | 8 | Vapor |
| 105 | $C_4F_9OCH_3$ | 86 | - | - | Trifluoroethanol | 14 | Vapor |
| 106 | $C_8F_{18}$ | 80 | MM | 20 | — | | Vapor |

*MM = Hexamethyldisiloxane

MDM = Octamethyltrisiloxane

Table 19

| Embodiment | Remaining oil content (mg/g) | Flammability | Ozone depletion coeficient |
|---|---|---|---|
| 92 | 0.005 | flame-retardant | 0 |
| 93 | 0.010 | flame-retardant | 0 |
| 94 | 0.007 | flame-retardant | 0 |
| 95 | 0.009 | flame-retardant | 0.025 |
| 96 | 0.011 | Incombustible | 0 |
| 97 | 0.009 | Incombustible | 0 |
| 98 | 0.004 | 298K | 0 |
| 99 | 0.006 | 296K | 0 |
| 100 | 0.014 | Incombustible | 0 |
| 101 | 0.012 | Incombustible | 0 |
| 102 | 0.008 | flame-retardant | 0 |
| 103 | 0.006 | flame-retardant | 0 |
| 104 | 0.006 | flame-retardant | 0 |
| 105 | 0.009 | Incombustible | 0 |
| 106 | 0.098 | flame-retardant | 0 |
| ** 13 | 0.051 | 273K*1 | 0 |
| ** 14 | 0.018 | 284.7K*1 | 0 |
| ** 15 | 0.698 | Incombustible | 0 |
| ** 16 | 0.007 | Incombustible | 0.8 |

Note
*1: Value measured by tag-closed type flash point measuring device
**: Comparision Example

Embodiment 107

The embodiment of the fifth cleaning method and the cleaning agent of the present invention will be described below.

First, hexamethyldisiloxane and perfluorohexane were prepared as the low molecular weight siloxane compound and fluorocarbons, respectively. 30 parts by weight of hexamethyldisiloxane and 70 parts by weight of perfluorohexane were mixed with each other to prepare a mixed cleaning agent.

The flammability of the mixed cleaning agent was evaluated by measuring the flash point thereof in accordance with JIS-K-2265, using the tag-closed type flash point measuring device and the Cleveland open type flash point measuring device. It was confirmed that the mixed cleaning agent was incombustible. That is, the flash points of the mixed cleaning agent could not be measured by the tag-closed type flash point measuring device and the Cleveland open type flash point measuring device.

Then, the mixed cleaning agent and carbon dioxide gas serving as an injection agent were charged into a spray can in such a manner that the mixing ratio between the two components of the mixed cleaning agent was not changed. A stainless test panel to which silicon press oil YF33 (commercial name) manufactured by Toshiba Silicone Co., Ltd. was applied was prepared. The mixed cleaning agent was sprayed over the stainless test panel from the spray can to remove the silicon press oil YF33 therefrom.

The oil content was quantitatively determined (residual oil content after cleaning) by means of the oil content meter (OCMA 220 manufactured by Horiba Manufacturing Co., Ltd.) before and after the cleaning operation was performed.

The appearance of the stainless test panel was visually observed to evaluate the cleaning performance of the cleaning agent. Table 20 shows the result of the quantitative determination of the oil content and the observation of the appearance of the stainless test panel.

Table 20

| | Amount of oil content (μl/piece) | Appearance |
|---|---|---|
| Before cleaning | 200 | x |
| After cleaning | 0.2 | ◎ |

As indicated in table 20, it was confirmed that the sprayed mixed cleaning agent consisting of the low molecular weight siloxane compound and fluorocarbons had a preferable cleaning property. The property of the mixed cleaning agent was evaluated after the spray can containing the mixed cleaning agent was preserved for a long time. It was confirmed that the cleaning property and combustibility (incombustibility) of the mixed cleaning agent were not changed.

Embodiment 108

First, octamethyltrisiloxane and $C_5F_{11}NO$ were prepared as the low molecular weight siloxane compound and fluorocarbons, respectively. Isopropanol was also prepared. 10 parts by weight of octamethyltrisiloxane, 80 parts by weight of $C_5F_{11}NO$, and 10 parts by weight of isopropanol were mixed with other to prepare a mixed cleaning agent.

The flammability of the mixed cleaning agent was evaluated by measuring the flash point thereof in accordance with JIS-K-2265, using the tag-closed type flash point measuring device and the Cleveland open type flash point measuring device. It was confirmed that the mixed cleaning agent was incombustible. That is, the flash points of the mixed cleaning agent could not be measured by the tag-closed type flash point measuring device and the Cleveland open type flash point measuring device.

Then, the mixed cleaning agent and $N_2$ gas serving as an injection agent were charged into a spray can in such a manner that the mixing ratio between the two components of the mixed cleaning agent was not changed. A copper test panel to which isostearic acid which is an oil agent was applied was prepared. The mixed cleaning agent was sprayed over the copper test panel from the spray can to remove the isostearic acid therefrom.

The oil content was quantitatively determined (residual oil content after cleaning) by means of the oil content meter OCMA 220 manufactured by Horiba Manufacturing Co., Ltd. before and after the cleaning operation was performed. The appearance of the copper test panel was visually observed to evaluate the cleaning performance of the cleaning agent. Table 21 shows the result of the quantitative determination of the oil content and the observation of the appearance of the stainless test panel.

Table 21

| | Amount of oil content (μl/piece) | Appearance |
|---|---|---|
| Before cleaning | 300 | x |
| After cleaning | 0.2 | ◎ |

As indicated in table 21, it was confirmed that the sprayed mixed cleaning agent consisting of the low molecular weight siloxane compound, fluorocarbons, and isopropanol had a preferable cleaning property. The property of the mixed cleaning agent was evaluated after the spray can containing the mixed cleaning agent was preserved for a long time. It was confirmed that the cleaning property and combustibility (incombustibility) of the mixed cleaning agent were not changed.

As described above, in the fifth cleaning method, because the closed container stores the incombustible or flame-retardant mixed cleaning agent containing the low molecular weight siloxane compound and the fluorocarbons mixed therewith, the mixed cleaning agent can be prevented from deteriorating in its incombustibility or flame-retardancy. Thus, the mixed cleaning agent can be used safely and effectively for a long time.

Embodiment 109 and Comparison examples 17 and 18

The embodiment of the sixth cleaning method and the cleaning agent of the present invention will be described below.

A glass lens polished and washed in water was immersed in trifluoroethanol, and pure water which attached thereto was removed therefrom. Then, the trifluoroethanol was dried by lifting the glass lens from the trifluoroethanol at a speed of 5mm/min. After dewatering drying operation was performed, the water removing percentage was determined in accordance with a method described below, and the state (surface state and whether stain was present thereon) of the glass lens was observed visually and by a scanning type electronic microscope after it was dried. Table 22 shows evaluated results.

Then, the lens dewatered with the trifluoroethanol and dried was immersed in dehydrated ethanol to dissolve water remaining therein. The amount (Ag) of the remaining water was quantitatively determined by Carl Fisher method. The amount (Bg) of water of another lens not dewatered with the trifluoroethanol and not dried was also quantitatively determined. The water removing percentage was determined, based on the following equation:

$$\text{Water removing percentage (\%)} = \{(B - A)/B\} \times 100$$

In comparison example 17, a dewatering drying operation was conducted on the same object (glass lens) as that of embodiment 109. The glass lens was dewatered with an CFC113/surface-active agent (nonion surface-active agent 0.5 parts by weight) and taken out therefrom to dry it. In comparison example 18, similarly to comparison example 17, dewatering drying operations were performed with IPA. Thereafter, similarly to embodiment 109, the water removing percentage was determined, and the appearance of each glass lens was observed visually after the drying operation terminated. Table 22 shows evaluated results.

Table 22

| | | Embodiment 109 | Comparison example 17 | Comparison example 18 |
|---|---|---|---|---|
| Dewatering drying liquid | | Trifluoro-ethanol | CFC113/surface -active agent | IPA |
| Dewatering rate | | 100% | 100% | 100% |
| Appearance | | | | |
| | Visual observation | o | o | o |
| | SEM observation | o | △ Surface-active agent remained | o |

Embodiment 110 and Comparison Examples 19 and 20

The sixth cleaning method and the fifth cleaning apparatus will be described below.

A dewatering drying apparatus having a construction shown in Fig. 1 according to an embodiment was prepared. The dewatering drying apparatus comprises a section for carrying out a water-washing process (A) having two water-washing tanks 101 and 101; and a section for carrying out a drying process (B) and having a drying tank 104 in which dewatering drying liquid (trifluoroethanol) 102 is heated by a heater 103 to generate vapor 102a. The dewatering drying liquid 102 in the drying tank 104 is fed to a distiller 105 every one hour to remove water by a distilling operation. Then, the recovered dewatering drying liquid 102 is fed to the drying tank 104 in which it is utilized as the vapor 102a. In the dewatering drying apparatus shown in Fig. 1, water replacement and drying are carried out by means of the vapor 102a of the dewatering drying liquid 102 Consisting of trifluoroethanol.

Using the dewatering drying apparatus shown in Fig. 1, an operation of water-washing chrome-plated glass filters

(10 pieces/basket) 106 and a dewatering drying operation (B) were conducted 100 times consecutively to calculate the water removing percentage of the dewatering drying liquid 102 and examine the appearances of the glass filters, similarly to embodiment 109 after the water washing and dewatering drying operations were carried out 100 times. Table 23 shows evaluated results.

In comparison example 19, using the dewatering drying apparatus shown in Fig. 1, water-washing and dewatering drying of the same chrome-plated glass filters as those of embodiment 110 were carried out 100 times consecutively, except that a mixture liquid of perfluorohexane and trifluoroethanol was used as the dewatering drying liquid. In comparison example 20, water-washing and dewatering drying of the same chrome-plated glass filters as those of embodiment 110 were performed 100 times consecutively, except that IPA was used as the dewatering drying liquid. Similarly to embodiment 109, the water removing percentage of each dewatering drying liquid was calculated and the appearances of the glass filters were visually observed after the water-washing and dewatering drying operations were carried out 100 times. Table 23 shows evaluated results.

Table 23

| | | Embodiment 110 | Comparison example 19 | Comparison example 20 |
|---|---|---|---|---|
| Dewatering drying liquid | | Trifluoro-ethanol | * | IPA |
| Dewatering rate | | 100% | 96% | 100% |
| Appearance | | | | |
| | Visual observation | o | x | o |
| | SEM observation | o | x | stain on dried object |

Note * : Perfluorohexane + Trifluoroethanol

Table 23 indicates that in embodiment 110 in which trifluoroethanol was used as the dewatering drying liquid, trifluoroethanol removed water from the glass filters at a high percentage and was dried favorably after the operation of water-washing and dewatering drying operations were carried out 100 times, whereas in comparison example 19 in which the mixture of perfluorohexane and trifluoroethanol was used as the dewatering drying liquid, the mixture removed water from the glass filters at a lower percentage and was dried in a lower degree. In comparison example 20 in which IPA was used as the dewatering drying liquid, its drying performance was poor because stains were left on the glass filters. This is because water was not removed from IPA but water accumulated therein and IPA had a high heat of vaporization.

Embodiments 111 - 114 and Comparison Examples 21 and 22

A dewatering drying apparatus having a construction shown in Fig. 2 according to an embodiment of the present invention was prepared. The dewatering drying apparatus comprises a section for carrying out a water-washing process (A) having two water-washing tanks 201 and 201; and a section for carrying out a dewatering drying process (C) having two dipping dewatering tanks 207 and 207 each accommodating a dewatering drying liquid 202 consisting of trifluoroethanol to dewater (water replacement) an object 206 by immersing it in the dewatering drying liquid 202; and a section for carrying out a vapor drying process (D) having a vapor drying tank 208 in which the dewatering drying liquid 202 consisting of trifluoroethanol is heated by a heater 203 to generate vapor 202a. The dewatering drying liquid 202 in the dipping dewatering tank 207 and that in the vapor drying tank 208 are continuously fed to a distiller 205 to remove water of the dewatering drying liquid 202 by a distilling operation. Then, the recovered dewatering drying liquid 202 is fed to the vapor drying tank 208 in which it is utilized as the vapor 202a.

Using the dewatering drying apparatus shown in Fig. 2, an operation of water-washing (A) polished polygon mirrors (30 pieces/basket), a dewatering (C) operation, and a vapor-drying (D) operation were carried out 300 times consecutively. The dewatering drying liquid was dried for five minutes. Similarly to embodiment 109, the water removing percentage of the dewatering drying liquid 202 was calculated, and the appearance of each water-removed/dried polygon mirror was visually examined. In embodiment 112, as the dewatering (C) liquid, fluoroethanol was used, and as the vapor-drying (D) liquid, hydrofluoroether was used. In embodiment 113, as the dewatering liquid, a mixture of fluoroethanol and hydrofluoroether was used, and as the vapor-drying liquid, hydrofluoroether was used. In embodiment 114, as the dewatering liquid 202, fluoroethanol was used, and as the vapor-drying liquid, hexamethyldisiloxane was used. In each of embodiments 112, 113, and 114, a dewatering drying operation was carried out similarly to embodiment 109. Table 24 shows evaluated results.

In comparison examples 21, except that CFC113/surface-active agent (0.5 parts by weight of nonionic surface-active agent) was used as both the dewatering liquid and the vapor-drying liquid, using the dewatering drying apparatus shown in Fig. 2, operations of water-washing the same polished polygon mirrors as those of embodiment 111, dewatering them, and drying the dewatering liquid by means of the vapor 202a were carried out 300 times consecutively. In comparison example 22, operations of water-washing the same polished polygon mirrors as those of embodiment 111, dewatering them, and drying the dewatering liquid by means of the vapor 202a were carried out 300 times consecutively, except that IPA was used as the dewatering drying liquid. As in the case of embodiment 111, the water removing percentage of each dewatering liquid was calculated, and the appearance of each dried polygon mirror was visually examined. Table 24 shows evaluated results.

Table 24

| | Embodiment 111 | Comparison example 21 | Comparison example 22 |
|---|---|---|---|
| Dewatering drying liquid | TFEA | CFC113/surface-active agent | IPA |
| Dewatering rate | 100% | 100% | 100% |
| Appearance Visual observation | 0 | 0 | △ |
| SEM observation | 0 | △ Surface-active agent remained | △ stain on dried object |

| | Embodiment 112 | Embodiment 113 | Embodiment 114 |
|---|---|---|---|
| Dewatering drying liquid | TFEA → HFE | TFEA/HFE → HFE | TFEA → MM |
| Dewatering rate | 100% | 100% | 100% |
| Appearance Visual observation | 0 | 0 | 0 |
| SEM observation | 0 | 0 | 0 |

Note TFEA:Trifluoroethanol, HFE :Hydrofluoroether
MM :hexamethyldisiloxane

Table 24 indicates that in embodiment 111 in which trifluoroethanol was used as the dewatering drying liquid, the glass filters were dewatered at a high percentage and dried favorably after the dewatering and drying operations were carried out 300 times, whereas in comparison example 22 in which IPA was used as the dewatering drying liquid, IPA was dried in a lower degree because stains were left on the glass filters.

Hexamethyldisiloxane was used as the vapor-drying liquid (D) in embodiment 114. In this case, hexamethyldisiloxane and trifluoroethanol are completely compatible with each other at a temperature proximate to and higher than the boiling point of the former, whereas they are separated from each other at the normal room temperature. Therefore, the dewatering drying liquid 202 in the vapor drying tank 208 may be cooled in a different tank to separate trifluoroethanol from hexamethyldisiloxane by means of gravity concentration. The distiller 205 is used as necessary to dewater the collected trifluoroethanol and recycle the dewatered trifluoroethanol. Hexamethyldisiloxane collected at this time is used as it is or purified by the distiller 205 as necessary. A filter may be used to separate hexamethyldisiloxane and trifluoroethanol from each other, but distillation is more favorable than filter and gravity concentration for the separation. Thus, it is possible to recycle the dewatering drying liquid consisting of trifluoroethanol accommodated in the dipping dewatering tank 207 by dewatering the polygon mirrors by the distiller 205; recycle the dewatering drying liquid consisting of hexamethyldisiloxane accommodated in the vapor drying tank 208 after it is separated from trifluoroethanol by gravity concentration in the vapor drying tank 208 or a different tank; and feed trifluoroethanol to the dipping dewatering tank 207 or the distiller 205.

As described above, because the dewatering drying method of the sixth cleaning method and the dewatering drying apparatus for carrying out the method provide a preferable dewatering drying property and allow water to be separated from the dewatering liquid by a distillation operation or the like. That is, objects can be preferably dewatered without stains being left thereon and the dewatering drying liquid can be dried favorably at a low cost. In this manner, the dewatering drying method of the sixth cleaning method and the dewatering drying apparatus dewater the objects as fast as the method in which flon solvents or chlorinated solvents is used and dry the dewatering drying liquid as finely as the method in which flon solvents or chlorinated solvents is used.

Embodiment 115 and Comparison Examples 23 through 27

A cleaning agent containing the azeotropic composition or the pseudo-azeotropic composition of the present invention as its effective component and its cleaning property will be described below.

First, hexamethyldisiloxane TSF451-0.65 (commercial name) (purity: not less than 99%) manufactured by Toshiba Silicone Co., Ltd., tert-butanol, and perfluorocarbon PF-5060 (commercial name) (manufactured by Sumitomo 3M Co., Ltd.) expressed by $C_6F_{14}$ were put in a distillation flask at a volume ratio of 1:1:1. The mixture was distilled at the normal pressure by using a fractionating tower, the number of theoretical stages of which was 30. As a result of the distillation, azeotropic fractions were obtained at 321 - 326K. The composition consisting of the azeotropic fractions was used as the cleaning agent.

The azeotropic fractions were analyzed by means of gas chromatography to determine the actual mixing ratio, based on an obtained peak area ratio. The result was that the weight percentage of hexamethyldisiloxane was 5.7; tert-butanol was 5.0; and perfluorocarbon ($C_6F_{14}$) was 89.3. The azeotropic fractions were analyzed by gas chromatography in the following conditions:

Gas chromatography condition:

An apparatus (GD-14A(TC-D)) used was manufactured by Shimazu Manufacturing Co., Ltd.; column: 2m x 3mmϕ (manufactured by GL Science chromosorb Corp. WAWDMCS; mesh: 60/80); filler: Silicone SE-30 10%; injection temperature: 523K; TC-D temperature: 523K; initial temperature: 323K; initial holding time: 0 min; temperature rise speed: 10K/min; final temperature: 523K; final holding time: 0 min; electric current: 100mA; FR CR He: 40ml; and attenuation: 64.

The method of measuring the mixing ratio between the components of the mixture, based on the peak area ratio obtained by means of gas chromatography will be described in detail below.

When the composition was an azeotropic mixture consisting of hexamethyldisiloxane, tert-butanol, and perfluorocarbon expressed by $C_6F_{14}$, n-hexane was selected as a reference substance in the gas chromatography analysis. 10.333g of a liquid mixture of the three components and 2.0704g of n-hexane were analyzed by gas chromatography. As a result, the peak area ratio of each component was as shown below:

| | |
|---|---|
| hexamethyldisiloxane: | 7.635% |
| tert-butanol: | 7.795% |
| perfluorocarbon: | 49.848% |
| n-hexane: | 34.322% |

Amending the obtained peak area ratio to 100%, the following result was obtained.

| | |
|---|---|
| hexamethyldisiloxane: | 7.67% |
| tert-butanol: | 7.83% |
| perfluorocarbon: | 50.04% |
| n-hexane: | 34.46% |

Gas chromatography analysis was made by changing the mixing ratio between each component of the 3-component liquid mixture and that of n-hexane to examine the relationship (calibration curve) between the mixing ratio (wt%) and GC peak area (%). Fig. 3 shows the calibration curve of each component. The calibration curve of acetate isopropyl in Fig. 3 relates to embodiment 116.

When the mixing ratio between hexamethyldisiloxane and n-hexane is changed, the peak area (%) ratio therebetween is as follows: hexamethyldisiloxane : n-hexane = 7.67 : 34.46. Therefore, the peak area (%) of n-hexane of the two-component mixture is as follows:

$$(34.46/(34.46 + 7.67)) \times 100 = 81.48\%$$

Introducing the above value into the calibration curve of hexamethyldisiloxane shown in Fig. 3, the actual mixing percentage thereof is 78.0wt%. Thus, the amount x(g) of hexamethyldisiloxane is as follows:

$$2.0704/(2.0704 + x) \times 100 = 78.0$$

From the above, x = 0.5839g. Thus, the mixing wt% of hexamethyldisiloxane is as follows:

$$(0.5839/10.333) \times 100 = 5.7 \text{ wt\%}$$

Determining the mixing wt% of tert-butanol and that of perfluorocarbon in a similar method, the mixing wt% of tert-butanol and that of perfluorocarbon are 5.0 and 89.3, respectively.

The mixing ratio between components of each mixed composition described in the present specification is determined based on the peak area of each component obtained by gas chromatography which analyzes the azeotropic fraction of each component.

Using the cleaning agent thus obtained, metal component parts 20 pieces (envelope parts) made of copper immersed in work oil G-6040 (commercial name) manufactured by Nippon Kosakuyu Co., Ltd. were cleaned in the following procedure, and cleaned states were evaluated. That is, first, the metal component parts were cleaned at about 303K in a first cleaning tank accommodating the above-described cleaning agent by irradiating respective metal component parts with ultrasonic wave. Then, respective metal component parts were cleaned again and rinsed at the normal room temperature in a second cleaning tank accommodating a cleaning agent having the same composition by irradiating respective metal component parts with ultrasonic wave. Finally, a cleaning agent containing the same composition accommodated in a third cleaning tank was heated to boil it. The respective metal component parts were subjected to vapor of the cleaning agent to dry them.

In the above-described process, the appearances of the cleaned metal component parts were observed visually and by a microscope, and a residual oil content was extracted from randomly selected two metal component parts cleaned, rinsed, and dried, by means of 300ml of carbon tetrachloride, and the amounts thereof were quantitatively determined by the oil content meter OCMA-220 manufactured by Horiba Manufacturing Co., Ltd. In addition, one clean metal component parts was immersed in a cleaning agent having a temperature of 313K and air-dried after it was taken out therefrom to measure a time period required for the metal component parts to dry completely. In addition, the flash point of the cleaning agent was measured by the Cleveland open type flash point measuring device. Table 25 shows measured results and ozone depletion coefficient.

As comparison examples, a cleaning agent consisting of tert-butanol (comparison example 23), a cleaning agent consisting of hexamethyldisiloxane TSF451-0.65 (comparison example 24), a cleaning agent consisting of perfluorocarbon PF-5060 (comparison example 25), a cleaning agent consisting of 1,1,1-trichloroethane (comparison example 26) were used to clean the metal component parts in a manner similar to that of embodiment 115. The cleaning properties of the cleaning agents were evaluated, and drying time periods and the flash points thereof were measured. Further, the amount of an oil content which remained on uncleaned metal component parts was measured (comparison example 27.) Table 25 shows test results and evaluations thereof.

Table 25

| Agent / Evaluation Item | Embodiment | Comparision Example | | | | |
|---|---|---|---|---|---|---|
| | 115 | 23 | 24 | 25 | 26 | 27 |
| | t-Butanol MM PFC | t-Butanol | MM | PFC | 1, 1, 1-Trichroloethane | Un-cleaned |
| Appearence after cleaning *1 | ○ | △ | △ | × | ○ | – |
| Remainig oil content (mg/g) | 0.006 | 0.007 | 0.010 | 0.687 | 0.004 | 0.989 |
| Drying time (sec) | 20 | 313 | 30 | 10 | 25 | – |
| Flash point(K) *2 | 287.99 | 281.9 | 273 | Incombustible | | – |
| ODP | 0 | 0 | 0 | 0 | 0.1 | – |

Note *1 : Evaluation standard

○=Residue was not present by visual and microscopic observation

△=Residue was present by microscopic observation

×=Residue was present by visual and microscopic observation

*2 : Measured by Cleveland open type flash point measuring device

MM : Hexamethyldisiloxane

PFC:Perfluorocarbon

As apparent from the test results shown in table 25, the cleaning agent of embodiment 115 is superior in its cleaning power (degreasing power), and its drying property is more favorable than that of 1,1,1-trichloroethane. Further, the cleaning agent of embodiment 115 has a flash point higher than that of tert-butanol and that of hexamethyldisiloxane. It was confirmed that the cleaning agent of embodiment 115 was allowed to be flame-retardant.

Embodiment 116 and Comparison Example 28

First, hexamethyldisiloxane TSF451-0.65 (commercial name) (purity: not less than 99%) manufactured by Toshiba Silicone Co., Ltd., isopropyl acetate, and perfluorocarbon PF-5060 (commercial name) (manufactured by Sumitomo 3M Co., Ltd.) expressed by $C_6F_{14}$ were put in a distillation flask at a volume ratio of 1:1:1. The mixture was distilled at the normal pressure by using a fractionating tower, the number of theoretical stages of which was 30. As a result of the distillation, azeotropic fractions were obtained at 323 - 328K. The composition consisting of the azeotropic fractions was used as the cleaning agent.

The azeotropic fractions were analyzed by means of gas chromatography to determine the actual mixing ratio, based on an obtained peak area ratio. The result was that the weight percentage of hexamethyldisiloxane was 4.9; isopropyl acetate was 5.3; and perfluorocarbon ($C_6F_{14}$) was 89.8. The gas chromatography analysis was carried out in the same conditions as those described previously.

Using the cleaning agent thus obtained, metal component parts 20 pieces (envelope parts) made of copper immersed in work oil G-6040 (commercial name) manufactured by Nippon Kosakuyu Co., Ltd. were cleaned in the same procedure as that of embodiment 115. The appearances of the cleaned (rinsed and dried) metal component parts were observed visually and by a microscope, and residual oil contents were measured in the same condition as that of embodiment 115. Similarly to embodiment 115, a time period required for the metal component parts to dry completely and the flash point of the cleaning agent was measured by the Cleveland open type flash point measuring device. Table 26 shows measured results and ozone depletion coefficient.

As a comparison example, a cleaning agent consisting of isopropyl acetate (comparison example 28) was used to clean the metal component parts in a manner similar to that of embodiment 115. The cleaning property of the cleaning agent was evaluated, and a drying time period and the flash point thereof were measured. Table 26 shows the measured result and the evaluation thereof. Table 26 also shows the test results of comparison examples 24 through 27.

Table 26

| Agent / Evaluation Item | Embodiment | Comparision Example | | | | |
|---|---|---|---|---|---|---|
| | 116 | 28 | 24 | 25 | 26 | 27 |
| Agent | Isopropyl-acetate, MM, PFC | Isopropyleacetate | MM | PFC | 1,1,1-Trichroloethane | Un-cleaned |
| Appearence after cleaning *1 | ○ | ○ | △ | × | ○ | − |
| Remainig oil content (mg/g) | 0.004 | 0.002 | 0.010 | 0.687 | 0.004 | 0.989 |
| Drying time (sec) | 14 | 207 | 30 | 10 | 25 | − |
| Flash point(K) *2 | 301 | 289 | 273 | Incombustible | | − |
| ODP | 0 | 0 | 0 | 0 | 0.1 | − |

As apparent from the test results shown in table 26, the cleaning agent of embodiment 116 is superior in its cleaning power (degreasing power), and its drying property is more favorable than that of 1,1,1-trichloroethane. Further, the cleaning agent of embodiment 116 has a flash point higher than that of isopropyl acetate and that of hexamethyldisiloxane. It was confirmed that the cleaning agent of embodiment 116 was allowed to be flame-retardant.

As described above, the azeotropic and pseudo-azeotropic compositions of the present invention do not destroy the ozone layer and are more favorable than those of comparison examples in their cleaning and drying properties.

Embodiment 117

Except that instead of perfluorocarbon FP-5060 of embodiment 115, perfluorocarbon PF-5070 (manufactured by Sumitomo 3M Co., Ltd.) expressed by $C_7F_{16}$ was used, a cleaning agent of embodiment 117 had the same components and the same mixing ratio as those of the cleaning agent of embodiment 115. The mixture of the three components was distilled in the same condition and method as those of embodiment 115. As a result of the distillation, azeotropic fractions were obtained at 337 - 344K. The composition consisting of the azeotropic fractions was used as the cleaning

agent.

The mixing ratio between the three components was determined in the same condition and method as those of embodiment 115. The result was that the weight percentage of hexamethyldisiloxane was 10.6; tert-butanol was 11.8; and perfluorocarbon expressed by $C_7F_{16}$ was 77.6. The method of measuring the mixing ratio between the three components of the mixture, based on a peak area ratio obtained by means of gas chromatography will be described in detail below.

When the composition was an azeotropic mixture consisting of hexamethyldisiloxane, tert-butanol, and perfluorocarbon expressed by $C_7F_{16}$, n-hexane was selected as a reference substance in the gas chromatography analysis. 10.0084g of a mixture liquid of the three components and 2.0074g of n-hexane were analyzed by gas chromatography. As a result, the peak area ratio of each component was as shown below:

| | |
|---|---|
| hexamethyldisiloxane: | 12.408% |
| tert-butanol: | 15.795% |
| perfluorocarbon: | 41.628% |
| n-hexane: | 30.101% |

Amending the obtained peak area ratio to 100%, the following result was obtained.

| | |
|---|---|
| hexamethyldisiloxane: | 12.42% |
| tert-butanol: | 15.81% |
| perfluorocarbon: | 41.66% |
| n-hexane: | 30.12% |

Using the calibration curve shown in Fig. 3, the mixing ratio between the three components were determined in the same method as that of embodiment 115. As a result, the above result was obtained.

Using the cleaning agent thus obtained, cleaning, rinsing, and drying operations were performed in the same condition and method as those of embodiment 115. Table 27 shows measured results and ozone depletion coefficient. Table 27 also shows the results of comparison examples 23 through 27.

Table 27

| Evaluation Item \ Agent | Embodiment 117 | Comparision Example 23 | 24 | 25 | 26 | 27 |
|---|---|---|---|---|---|---|
| | t-Butanol MM PFC | t-Butanol | MM | PFC | 1,1,1-Trichroloethane | Un-cleaned |
| Appearence after cleaning *1 | ○ | ○ | △ | × | ○ | − |
| Remainig oil content (mg/g) | 0.006 | 0.007 | 0.010 | 0.687 | 0.004 | 0.989 |
| Drying time (sec) | 22 | 313 | 30 | 10 | 25 | − |
| Flash point(K) *2 | 291.9 | 281.9 | 273 | Incombustible | | − |
| ODP | 0 | 0 | 0 | 0 | 0.1 | − |

Note *1 : Evaluation standard

○=Residue was not present by visual and microscopic observation

△=Residue was present by microscopic observation

×=Residue was present by visual and microscopic observation

*2 : Measured by Cleveland open type flash point measuring device

MM : Hexamethyldisiloxane

PFC:Perfluorocarbon

As apparent from the test results shown in table 27, the cleaning agent of embodiment 117 is superior in its cleaning power (degreasing power), and its drying property is more favorable than that of 1,1,1-trichloroethane. Further, the cleaning agent of embodiment 117 has a flash point higher than that of tert-butanol and that of hexamethyldisiloxane. It was confirmed that the cleaning agent of embodiment 117 was allowed to be flame-retardant.

Embodiment 118

First, hexamethyldisiloxane TSF451-0.65 (commercial name) (purity: not less than 99%) manufactured by Toshiba Silicone Co., Ltd., isopropyl acetate, and perfluorocarbon PF-5060 (commercial name) (manufactured by Sumitomo 3M Co., Ltd.) expressed by $C_7F_{16}$ were put in a distillation flask at a volume ratio of 1:1:1, and the mixture was distilled at the normal pressure by using a fractionating tower, the number of theoretical stages of which was 30. As a result of the distillation, azeotropic fractions were obtained at 337 - 345K. The composition consisting of the azeotropic fractions was used as the cleaning agent.

The azeotropic fractions were analyzed by means of gas chromatography to determine the actual mixing ratio, based on obtained peak area ratios. The result was that the weight percentage of hexamethyldisiloxane was 10.5; isopropyl acetate was 10.7; and perfluorocarbon $C_7F_{16}$ was 78.8. The gas chromatography analysis was carried out in the same condition as that described previously.

Using the cleaning agent thus obtained, metal component parts 20 pieces (envelope parts) made of copper immersed in work oil G-6040 (commercial name) manufactured by Nippon Kosakuyu Co., Ltd. were cleaned (rinsed and dried) in the same procedure as that of embodiment 115. The appearances of the cleaned (rinsed and dried) metal component parts were observed visually and by a microscope, and residual oil contents were measured in the same condition as that of embodiment 115. Similarly to embodiment 115, time periods required for the metal component parts to dry completely and the flash point of the cleaning agent were measured by the Cleveland open type flash point measuring device. Table 28 shows measured results and ozone depletion coefficient.

Table 28 also shows the results of comparison examples 24 through 28.

Table 28

| Evaluation Item \ Agent | Embodiment | Comparision Example | | | | |
|---|---|---|---|---|---|---|
| | 118 | 28 | 24 | 25 | 26 | 27 |
| | Isopropyl-acetate , MM, PFC | Isopropyleacetate | MM | PFC | 1,1,1-Trichroloethane | Un-cleaned |
| Appearence after cleaning *1 | ○ | ○ | △ | × | ○ | − |
| Remainig oil content (mg/g) | 0.004 | 0.002 | 0.010 | 0.687 | 0.004 | 0.989 |
| Drying time (sec) | 21 | 207 | 30 | 10 | 25 | − |
| Flash point(K) *2 | 292.7 | 289 | 273 | Incombustible | | − |
| ODP | 0 | 0 | 0 | 0 | 0.1 | − |

As apparent from the test results shown in table 28, the cleaning agent of embodiment 118 is superior in its cleaning power (degreasing power), and its drying property is more favorable than that of 1,1,1-trichloroethane. Further, the cleaning agent of embodiment 118 has a flash point higher than that of isopropyl acetate and that of hexamethyldisiloxane. It was confirmed that the cleaning agent of embodiment 118 was allowed to be flame-retardant.

As described above, the azeotropic and pseudo-azeotropic compositions of the present invention do not destroy the ozone layer and are more favorable than those of the comparison examples in their cleaning and drying properties.

Embodiment 119 and Comparison Examples 29 - 33

Except that instead of perfluorocarbon FP-5060 of embodiment 115, perfluoromorpholine (commercial name: PF-5052, manufactured by Sumitomo 3M Co., Ltd.) was used, a cleaning agent of embodiment 119 had the same components and the same mixing ratio as those of the cleaning agent of embodiment 115. The mixture of the three components was distilled in the same condition and method as those of embodiment 115. As a result of the distillation, azeotropic fractions were obtained at 313 - 322K. The composition consisting of the azeotropic fractions was used as the cleaning agent.

The mixing ratio between the three components was determined in the same condition and method as those of

embodiment 115. The result was that the weight percentage of hexamethyldisiloxane was 5.4; tert-butanol was 5.2; and perfluoromorpholine was 89.4.

Spindle oil was applied to steel plates, and the spindle oil-applied steel plates were baked in a heating oven at 150°C for 48 hours to prepare test pieces. Operations of cleaning (cleaning by means of ultrasonic wave) an oil and fat which attached to each of the test pieces was performed, using the cleaning agent to evaluate cleaned states. The cleaning operation was performed as follows: First, the test pieces were cleaned at about 30°C in the first cleaning tank accommodating the cleaning agent, by irradiating respective test pieces with ultrasonic wave. Then, respective test pieces were cleaned again and rinsed at the normal room temperature in the second cleaning tank accommodating a cleaning agent containing the same composition, by irradiating respective test pieces with ultrasonic wave. Finally, a cleaning agent containing the same composition accommodated in the third cleaning tank was heated to boil it. The respective test pieces were subjected to vapor of the cleaning agent to dry them. The appearances of the cleaned (rinsed and dried) test pieces were observed visually and by a microscope, and residual oil contents were measured as follows: That is, the cleaned (rinsed and dried) test pieces were immersed in 300ml of carbon tetrachloride, and the residual oil contents were extracted therefrom by means of 300ml of carbon tetrachloride. Then, the residual oil contents were quantitatively determined by the oil content meter OCMA-220 manufactured by Horiba Manufacturing Co., Ltd. As comparison examples 29 - 33, using a cleaning agent consisting of each of the three components, cleaning and drying operations were performed in a similar procedure. In addition, the flash point of each cleaning agent was measured by the Cleveland open type flash point measuring device. Table 29 shows test results of the measurements.

Table 29 indicates that the cleaning agent of embodiment 119 allows the cleaned (rinsed and dried) test pieces to have no residue on their surfaces, dried favorably, had a very small amount of oil content left thereon; the cleaning agent was incombustible; and did not destroy the ozone layer.

Table 29

| Evaluation Item \ Agent | Embodiment 119 | Comparision Example 29 | 30 | 31 | 32 | 33 |
|---|---|---|---|---|---|---|
| | t-Butanol MM PFM | MM | tert-Butanol | PFM | 1,1,1-Trichroloethane | Un-cleaned |
| Appearence after cleaning *1 | ○ | △ | △ | × | ○ | − |
| Drying property *2 | ○ | ○ | × | ○ | ○ | − |
| Remainig oil content (mg/cm$^2$) | 0.10 | 1.38 | 0.05 | 3.02 | 0.41 | 3.41 |
| Flash point(K)) *3 | Incombustible | 273 | 281.9 | Incombustible | | − |
| ODP | 0 | 0 | 0 | 0 | 0.1 | − |

Note *1 : Evaluation standard

○=Residue was not present by visual and microscopic observation

△=Residue was present by microscopic observation

×=Residue was present by visual and microscopic observation

*2 : Evaluation standard

○=It takes less than one minute for test piece taken out from vapor cleaning tank to dry completely.

×=It takes not less than two minutes for test piece taken out from vapor cleaning tank to dry completely.

*3 : Measured by Cleveland open type flash point measuring device.

MM : Hexamethyldisiloxane

PFM:Perfluoromorpholine

Embodiment 120 and Comparison Example 34

Except that instead of tert-butanol of embodiment 119, isopropyl acetate was used, a cleaning agent of embodiment 120 had the same components and the same mixing ratio as those of the cleaning agent of embodiment 119. The mixture of the three components was distilled in the same condition and method as those of embodiment 119. As a result of the distillation, azeotropic fractions were obtained at 315 - 322K. The composition consisting of the azeotropic fractions was used as the cleaning agent.

The mixing ratio between the three components was determined in the same condition and method as those of embodiment 115. The result was that the weight percentage of hexamethyldisiloxane was 3.7; isopropyl acetate was 4.8; and perfluoromorpholine was 91.5.

Using the cleaning agent thus obtained, the cleaning property was evaluated in the same condition and method as those of embodiment 119. Table 30 shows evaluated results.

Table 30

| Agent / Evaluation Item | Embodiment | Comparision Example | | | | |
|---|---|---|---|---|---|---|
| | 120 | 29 | 34 | 31 | 32 | 33 |
| | Isopropyl-acetate , MM, PFM | MM | Isopropyleacetate | PFM | 1,1,1-Trichroloethane | Un-cleaned |
| Appearence after cleaning *1 | ○ | × | ○ | × | ○ | – |
| Drying property *2 | ○ | ○ | × | ○ | ○ | – |
| Remainig oil content (mg/cm²) | 0.05 | 1.38 | 0.03 | 3.02 | 0.41 | 3.41 |
| Flash point(K)) *3 | Incombustible | 273 | 289 | Incombustible | | – |
| ODP | 0 | 0 | 0 | 0 | 0.1 | – |

Note *1 : Evaluation standard

○=Residue was not present by visual and microscopic observation

△=Residue was present by microscopic observation

×=Residue was present by visual and microscopic observation

*2 : Evaluation standard

○=It takes less than one minute for test piece taken out from vapor cleaning tank to dry completely.

×=It takes not less than two minutes for test piece taken out from vapor cleaning tank to dry completely.

*3 : Measured by Cleveland open type flash point measuring device.

MM : Hexamethyldisiloxane

PFM:Perfluoromorpholine

Table 30 indicates that the cleaning agent of embodiment 120 allows the cleaned (rinsed and dried) test pieces to have no residue on their surfaces, dried favorably, and had a very small amount of oil content left thereon; the cleaning agent was incombustible; and did not destroy the ozone layer.

As described above, the cleaning agent comprising the azeotropic composition of the present invention does not

destroy the ozone layer and is incombustible and superior in its cleaning performance. In addition, the mixing ratio between the components of the cleaning agent hardly change during use when it vaporizes. Further, the cleaning agent dries quickly, thus displaying an excellent effect.

Embodiment 121 and Comparison Examples 35 - 38

First, purity of 99.5% hexamethyldisiloxane determined by gas chromatography and 99.5 % tert-butanol determined thereby were mixed with each other at a weight ratio of 1:1. The mixture was put in a distillation flask and distilled at the normal pressure by using a fractionating tower, the number of theoretical stages of which was 30. As a result of the distillation, azeotropic fractions were obtained at 350 - 355K. The composition consisting of the azeotropic fractions was used as the cleaning agent.

The azeotropic fractions were analyzed by means of gas chromatography to determine the actual mixing ratio, based on obtained peak area ratios. The result was that the weight percentage of hexamethyldisiloxane was 47; and tert-butanol was 53. The gas chromatography analysis was carried out in the same condition as that of embodiment 115.

Tables 31 shows the surface tension (298K) and KB value of the cleaning agent of embodiment 121, hexamethyldisiloxane, and tert-butanol both of which are the starting components thereof.

Table 31

| | Surface tension (dyn/cm) | KB value |
|---|---|---|
| Cleaning agent of embodiment 121 | 18.5 | 62 |
| Hexamethyldisiloxane | 15.9 | 30 |
| tert-Butanol | 20.7 | 140 |

As comparison examples of embodiment 121, a cleaning agent consisting of trichloethane (comparison example 35), a cleaning agent consisting of isopropylalcohol (comparison example 36), a cleaning agent consisting of methanol (comparison example 37), and a cleaning agent consisting of ethanol (comparison example 38) were prepared.

Using the cleaning agent of embodiment 121 and comparison examples 35 - 38, the cleaning and drying properties thereof were evaluated.

[Evaluation 1 of Cleaning]

As objects to be cleaned, glass lenses, polycarbonate (PC) pieces, and aluminum pieces were prepared. Core drawing oil was applied to the glass lenses and the polycarbonate pieces, whereas machining oil was applied to the aluminum pieces. These test pieces were cleaned in a procedure shown below. First, the test pieces were degreased in the first cleaning tank accommodating the cleaning agent of embodiment 121, by irradiating them with ultrasonic wave. Then, they were degreased again in the second cleaning tank accommodating a cleaning agent containing the same composition, by irradiating them with ultrasonic wave. Thereafter, they were rinsed in the third cleaning tank accommodating a cleaning agent containing the same composition, by irradiating them with ultrasonic wave. Then, they were dried by hot air having a temperature lower than 323K. They were also cleaned, rinsed, and dried by a cleaning agent of comparison example 35 and that of comparison example 36 in a similar manner.

In order to evaluate the state of each of test pieces cleaned, rinsed, and dried, the appearance of each test piece was visually observed, and contact angles were measured before dirt was applied thereto and after cleaning, rinsing, and drying operations were carried out as shown in table 32.

Table 32

| Example / Agent / Characteristics / Objects | Embodiment 121 | | Comparison example 35 | | Comparison example 36 | | Before cleaning |
|---|---|---|---|---|---|---|---|
| Agent | Hexamethyldisiloxane tert-Butanol | | Trichloroethane | | Isopropyl alcohol | | |
| Characteristics | Appearance | Contact angle | Appearance | Contact angle | Appearance | Contact angle | Contact angle |
| Glass lens | ○ | 8° | ○ | 9° | × | 9° | 11° |
| P C | ○ | 85° | cracks | 83° | cracks | 85° | 85° |
| Aluminum | ○ | 65° | ○ | 68° | ○ | 69° | 75° |

Note ○ = Preferable in cleaning property , × = Stain was present on object

As indicated in table 32, the cleaning agent of embodiment 121 has a cleaning property superior to that of the cleaning agent consisting of trichloroethane (comparison example 35) and the cleaning agent consisting of isopropyl alcohol (comparison example 36).

[Evaluation 2 of Cleaning]

Spindle oil was applied to steel plates, and the spindle oil-applied steel plates were baked in a heating oven at 423K for 48 hours to prepare test pieces. The test pieces were cleaned in a procedure shown below. First, the test pieces were cleaned at the normal room temperature in the first cleaning tank accommodating the cleaning agent of embodiment 121, by irradiating them with ultrasonic wave. Then, they were rinsed in the second cleaning tank accommodating a cleaning agent containing the same composition, by irradiating them with ultrasonic wave. Finally, a cleaning agent containing the same composition accommodated in the third cleaning tank was heated to boil it to subject each test piece to the vapor of the cleaning agent to dry them. The test pieces were also cleaned, rinsed, and dried by a cleaning agent of comparison example 37 and that of comparison example 38 in a similar manner.

In order to evaluate the state of the test pieces cleaned, rinsed, and dried, the appearance of each of the test pieces was visually observed, and the amount of each residual oil content was measured. The residual oil content was extracted by means of 300ml of carbon tetrachloride and its amount was determined by the oil content meter OCMA-220 manufactured by Horiba Manufacturing Co., Ltd, as shown in Table 33.

Table 33

| | Embodiment121 | Comparison example 37 | Comparison example 38 | Reference (uncleaned) |
|---|---|---|---|---|
| Appearance | ◎ | △ | △ | - |
| Remaining oil content ($mg/cm^2$) | 0.12 | 0.56 | 0.41 | 3.22 |
| Note<br>◎ = Dirt did not remain,<br>△ = Dirt remained | | | | |

[Evaluation 3 of Cleaning]

Ten glass plates each having a dimension of 70mm x 70mm x 1mm(thickness) were put in a reticulate basket and cleaned by a cleaning agent consisting of 5 wt% of sodium laurate, 5 wt% of polyoxyethylene octyl phenylether, and 90 wt% of water. Then, each glass plate was rinsed with pure water. Each rinsed glass plate was dewatered with 1,000ml of the cleaning agent of embodiment 121, comparison example 37, and comparison example 38. Then, each dewatered glass plate was taken out from each cleaning agent and air-dried at the normal room temperature. After 100 glass plates were dewatered with each of the cleaning agents, each cleaning agent was visually observed, and the amount of water dissolved in each cleaning agent was measured, and the appearance of each glass plate was visually observed. The amount of water dissolved in each cleaning agent was measured by the Carl Fisher meter, as shown in Table 34.

Table 34

| | Embodiment 121 | Comparison example 37 | Comparison example 38 |
|---|---|---|---|
| State of cleaning agent | Water was separated and sank | No particular change | No particular change |
| Water content(%) | 0.35 | 2.4 | 2.7 |
| Appearance of glass | Preferable | Stain on edge | Stain on edge |

Table 34 indicates that the cleaning agent of embodiment 121 does not contain much amount of water, which means that the it prevents stains from being generated on the glass plates.

Embodiment 122

First, purity of 99.5% hexamethyldisiloxane and 99.5% (purity) isopropyl acetate both measured by gas chromatography were mixed with each other at 1:1 in weight ratio, and 200g of the mixture was put in a distillation flask to distill it

at the normal pressure by using a fractionating tower having 30 theoretical stages. As a result of the distillation, azeotropic fractions were obtained at 353 - 358K. The composition consisting of the azeotropic fractions thus obtained was used as a cleaning agent.

The azeotropic fractions were analyzed by using gas chromatography to determine the mixing ratio between the two components, based on obtained peak area ratios. The result was that the weight percentage of hexamethyldisiloxane was 43 and that of isopropyl acetate was 57. The gas chromatography was carried out in the same conditions as that described previously.

Tables 35 shows the surface tension (298K) and KB value of the cleaning agent of embodiment 122, hexamethyldisiloxane, and isopropyl acetate, both of which are the starting components thereof.

Table 35

| | Surface tension (dyn/cm) | KB value |
|---|---|---|
| Cleaning agent of embodiment 122 | 18.5 | 72 |
| Hexamethyldisiloxane | 15.9 | 30 |
| Isopropyl acetate | 20.7 | 187 |

The cleaning and drying properties of the cleaning agent of embodiment 122 were evaluated in a manner similar to that of embodiment 121.

[Evaluation 1 of Cleaning]

In the same condition as that of [Evaluation 1 of Cleaning] of embodiment 121, glass lenses, polycarbonate (PC) pieces, and aluminum pieces were cleaned to evaluate the finish state thereof. Table 36 shows the visually observed appearances thereof and the contact angle measured contact angles were measured before dirt was applied thereto and after cleaning, rinsing, and drying operations were carried out. Table 36 also shows test results of cleaning agents of embodiment 122 and comparison examples 35 and 36.

Table 36

| Example / Agent / Characteristics / Objects | Embodiment 121 | | Comparison example 35 | | Comparison example 36 | | Before cleaning |
|---|---|---|---|---|---|---|---|
| Agent | Hexamethyldisiloxane Isopropylacetate | | Trichloroethane | | Isopropyl alcohol | | |
| Characteristics | Appearance | Contact angle | Appearance | Contact angle | Appearance | Contact angle | Contact angle |
| Glass lens | ○ | 7° | ○ | 9° | × | 9° | 11° |
| P C | ○ | 79° | cracks | 83° | cracks | 85° | 85° |
| Aluminum | ○ | 64° | ○ | 68° | ○ | 69° | 75° |

Note ○ = Preferable in cleaning property , × = Stain was present on object

Table 36 indicates that the cleaning agent of embodiment 122 is superior to that of the cleaning agent consisting of trichloroethane (comparison example 35) and the cleaning agent consisting of isopropyl alcohol (comparison example 36).

[Evaluation 2 of Cleaning]

In the same condition as that of [Evaluation 2 of Cleaning] of embodiment 121, a test piece (steel plate to which spindle oil was applied and spindle oil-applied plate was baked) was cleaned , using the cleaning agent of embodiment 122 to evaluate the finish state thereof. Table 37 shows the visually observed appearance of the test piece and the amount of a residual oil content. Table 37 also shows test results of cleaning agents of comparison examples 37 and 38.

Table 37

| | Embodiment122 | Comparison example 37 | Comparison example 38 | Reference (uncleaned) |
|---|---|---|---|---|
| Appearance | ◎ | △ | △ | - |
| Remaining oil content ($mg/cm^2$) | 0.01 | 0.56 | 0.41 | 3.22 |
| Note<br>◎ = Dirt did not remain,<br>△ = Dirt remained | | | | |

[Evaluation 3 of Cleaning]

In the same condition as that of [Evaluation 3 of Cleaning] of embodiment 121, glass plates were cleaned and dewatered, using the cleaning agent of embodiment 122. Table 38 shows the state of the cleaning agent, the measured amount of water contained in each cleaning agent, and the visually observed appearances of the glass plates. Table 38 also shows test results of the cleaning agents of comparison examples 37 and 38.

Table 38

| | Embodiment 122 | Comparison example 37 | Comparison example 38 |
|---|---|---|---|
| State of cleaning agent | Water was separated and sank | No particular change | No particular change |
| Water content(%) | 0.03 | 2.4 | 2.7 |
| Appearance of glass | Preferable | Stain on edge | Stain on edge |

Table 38 indicates that the cleaning agent of embodiment 122 does not contain much amount of water, which means that the generation of stains can be prevented.

As described above, the azeotropic and pseudo-azeotropic compositions of the present invention do not destroy the ozone layer; do not deteriorate plastic; have a fine cleaning property and drying property; prevent the mixing ratio between components thereof while it is used and being recovered by distillation; and prevent water from being mixed therewith. Accordingly, the cleaning agent, of the present invention, consisting of the azeotropic and pseudo-azeotropic compositions does not destroy the ozone layer and can be used without generating stains or rust on objects in degreasing cleaning, dewatering cleaning, and vapor cleaning. Further the cleaning agent can be applied in cleaning, rinsing, and drying processes. Furthermore, the mixing ratio between components of the cleaning agent can he prevented from being changed. Therefore, the cleaning agent can be easily recycled.

Embodiment 123

An embodiment of the first cleaning apparatus of the present invention will be described below with reference to drawings.

Fig. 5 shows the construction of the cleaning apparatus according to an embodiment of the present invention. The cleaning apparatus comprises a section for carrying out a cleaning process (A); a section for carrying out a rinsing process (B); and a section for carrying out a drying process (C). The cleaning apparatus further comprises a distillation recovering mechanism (D); a composition control mechanism (E); a preventive safety mechanism (F); and an extinguishing mechanism (G). The sections corresponding to the processes for handling flammable solvents, namely, the

cleaning process (A), the rinsing process (B), and the drying process (C) are covered with a casing 502 except parts for taking in and out an object 501. Each of the parts for taking in and out the object 501 is provided with a sealing door 503 so that the cleaning process (A), the rinsing process (B), and the drying process (C) can be positioned in the closed part of the cleaning apparatus.

A predetermined amount of a cleaning agent 512 consisting of a solvent of hydrocarbons is accommodated in a cleaning agent tank 511 of the cleaning process (A). The object 501 is immersed in the cleaning agent 512 to remove dirty components which have attached to the object 501. The number of the cleaning agent tank 511 of the cleaning process (A) is set according to the kind of dirt, the amount thereof, a cleaning time period, and a cleaning quality. The tank 511 can be arranged as a single tank or plural tanks. The cleaning apparatus of embodiment 123 has two cleaning agent tanks 511 and 511. The cleaning agent 512 consists of Naphthezol (commercial name) manufactured by Nippon Petrochemistry Co., Ltd. An ultrasonic wave-generating device 513 is installed at the bottom of each of the cleaning agent tanks 511 as necessary.

A rinsing tank 521 of the rinsing process (B) contains a predetermined amount of a rinsing cleaning agent 522 consisting of a mixture of hexamethyldisiloxane used as the low molecular weight siloxane compound and perfluorocarbon PF5060 (commercial name; boiling point: 329K, manufactured by Sumitomo 3M Co., Ltd.) used as inactive fluorocarbons. In embodiment 123, 30 parts by weight of flammable hexamethyldisiloxane and 70 parts by weight of perfluorocarbon PF5060 are mixed with each other to form the rinsing mixed cleaning agent 522. Because the rinsing mixed cleaning agent 522 contains perfluorocarbon PF5060, it is allowed to be incombustible or flame-retardant.

After the object 501 is cleaned in the cleaning agent tanks 511, it is immersed in the rinsing mixed cleaning agent 522 to remove cleaning agent components which have attached to the object 501. The number of the rinsing tanks 521 of the rinsing process (B) is set according to a cleaning time period and a cleaning quality, as in the case of the cleaning process (A). The tank 521 can be arranged as a single tank or plural tanks. The cleaning apparatus of embodiment 123 has two rinsing tanks 521 and 521 connected with each other through an over-flow pipe 524. An ultrasonic wave-generating device 523 is installed at the bottom of each of the cleaning agent tanks 511, as necessary.

A vapor drying agent tank 531 of the drying process (C) accommodates a vapor mixed cleaning agent 532 having the same composition as that of the rinsing mixed cleaning agent 522. A heater 533 heats the vapor mixed cleaning agent 532 so that vapor 532a is generated. The rinsed object 501 is subjected to the vapor 532a of the vapor mixed cleaning agent 532 for a predetermined time period to allow the vapor 532a of the vapor mixed cleaning agent 532 to form dew on the surface of the object 501. In this manner, the rinsing mixed cleaning agent 522 is removed from the object 501. At this time, while the object 501 which has been heated by condensation latent heat is being taken out from the vapor drying agent tank 531, the object 501 is stopped temporarily in a cooling zone of a cooling pipe 534 provided to prevent the vapor 532a from being volatile so as to remove liquid from the surface of the object 501 and dry it. The vapor drying agent tank 531 is provided with an unshown level gage to monitor the amount of the vapor mixed cleaning agent 532 which is reduced due to the volatility of the vapor 532a. When the amount of the vapor mixed cleaning agent 532 becomes smaller than the predetermined amount, an alarm is given.

As described above, the cooling pipe 534 is installed on the upper inner wall surface of each of the rinsing tank 521 and the vapor drying agent tank 531, thus cooling the vapor of the rinsing mixed cleaning agent 522 and that of the vapor mixed cleaning agent 532 so as to liquefy them. In this manner, the vapor is prevented from dispersing to the outside from the rinsing tank 521, the vapor drying agent tank 531, and the cleaning apparatus.

Dirty components and the cleaning agent 512 consisting of the hydrocarbon solvent are fed into the vapor mixed cleaning agent 532 stored in the vapor drying agent tank 531 through the rinsing mixed cleaning agent 522 which has attached to the object 501 during the vapor drying operation. The dirty components, the cleaning agent 512 consisting of the hydrocarbon solvent, and the vapor mixed cleaning agent 532 are fed to a distillation recovering mechanism (D) through an over-flow pipe 541 to prevent the dirty components and the cleaning agent 512 consisting of the hydrocarbon solvent from adversely affecting the generation of the vapor 532a. The cleaning agent 512 consisting of the hydrocarbon solvent which has attached to the object 501 is delivered to the rinsing tank 521, thus polluting the rinsing mixed cleaning agent 522 and accumulating in the rinsing tank 521. Thus, the rinsing mixed cleaning agent 522 in the rinsing tank 521 is fed to the distillation recovering mechanism (D) through an over-flow pipe 542.

The distillation recovering mechanism (D) collects the rinsing mixed cleaning agent 522 contaminated with the dirty components and with the cleaning agent 512 consisting of the hydrocarbon solvent from the rinsing tank 521 and also collects the vapor mixed cleaning agent 532 (same composition as that of rinsing mixed cleaning agent 522) from the vapor drying agent tank 531. A distiller 543 distills the collected rinsing mixed cleaning agent 522 and the vapor mixed cleaning agent 532. The vapor 532a generated by the distiller 543 is fed to the vapor cleaning agent tank 531 through a pipe 544. Residue present in the distiller 543 is discharged to the outside of the cleaning apparatus through a pipe 545.

The vapor mixed cleaning agent 532 purified by being cooled and condensed by the cooling pipe 534 installed on the upper inner wall surface of the vapor drying agent tank 531 circulates to the rinsing tank 521 positioned at the downstream side through a pipe 535. The concentration of the dirty component of the rinsing mixed cleaning agent 522 in the rinsing tank 521 is kept to be constant by introducing, into the rinsing tank 521, the vapor mixed cleaning agent 532

purified by being cooled and condensed. As described above, because the rinsing mixed cleaning agent 522 which has become dirty is fed to the distillation recovering mechanism (D) through the over-flow pipe 542, the amount of the cleaning agent in the rinsing tank 521 is kept to be constant.

The composition control mechanism (E) for keeping the mixing ratio between the components of the rinsing mixed cleaning agent 522 and that between those of the vapor mixed cleaning agent 532 constant comprises a composition change monitoring section, a component adjusting section, and a control section. A fuzzy control method is adopted in the control section as necessary.

The composition change monitoring section serving as a mixing ratio measuring means has temperature sensors 551, 552, 553, and 554 for measuring the boiling point and the condensation point of the vapor mixed cleaning agent 532. The boiling point of the vapor mixed cleaning agent 532 is measured by the temperature sensor 551 installed in the vapor mixed cleaning agent 532 of the vapor drying agent tank 531 or the temperature sensor 552 installed inside the distiller 543. The condensation point of the vapor mixed cleaning agent 532 is measured by the temperature sensor 553 installed at a position, in the vapor drying agent tank 531, to be subjected to the vapor 532a or the temperature sensor 554 installed at a position, in the distiller 543, to be subjected to the vapor. If it is detected that any one of temperatures detected by the temperature sensors 551, 552, 553, and 554 is not at a predetermined temperature, a signal indicating the abnormality is generated to supply the rinsing tank 521 with a shortage amount of perfluorocarbons PF5060 or the hexamethyldisiloxane.

The component adjusting section has a tank 555 for storing fluorocarbons (in embodiment 123, perfluorocarbon PF5060) and a tank 556 for storing a low molecular weight siloxane compound (in embodiment 123, hexamethyldisiloxane). The tank 555 is provided with an automatic on-off valve 557, and the tank 556 is provided with an automatic on-off valve 558. Upon receipt of a signal from the composition change monitoring section, the control section issues an instruction of opening or closing the automatic on-off valves 557 and 558 of the component adjusting section to supply the rinsing tank 521 with a shortage amount of perfluorocarbons PF5060 or the hexamethyldisiloxane.

Because the composition control mechanism (E) of the cleaning apparatus of embodiment 123 keeps the mixing ratio between the components of the incombustible or flame-retardant mixed cleaning agents 522 and 532 constant. In other words, one of the two components can be prevented from being consumed in a greater quantity than the other. Thus, the incombustibility or flame-retardancy of the mixed cleaning agents 522 and 532 can be prevented from being spoiled. Accordingly, it is possible to use the flammable low molecular weight siloxane compound safely against fire.

In embodiment 123, the composition change monitoring section serving as the mixing ratio measuring means is constituted of the temperature sensors 551, 552, 553, and 554 for measuring the boiling point and condensation point of the vapor mixed cleaning agent 532. Instead, the composition change monitoring section may be constituted of a sensor for measuring the specific gravity and index of refractivity of the mixed cleaning agent and a sensor for measuring the concentration of the low molecular weight siloxane compound contained in the vapor of the mixed cleaning agent, based on the degree of infrared absorption of the Si-O bond of the low molecular weight siloxane compound. The sensor for measuring the specific gravity and index of refractivity of the mixed cleaning agent is installed in the pipe 535 for feeding the mixed cleaning agent from the vapor drying agent tank 531 to the rinsing tank 521. The sensor for measuring the concentration of the low molecular weight siloxane compound contained in the vapor of the mixed cleaning agent, based on the degree of infrared absorption of the Si-O bond is installed in the vapor drying agent tank 531. These sensors also provide an effect similar to that provided by the composition change monitoring section which measures the boiling point and condensation point of the vapor mixed cleaning agent 532.

The preventive safety mechanism (F) comprises a sensor 561 for detecting the vapor density of the low molecular weight siloxane compound; a sensor 562 for detecting the concentration of oxygen; an inactive gas purge mechanism 563 which is actuated based on results detected by the sensors 561 and 562; and a mechanism 564 for generating alarm upon detection of liquid leakage.

Inactive nitrogen gas or fluorocarbon gas is introduced from the inactive gas purge mechanism 563 into the cleaning apparatus. As a result, the vapor density of the low molecular weight siloxane compound is diluted to a range in which the low molecular weight siloxane compound is incombustible. It is possible to operate the cleaning apparatus by pressurizing the atmosphere in the cleaning tank 511, the rinsing tank 521, the vapor drying agent tank 531, and the upper part above the tanks 511, 521, and 531, using the inactive gas by always operating the inactive gas purge mechanism 563.

The preventive safety mechanism (F) further comprises an unshown liquid temperature adjusting mechanism and a mechanism for automatically stopping the operation of the heating apparatus at a time of an excessive temperature rise. Further, basically, noncontact type relays are adopted at electric equipments of the preventive safety mechanism (F), whereas electric equipments thereof having contacts are air-purged. Motors have flameproof constructions. An oil pan 565 is provided to prevent the low molecular weight siloxane compound from spreading over the floor if it has leaked from the cleaning tank 511, the rinsing tank 521 or the vapor drying agent tank 531. Further, an oil coagulating agent 566 is provided to solidify the low molecular weight siloxane compound if it leaks therefrom.

The extinguishing mechanism (G) has a $CO_2$-automatic extinguisher 571. In order to drive the $CO_2$-automatic extinguisher 571, a flame sensor 572 and a temperature sensor 573 are installed inside the cleaning apparatus. When

a fire is detected by the flame sensor 572 and the temperature sensor 573, a $CO_2$ fire-extinguishing agent is injected from each extinguishing nozzle 571a of the automatic extinguisher 571. Upon actuation of the automatic extinguisher 571, a discharge duct 504 is stopped, and a damper 574 in the duct 504 and a door 503 are automatically closed to cut off the ambient air to prevent oxygen from penetrating into the heating apparatus.

The preventive safety mechanism (F) and the extinguishing mechanism (G) prevent the low molecular weight siloxane compound from being inflamed. Even though a fire breaks out, it can be extinguished automatically. Thus, the low molecular weight siloxane compound can be used safely against fire. In the above-described embodiment 123, the low molecular weight siloxane compound is used in the rinsing process (B) and the drying process (C), but the present invention may be applied to a cleaning apparatus in which the low molecular weight siloxane compound may be used in only one of the cleaning process (A), the rinsing process (B), and the drying process (C). Further, the present invention may be applied to a cleaning apparatus having only the rinsing process (B) and the drying process (C) so that it cleans objects dirty in a small degree or to a cleaning apparatus comprising the cleaning process (A), the rinsing process (B) or the drying process (C).

As described above, according to the cleaning apparatus of the present invention, fluorocarbons are mixed with the flammable low molecular weight siloxane compound to allow the mixture thereof to be incombustible or flame-retardant, and the mixing ratio between the two components of the mixture is controlled to prevent the incombustibility and flame-retardancy thereof from being spoiled. Thus, it is possible to use the cleaning agent containing the low molecular weight siloxane compound safely and effectively.

Embodiment 124

An embodiment of the second through fourth cleaning apparatuses of the present invention will be described below with reference to drawings.

Fig. 6 shows the construction of the cleaning apparatus according to an embodiment of the present invention. The cleaning apparatus comprises a section for carrying out a cleaning process (A); a section for carrying out a rinsing process (B); and a section for carrying out a drying process (C). The cleaning apparatus further comprises a preventive safety mechanism (D); an extinguishing mechanism (E); and a distillation recovering mechanism (F). The sections corresponding to the processes for handling the flammable low molecular weight siloxane compound, namely, the cleaning process (A), the rinsing process (B), and the drying process (C) are covered with a casing 601. The part for taking in and out an object 602 is provided with double doors 603 and 604 to allow the processes for handling the flammable low molecular weight siloxane compound to be airtight.

A predetermined amount of a cleaning agent 612 consisting of octamethylciclotetrasiloxane which is a low molecular weight siloxane compound is accommodated in a cleaning agent tank 611 of the cleaning process (A). The object 602 is immersed in the cleaning agent 612 to remove dirty components which have attached thereto. The number of the cleaning agent tanks 611 of the cleaning process (A) is set according to the kind of dirt, the amount thereof, a cleaning time period, and a cleaning quality. The tank 611 can be arranged as a single tank or plural tanks. An ultrasonic wave-generating device 613 is installed at the bottom of each of the cleaning agent tanks 611 as necessary.

A rinsing tank 621 of the rinsing process (B) contains a predetermined amount of a rinsing cleaning agent 622 consisting of octamethylcycloxane which is a low molecular weight siloxane compound. The object 602 is immersed in the rinsing agent 622 to remove the cleaning agent components which have attached thereto. The number of the rinsing tanks 621 of the rinsing process (B) is set according to a rinsing cleaning time period and a cleaning quality, and the like, similarly to the cleaning process (A). The rinsing tank 621 can be arranged as a single tank or plural tanks. An ultrasonic wavegenerating device 623 is installed at the bottom of the rinsing tank 621 as necessary.

A liquid temperature sensor 641 is installed in each of the cleaning agent 612 contained in the cleaning agent tank 611 and the cleaning agent 622 contained in the rinsing tank 621 as a part of the preventive safety mechanism (D). Based on results obtained by the measurement of the liquid temperature sensors 641, unshown liquid temperature adjusting mechanism keeps the temperature of the cleaning agent 612 and that of the cleaning agent 622 lower than the flash point thereof. Motors 615 and 625 circulate the cleaning agent 612 and the cleaning agent 622, respectively through filters 614 and 624, respectively.

A vapor drying agent tank 631 of the drying process (C) accommodates a vapor cleaning agent 632 consisting of hexamethyldisiloxane which is a low molecular weight siloxane compound. A heater 633 heats the vapor cleaning agent 632 so that vapor 632a is generated. The rinsed object 602 is subjected to the vapor 632a of the vapor cleaning agent 632 for a predetermined time period to allow the vapor 632a of the vapor cleaning agent 632 to form dew on the surface of the object 602. In this manner, the rinsing cleaning agent 622 is removed from the object 602, and the object 602 is heated by condensation latent heat.

Cooling pipes 616, 626, and 634 are installed on the upper inner wall surface of each of the cleaning agent tank 611, the rinsing tank 621, and the vapor cleaning tank 631, thus cooling and liquefying the vapor of the low molecular weight siloxane compound. In this manner, the vapor is prevented from dispersing to the outside from the cleaning apparatus.

The preventive safety mechanism (D) has an inactive gas purge mechanism 642 for pressurizing the atmosphere inside the cleaning agent tank 611, the rinsing tank 621, and the vapor cleaning tank 631 and the atmosphere in the upper part thereof by means of inactive fluorocarbon gas such as the gas of perfluorocarbon $C_4F_{10}$ so as to keep the atmosphere inside the cleaning apparatus at a pressure at which the low molecular weight siloxane compound does not inflame and prevent oxygen from penetrating into the cleaning apparatus. Upon actuation of the inactive gas purge mechanism 642, the double doors 603 and 604 are closed to prevent oxygen from penetrating into the cleaning apparatus.

The preventive safety mechanism (D) comprises a sensor 643 for detecting the vapor density of the low molecular weight siloxane compound and a sensor 644 for detecting the concentration of oxygen. The sensors 643 and 644 are connected with a control section 645 of the inactive gas purge mechanism 642. The control section 645 issues an instruction of giving an alarm and increasing a purge amount of the inactive gas purge mechanism 642 to set the vapor density of the low molecular weight siloxane compound to a range in which the low molecular weight siloxane compound does not inflame, when the vapor density of the low molecular weight siloxane compound and the concentration of oxygen is beyond a controllable range. In this manner, the vapor density of the low molecular weight siloxane compound inside the cleaning apparatus is kept at the range in which the low molecular weight siloxane compound does not inflame.

As described above, the preventive safety mechanism (D) makes it possible to use the cleaning agent 612, the cleaning agent 622, and the vapor cleaning agent 632 safely. The vapor density sensor 643 for detecting the vapor density of the low molecular weight siloxane compound measures the density of the vapor of the low molecular weight siloxane compound, based on the degree of infrared absorption of the Si-O bond of the low molecular weight siloxane compound. Therefore, the vapor density of the low molecular weight siloxane compound can be detected at a high sensitivity, which secures safety against fire.

In addition to the above-described equipments, the preventive safety mechanism (D) further comprises a mechanism for automatically stopping the operation of the heating apparatus at a time of an excessive temperature rise and a mechanism 646 for detecting liquid leak and giving an alarm. Further, basically, noncontact type relays are adopted at electric equipments of the preventive safety mechanism (D), whereas electric equipments thereof having contacts are air-purged. Motors have flameproof constructions. An oil pan 647 is provided to prevent the low molecular weight siloxane compound from spreading over the floor if it leaks from the cleaning tank 611, the rinsing tank 621 or the vapor cleaning agent tank 631. Further, an oil coagulating agent 648 is provided to solidify the low molecular weight siloxane compound if it has leaked therefrom. In addition, instead of the oil coagulating agent 648, it is possible to use the incombustible or flame-retardant fluorocarbons as an agent for absorbing the low molecular weight siloxane compound.

Instead of the inactive gas purge mechanism 642 of the preventive safety mechanism (D) or in combination with inactive gas purge mechanism 642, it is possible to combine the cleaning agent tank 611, the rinsing tank 621, and the vapor cleaning tank 631 into a tank 649 which can be closed, as shown in Fig. 7 and provide a mechanism for moving the closed tank 649 vertically so that except the time when the object 602 is introduced thereinto and discharged therefrom, the closed tank 649 is immersed in a liquid 650 of incombustible or flame-retardant fluorocarbons, for example, hydrofluorocarbon $C_5H_2F_{10}$. In this construction, the cleaning agent 612, and the cleaning agent 622, and vapor cleaning agent 632 can be used safely; and even though liquid leakage occurs, the low molecular weight siloxane compound is absorbed by the fluorocarbon liquid 650. Thus, the low molecular weight siloxane compound can be used safely. Further, the low molecular weight siloxane compound can be used more safely by providing the upper construction of the fluorocarbon liquid 650 with a sealing construction.

Further, as shown in Fig. 8, it is possible to provide each of the cleaning agent tank 611, the rinsing tank 621, and the vapor cleaning tank 631 with a double construction and charge a filler 652 consisting of incombustible or flame-retardant fluorocarbons between an outer tank 651 and each of the cleaning agent tank 611, the rinsing tank 621, and the vapor cleaning tank 631. In this construction, even though liquid leak occurs, the low molecular weight siloxane compound is absorbed by the filler 652 consisting of fluorocarbons. Thus, the low molecular weight siloxane compound can be used safely.

The extinguishing mechanism (E) has an automatic extinguisher 661 containing incombustible or flame-retardant fluorocarbons such as fluoroiodidecarbon $CF_2I_2$. In order to drive the automatic extinguisher 661, a flame sensor 662, a temperature sensor 663, and a pressure sensor 664 are installed inside the cleaning apparatus. When a fire is detected by the flame sensor 662, the temperature sensor 663, and the pressure sensor 664, a fire-extinguishing agent consisting of fluoroiodidecarbon $CF_2I_2$ is injected from each extinguishing nozzle 661a of the automatic extinguisher 661. The liquid of consisting of fluoroiodidecarbon $CF_2I_2$ can be used. Upon actuation of the automatic extinguisher 661, the double doors 603 and 604 are closed to cut off the ambient air to prevent oxygen from penetrating into the heating apparatus, thus providing an improved extinguishing effect.

The extinguishing mechanism (E) extinguishes a fire if the low molecular weight siloxane compound has been inflamed. Thus, the cleaning agent 612, the cleaning agent 622, and the vapor cleaning agent 632 can be used safely.

The cleaning agent 622 which has attached to the object 602 is delivered into the vapor cleaning tank 631, thus polluting the vapor cleaning agent 632 and accumulating in the vapor cleaning tank 631. Therefore, the vapor cleaning

agent 632 to be used in the vapor cleaning tank 631 is fed to a distiller 672 of a distillation recovering mechanism (F) via a pipe 671 to purify the polluted vapor cleaning agent 632. The vapor cleaning agent 632 thus recovered is returned to the vapor cleaning tank 631 via a pipe 673. Dirt and the cleaning agent which have attached to the object 602 are separated therefrom and discharged via a pipe 674. The safety of the respective devices of the distillation recovering mechanism (F) can be ensured by providing them with incombustible or flame-retardant fluorocarbons.

In the cleaning apparatus of the embodiments, the low molecular weight siloxane compound is used in each of the cleaning process (A), the rinsing process (B), and the drying process (C). But the present invention may be applied to a cleaning apparatus in which the low molecular weight siloxane compound may be used in only one of the cleaning process (A), the rinsing process (B), and the drying process (C). Further, the present invention may be applied to a cleaning apparatus comprising the cleaning process (A), the rinsing process (B) or the drying process (C). The low molecular weight siloxane compound can be used safely and effectively not only for cleaning operations (vibration, agitation, ultrasonic waver, spray, and the like), but also for drying operations (hot air drying, spin drying, vapor drying, lift drying, vacuum drying, and the like.)

As described above, according to the cleaning apparatus of the present invention, the flammable low molecular weight siloxane compound can be used safely and easily. For example, in the second cleaning apparatus, the vapor density of the low molecular weight siloxane compound can be diluted to a range in which the low molecular weight siloxane compound does not inflame. Thus, the low molecular weight siloxane compound can used safely against fire. In the third cleaning apparatus, the generation of heat sources such as electrical spark can be prevented and the low molecular weight siloxane compound can be cut off from oxygen. Therefore, cleaning works can be carried out safely. In the fourth cleaning apparatus, even though a fire happens, the fire can be effectively extinguished. Thus, the fourth cleaning apparatus can be used very safely.

INDUSTRIAL APPLICABILITY

As apparent from the foregoing description, the cleaning agent of the present invention have been developed to replace flon solvents and chlorinated solvents. The cleaning agent, the cleaning method, and the cleaning apparatus do not destroy environment and are useful for cleaning many industrial products such as electronic parts and precision parts.

## Claims

**1.** A cleaning method comprising the steps of:

cleaning an object with a polar cleaning agent having a solubility parameter not less than nine or a dielectric constant not less than four; and

at least one step selected from the group consisting of rinsing the object with a mixed cleaning agent comprising the polar cleaning agent having the solubility parameter not less than nine or the dielectric constant not less than four and a cleaning agent having a solubility parameter less than nine and a dielectric constant less than four and

drying the object with a mixed cleaning agent comprising the polar cleaning agent having the solubility parameter not less than nine or the dielectric constant not less than four and a cleaning agent having a solubility parameter less than nine and a dielectric constant less than four.

**2.** A cleaning method according to claim 1, wherein the polar cleaning agent has the solubility parameter in a range of 9 - 14 or the dielectric constant in a range of 4 - 45.

**3.** A cleaning method according to claim 1, wherein the mixed cleaning agent is incombustible or flame-retardant.

**4.** A cleaning method according to claim 1, wherein the drying step comprises vapor drying with the mixed cleaning agent.

**5.** A cleaning method according to claim 1, wherein the cleaning agent having the solubility parameter less than nine and the dielectric constant less than four consists of at least one agent selected from the group consisting of low molecular weight siloxane compound, hydrocarbons, fluorocarbons, ethers, and acetals.

**6.** A cleaning method according to claim 1, wherein the mixed cleaning agent comprises the polar cleaning agent in a range of 0.1 - 30 wt%.

**7.** A cleaning method according to claim 5, wherein the hydrocarbons consist of aliphatic hydrocarbon and/or alicyclic

hydrocarbon.

8. A cleaning method according to claim 5, wherein the fluorocarbons are cleaning agents comprising hydrofluoroether expressed by a general formula of $C_tF_uOC_vH_{2v+1}$ where t, u, and v are given integers.

9. A cleaning method comprising the steps of:

   cleaning an object with a polar cleaning agent having a solubility parameter not less than nine or a dielectric constant not less than four; and
   rinsing the object and/or drying the object with a mixed cleaning agent comprising hydrofluoroether expressed by a general formula of $C_tF_uOC_vH_{2v+1}$ as an effective component thereof.

   where t, u, and v are given integers.

10. A cleaning method comprising at least one step selected from the group consisting of:

    cleaning, rinsing, and drying an object with a cleaning composition consisting essentially of a low molecular weight siloxane compound, and at least one of fluorocarbons and a polar cleaning agent having a solubility parameter not less than nine or a dielectric constant not less than four.

11. A cleaning method according to claim 10, wherein the cleaning agent comprises the low molecular weight siloxane compound, fluorocarbons, and the polar cleaning agent.

12. A cleaning method comprising the steps of cleaning, rinsing, and drying an object, using a cleaning agent comprising a low molecular weight siloxane compound, fluorocarbons, and a polar cleaning agent having a solubility parameter not less than nine or a dielectric constant not less than four.

13. A cleaning method according to claims 11 or 12, wherein the drying method is carried out by hot air drying, natural drying, vacuum drying or vapor drying.

14. A cleaning method in which a mixed cleaning agent comprising a low molecular weight siloxane compound and fluorocarbons as a main component thereof and being incombustible or flame retardant is charged into a closed container so that the mixed cleaning agent is sprayed over an object.

15. A dewatering drying method in which an object is dewatered, using a liquid being compatible with water, not forming an azeotropic composition when the liquid has mixed with water and having a heat of vaporization not more than 100 cal/g.

16. A dewatering drying method according to claim 15, wherein the liquid consists of trifluoroethanol.

17. A dewatering drying method according to claim 15, wherein the liquid is a mixture consisting of trifluoroethanol and hydrofluoroether.

18. A dewatering drying method according to claim 15, wherein the object is dewatered with trifluoroethanol or a mixed cleaning agent consisting of the trifluoroethanol and hydrofluoroether and dried with vapor of hydrofluoroether.

19. A dewatering drying method according to claim 15, wherein the object is dried with vapor of an azeotropic composition consisting of trifluoroethanol and hydrofluoroether.

20. A dewatering drying method according to claim 15, wherein the object is dried with vapor of low molecular weight siloxane compound.

21. A cleaning method according to claims 5, 10, 12, 14 or 20, wherein the low molecular weight siloxane compound comprises at least one low molecular weight polyorganosiloxane selected from the group consisting of a straight-chain polyorganosiloxane and its derivatives expressed by:

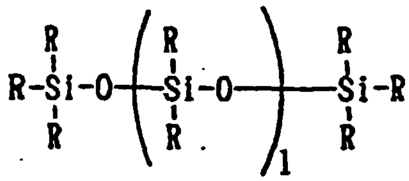

..... (i)

where groups expressed by R are substituted or unsubstituted monovalent organic groups identical to each other or different from each other; l is integers 0 - 5; and
cyclic polyorganosiloxane and its derivatives expressed by:

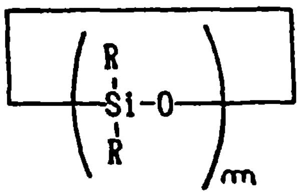

..... (ii)

where groups expressed by R are substituted or unsubstituted monovalent organic groups identical to each other or different from each other; m is integers 3 - 7.

**22.** A cleaning method according to claim 5, 10, 12 or 14, wherein the fluorocarbons comprises at least one fluorocarbon selected from the group consisting of perfluorocarbons, hydrofluorocarbons, hydrochlorofuorocarbons, fluoroiodidecarbons, and fluoroalcohols.

**23.** A cleaning method according to claim 1, 9, 10 or 12, wherein the polar cleaning agent comprises at least one component selected from the group consisting of alcohols, glycols, phenols, ketones, fatty acids, acid anhydrides, esters, amines, amides, quaternary ammonium salts, nitriles, morpholines, sulfoxides, sultones, phosphoric acids, derivatives of these substances, and N-methyl-2-pyrrolidone.

**24.** A cleaning agent comprising at least two substances selected from a low molecular weight siloxane compound, fluorocarbons, and a polar cleaning agent having a solubility parameter not less than nine or a dielectric constant not less than four.

**25.** A cleaning agent comprising a low molecular weight siloxane compound, and at least one substance selected from fluorocarbons and a polar cleaning agent having a solubility parameter not less than nine or a dielectric constant not less than four.

**26.** A cleaning agent according to claims 24 or 25, wherein the cleaning agent comprising the low molecular weight siloxane compound, the fluorocarbons, and the polar cleaning agent.

**27.** A cleaning agent according to any one of claims 24 through 26, wherein the cleaning agent comprising the fluorocarbons, the low molecular weight siloxane compound, and the polar cleaning agent is incombustible or flame-retardant.

**28.** A cleaning agent according to claim 24 or 25, wherein the cleaning agent comprising the fluorocarbons, the low molecular weight siloxane compound, and the polar cleaning agent consists of an azeotropic composition or a pseudo-azeotropic composition.

**29.** A cleaning agent according to claim 24 or 25, wherein the fluorocarbons is selected from perfluorocarbons, hydrofluorocarbons, hydrochlorofluorocarbons, fluoroiodidecarbons, fluoroalcohols, and hydrofluoroethers.

**30.** A cleaning agent according to claim 24 or 25, wherein the low molecular weight siloxane compound comprises at least one low molecular weight polyorganosiloxane selected from the group consisting of a straight-chain polyorganosiloxane and its derivatives expressed by:

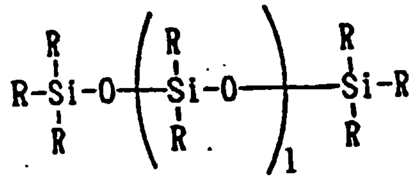

..... (i)

where groups expressed by R are substituted or unsubstituted monovalent organic groups identical to each other or different from each other; l is integers 0 - 5; and
cyclic polyorganosiloxane and its derivatives expressed by:

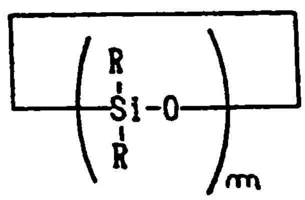

..... (ii)

where groups expressed by R are substituted or unsubstituted monovalent organic groups identical to each other or different from each other; m is integers 3 - 7.

**31.** A cleaning agent according to claim 24 or 25, wherein the polar cleaning agent comprising at least one component selected from alcohols, glycols, phenols, ketones, aliphatic acids, acid anhydrides, esters, amines, amides, quaternary ammonium salts, nitriles, morpholines, sulfoxides, sultones, phosphoric acids, derivatives of these substances, and N-methyl-2-pyrrolidone.

**32.** A cleaning agent according to claim 24 or 25, wherein 10 - 10,000 parts by weight of the fluorocarbons is mixed with 100 parts by weight of the low molecular weight siloxane compound; and the mixing ratio of the polar cleaning agent to the whole amount of the cleaning agent is in a range of 0.1 - 30 percent by weight.

**33.** A cleaning agent according to claim 24 or 25, wherein the fluorocarbons is perfluorocarbon selected from perfluorohexane, perfluoroheptane, and perfluoromorpholine; the low molecular weight siloxane compound is hexamethyldisiloxane; and the polar cleaning agent is selected from tert-butanol and isopropyl acetate.

**34.** A cleaning agent according to claim 24, wherein the agent comprising an azeotropic composition or a pseudo-azeotropic composition consisting essentially of the perfluorocarbon, the hexamethyldisiloxane, and the polar cleaning agent as an effective component thereof.

**35.** A cleaning agent according to claim 33, wherein the agent comprises an azeotropic composition or a pseudo-azeotropic composition including the hexamethyldisiloxane and the polar cleaning agent as an effective component thereof.

**36.** A cleaning agent according to claim 33, wherein the agent comprises, as an effective component thereof, a composition including the 60 - 96 wt% of perfluorocarbon selected from the perfluorohexane and the perfluoromorpholine, 2 - 20 wt% of the hexamethyldisiloxane, and 2 - 20 wt% of the polar cleaning agent.

**37.** A cleaning agent according to claim 33, the perfluoromorpholine is perfluoroalkylmorpholine.

**38.** A cleaning agent according to claim 37, the perfluoroalkylmorpholine is perfluor-N-methylmorpholine.

**39.** A cleaning agent according to claim 33, wherein the agent comprises, as an effective component thereof, a composition including the 50 - 90 wt% of perfluoroheptane, 5 - 25 wt% of the hexamethyldisiloxane, and 5 - 25 wt% of the polar cleaning agent.

**40.** A cleaning agent according to claim 33, wherein the agent comprises a composition including the 44 - 50 wt% of the hexamethyldisiloxane and 50 - 56 wt% of the tert-butanol as an effective component thereof.

**41.** A cleaning agent according to claim 33, wherein the agent comprises a composition including the 40 - 46 wt% of the hexamethyldisiloxane and 54 - 60 wt% of the isopropyl acetate as an effective component thereof.

**42.** A cleaning agent according to claim 24 or 25, wherein the agent comprises, as an effective component thereof, an azeotropic composition or a pseudo-azeotropic composition including the fluorocarbons and the polar cleaning agent having a solubility parameter not less than nine or a dielectric constant not less than four.

**43.** A cleaning agent according to claim 24 or 25, wherein the agent comprises, as an effective component thereof, an azeotropic composition or a pseudo-azeotropic composition including the fluorocarbons and the low molecular weight siloxane compound.

**44.** A cleaning agent according to claim 43, wherein the fluorocarbons is selected from perfluorocarbons, hydrofluorocarbons, hydrochlorofluorocarbons, fluoroiodidecarbons, fluoroalcohols, and hydrofluoroethers; and the low molecular weight siloxane compound is selected from hexamethyldisiloxane, octamethyltrisiloxane, and octamethylcyclotetrasiloxane.

**45.** An azeotropic composition or a pseudo-azeotropic composition comprising perfluorocarbon selected from perfluorohexane, perfluoroheptane, and perfluoromorpholine; hexamethyldisiloxane; and tert-butanol or isopropyl acetate.

**46.** An azeotropic composition or a pseudo-azeotropic composition consisting of hexamethyldisiloxane and tert-butanol or isopropyl acetate.

**47.** An azeotropic composition or a pseudo-azeotropic composition comprising fluoroether and a polar cleaning agent having a solubility parameter not less than nine or a dielectric constant not less than four.

**48.** A cleaning apparatus comprising:

a main body for carrying out at least one of the step of cleaning an object, the step of rinsing the object, and the step of vapor-drying the object by means of a mixed cleaning agent consisting of a cleaning agent comprising a low molecular weight siloxane compound and incombustible or flame-retardant fluorocarbons; and
a composition control mechanism for controlling a mixing ratio between the low molecular weight siloxane compound and the fluorocarbons of the mixed cleaning agent.

**49.** A cleaning apparatus according to claim 48, wherein the composition control means comprises a means for measuring the mixing ratio between the low molecular weight siloxane compound and the fluorocarbons of the mixed cleaning agent; and a means for supplying the mixed cleaning agent with the low molecular weight siloxane compound or the fluorocarbons, according to a result measured by the mixing ratio measuring means.

**50.** A cleaning apparatus according to claim 48, wherein the mixing ratio measuring means has a means for measuring at least one of the specific gravity, refractive index, boiling point, and condensation point of the mixed cleaning agent.

**51.** A cleaning apparatus according to claim 48, wherein the mixing ratio measuring means has a means for measuring a density of the low molecular weight siloxane compound of a vapor generated from the mixed cleaning agent, based on a degree of infrared absorption of a Si-O bond of the low molecular weight siloxane compound.

**52.** A cleaning apparatus using a cleaning agent comprising a low molecular weight siloxane compound, comprising a means for measuring a density of vapor of the low molecular weight siloxane compound generated from the cleaning agent, based on a degree of infrared absorption of a Si-O band of the low molecular weight siloxane compound.

**53.** A cleaning apparatus according to claim 52, further comprising a means for adjusting a temperature of the cleaning agent.

**54.** A cleaning apparatus using a cleaning agent comprising a low molecular weight siloxane compound, wherein a gas or a liquid of incombustible or flame-retardant fluorocarbons is charged to or placed in at least one of an inside of the cleaning apparatus, a periphery of the cleaning apparatus, insides of devices constituting the cleaning apparatus, and peripheries of the devices.

55. A cleaning apparatus using a cleaning agent comprising a low molecular weight siloxane compound, comprising a means for injecting an extinguishing agent consisting of a gas of incombustible or flame-retardant fluorocarbons or a liquid thereof to at least a part of the cleaning apparatus.

56. A cleaning apparatus according to claim 55, wherein to drive the extinguishing agent injection means, at least one of a flame detection means, a temperature detection means, and a pressure detection means required is provided.

57. A cleaning apparatus according to claim 48, 52, 54 or 55, wherein the low molecular weight siloxane compound comprises at least one low molecular weight polyorganosiloxane selected from the group consisting of a straight-chain polyorganosiloxane and its derivatives expressed by:

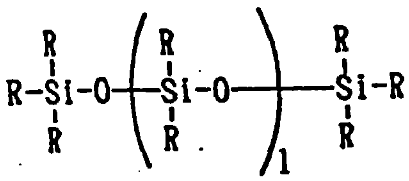

..... (i)

where groups expressed by R are substituted or unsubstituted monovalent organic groups identical to each other or different from each other; l is integers 0 - 5; and
cyclic polyorganosiloxane and its derivatives expressed by:

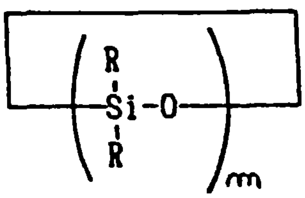

..... (ii)

where groups expressed by R are substituted or unsubstituted monovalent organic groups identical to each other or different from each other; m is integers 3 - 7.

58. A cleaning apparatus according to any one of claims 48, 54, and 55, wherein the incombustible or flame-retardant fluorocarbons is selected from perfluorocarbons, hydrofluorocarbons, hydrochlorofuorocarbons, fluoroiodidecarbons, and fluoroalcohols.

59. A dewatering drying apparatus in which an object is dewatered, using a liquid being compatible with water, not forming an azeotropic composition when the liquid has mixed with water and having a heat of vaporization not more than 100 cal/g.

60. A dewatering drying apparatus according to claim 59, wherein the liquid consists of trifluoroethanol.

61. A dewatering drying apparatus according to claim 59 or 60, further comprising a means for removing water which has mixed with the liquid regularly or intermittently.

FIG. 1

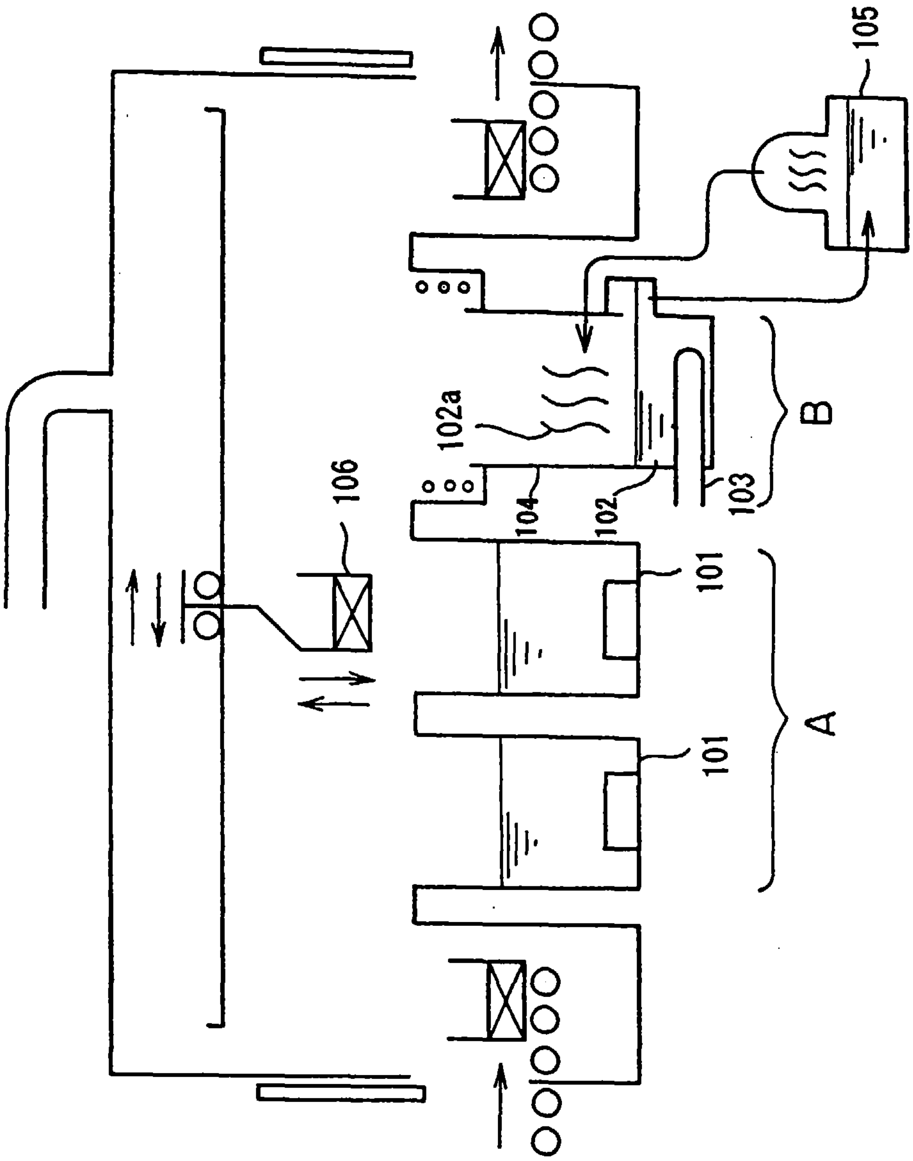

FIG. 2

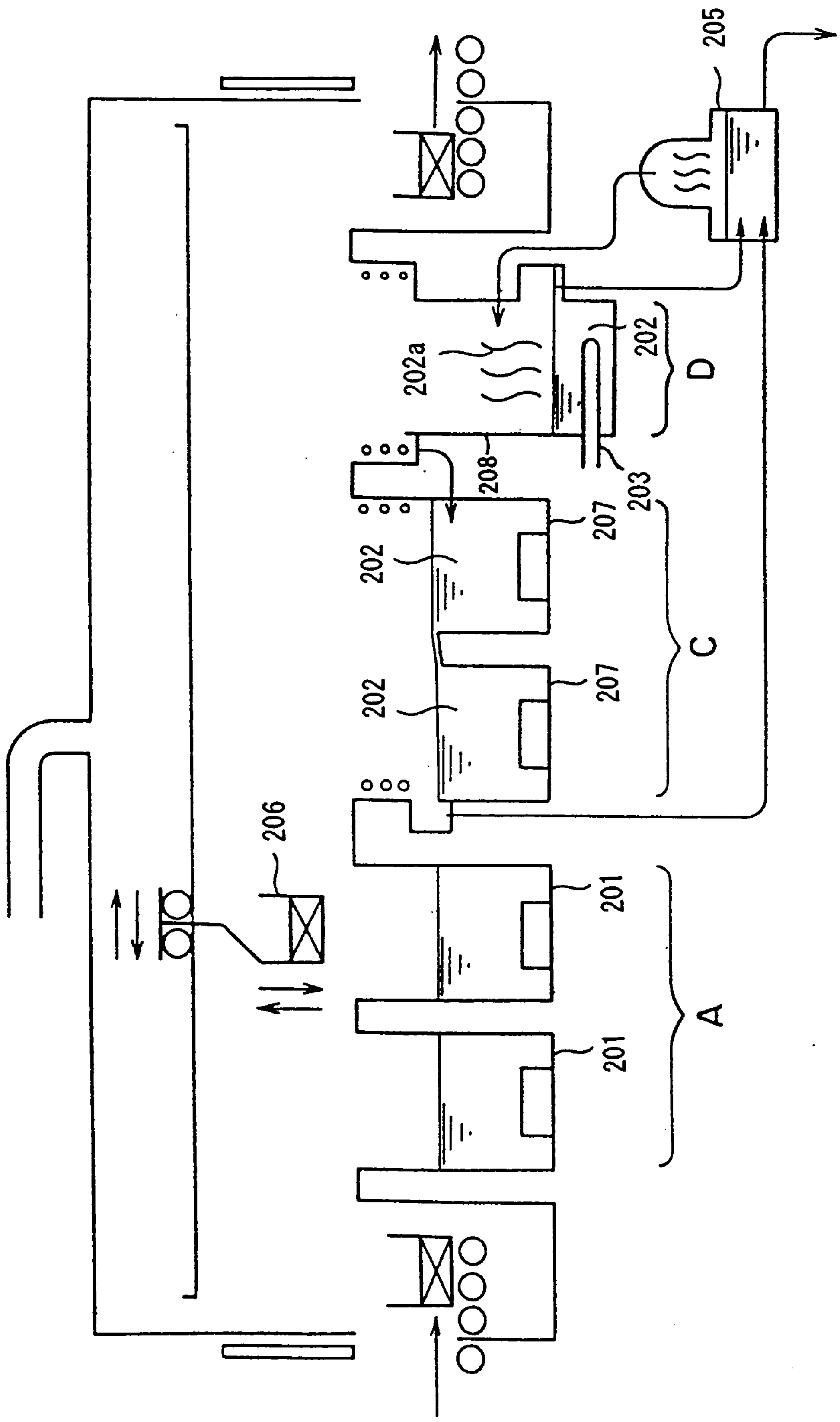

# FIG. 3

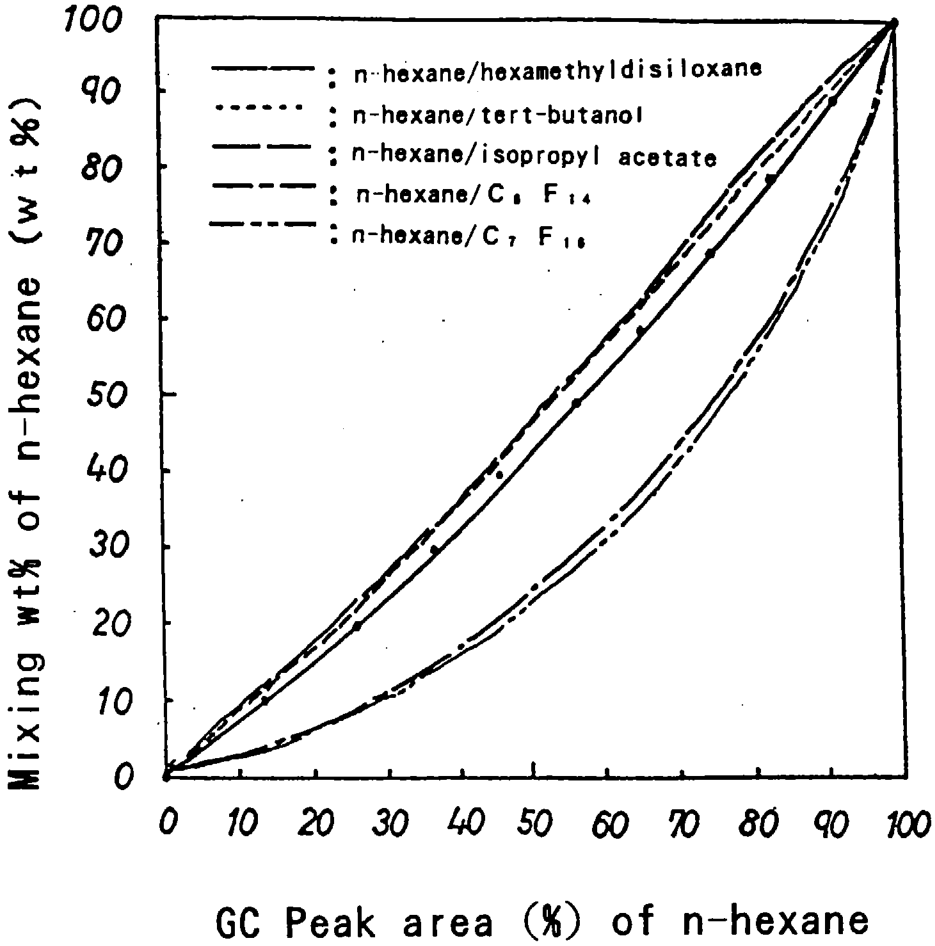
n-hexane/hexamethyldisiloxane
n-hexane/tert-butanol
n-hexane/isopropyl acetate
n-hexane/$C_6F_{14}$
n-hexane/$C_7F_{16}$
Mixing wt% of n-hexane (wt%)
0
10
20
30
40
50
60
70
80
90
100
GC Peak area (%) of n-hexane

FIG. 4

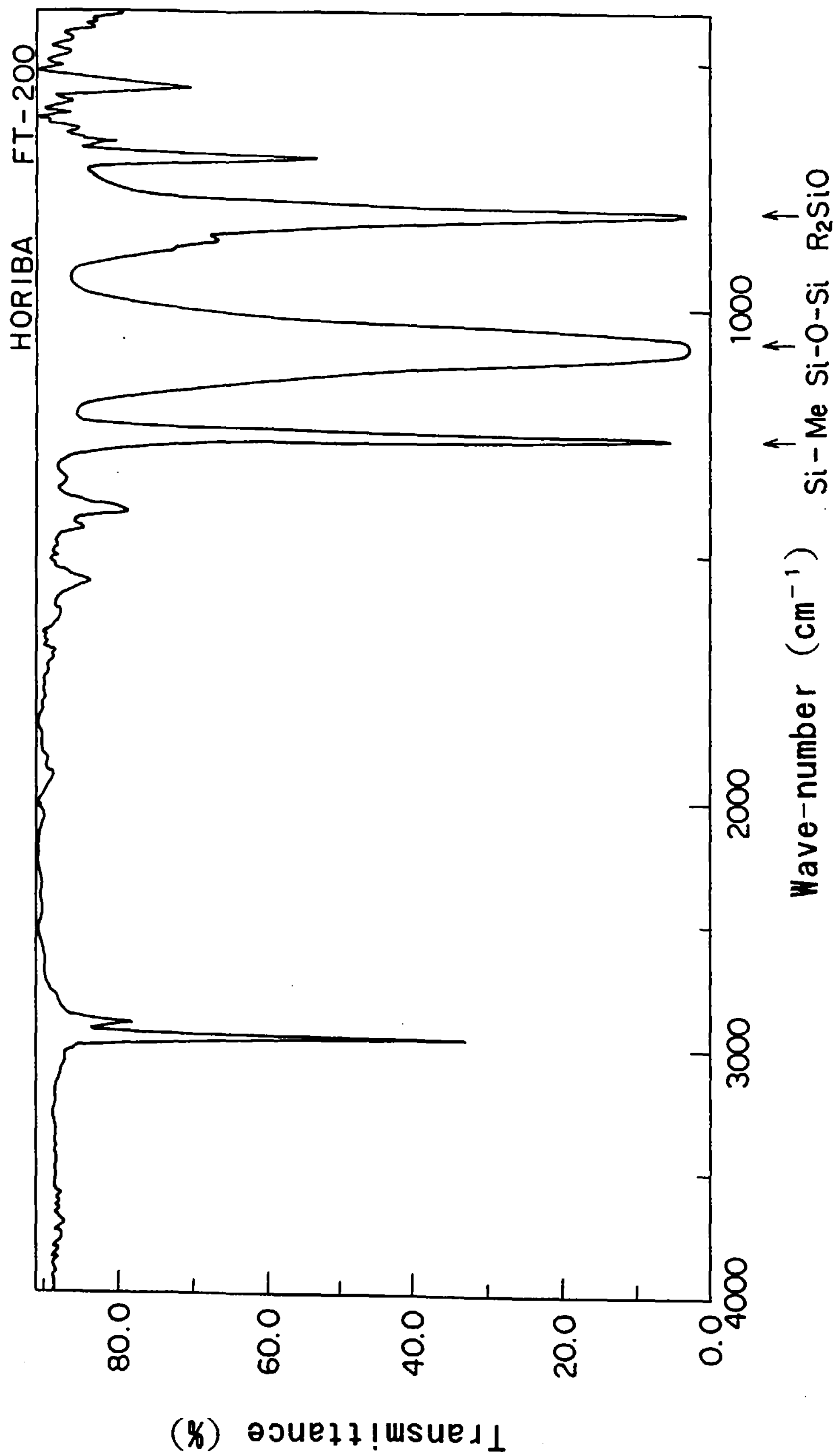
HORIBA
FT-200
Transmittance (%)
80.0
60.0
40.0
20.0
0.0
4000
3000
2000
1000
Wave-number (cm$^{-1}$)
Si-Me
Si-O-Si
$R_2SiO$

FIG. 5

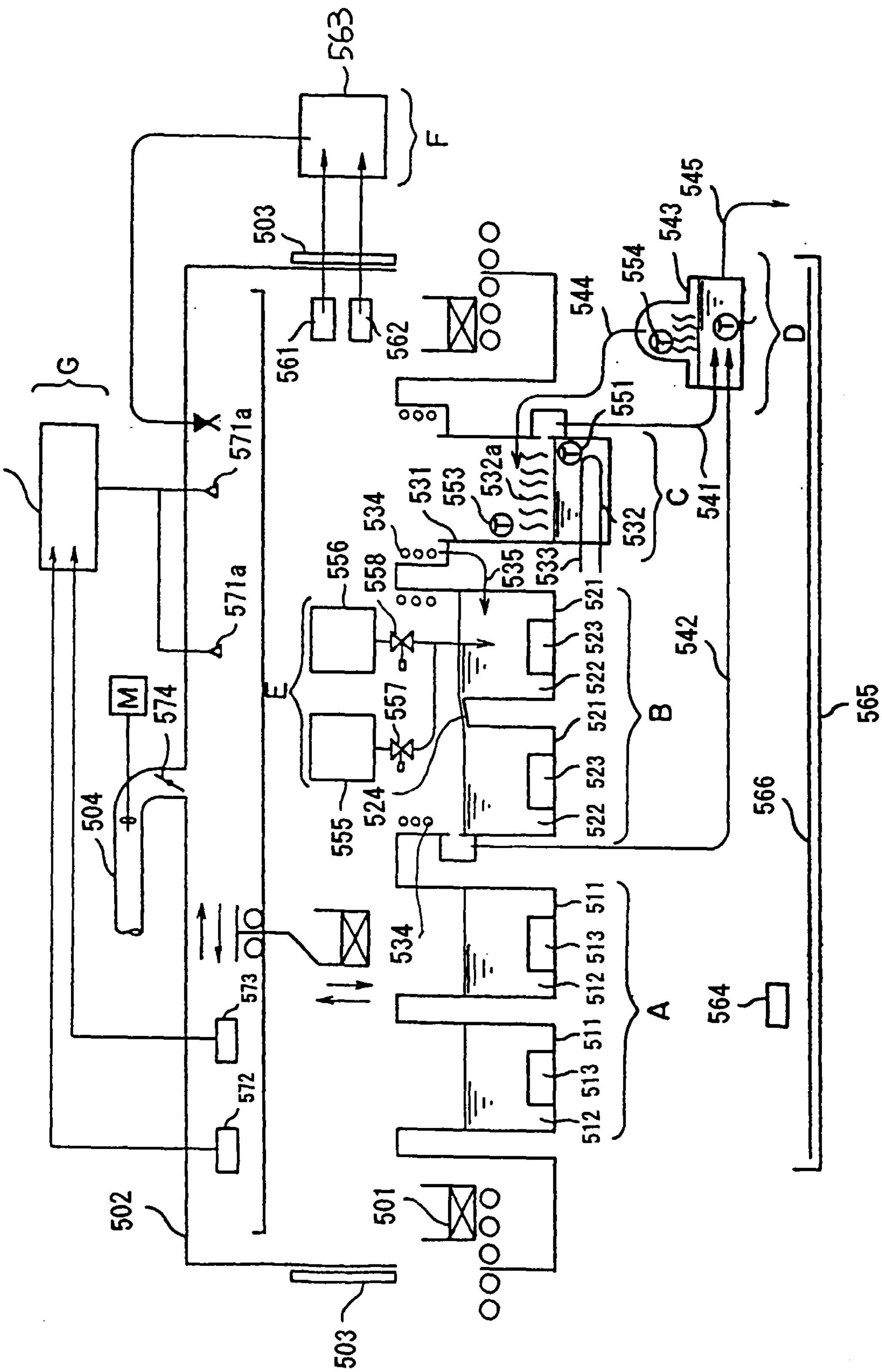
563
F
503
561
562
G
571
571a
571a
556
558
534
531
553
532a
551
554
544
543
545
D
C
541
532
533
535
521
523
522
542
B
E
M
574
557
555
524
504
534
511
513
512
A
564
565
566
573
572
502
501
503

FIG. 6

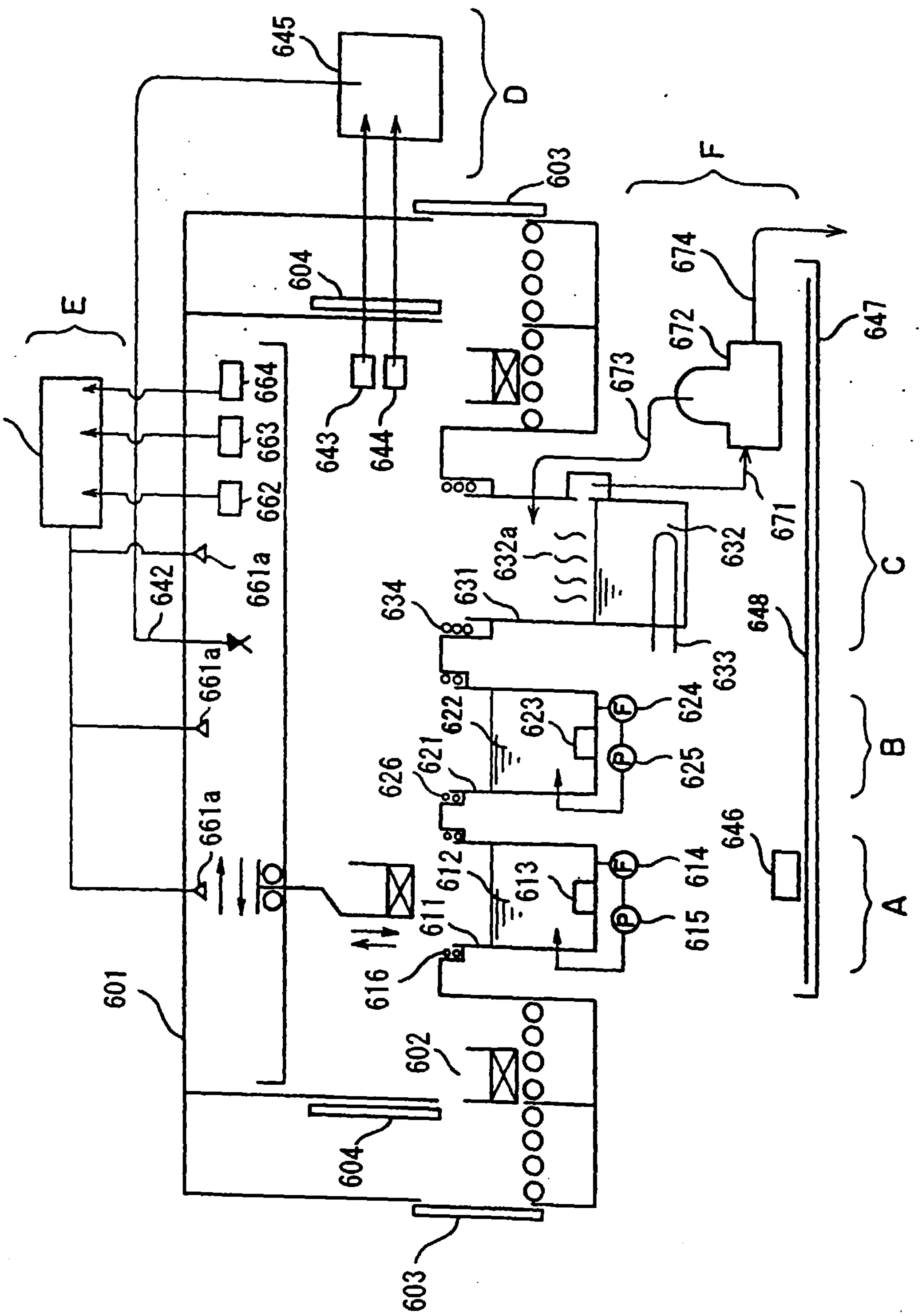
645
D
603
F
674
672
647
604
673
E
661
664
663
662
643
644
671
632
632a
C
634
631
661a
642
648
633
661a
622
623
624
B
626
621
625
661a
612
613
614
646
A
611
615
616
601
602
604
603

FIG. 7

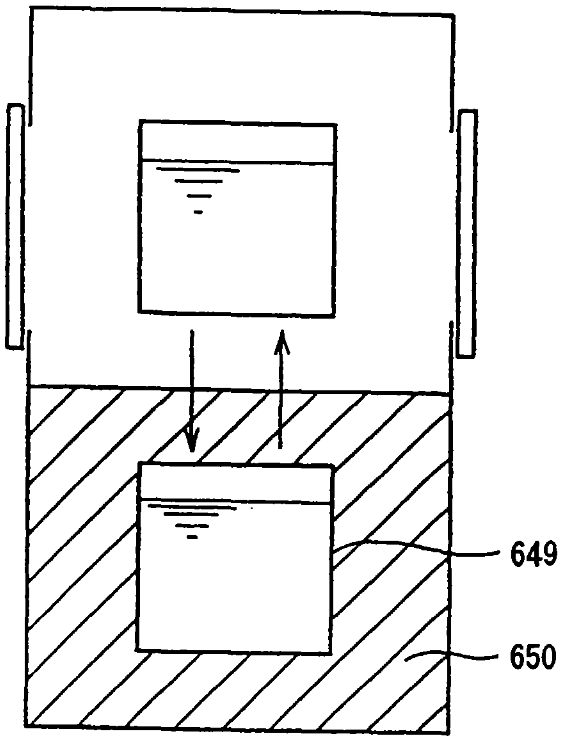


FIG. 8

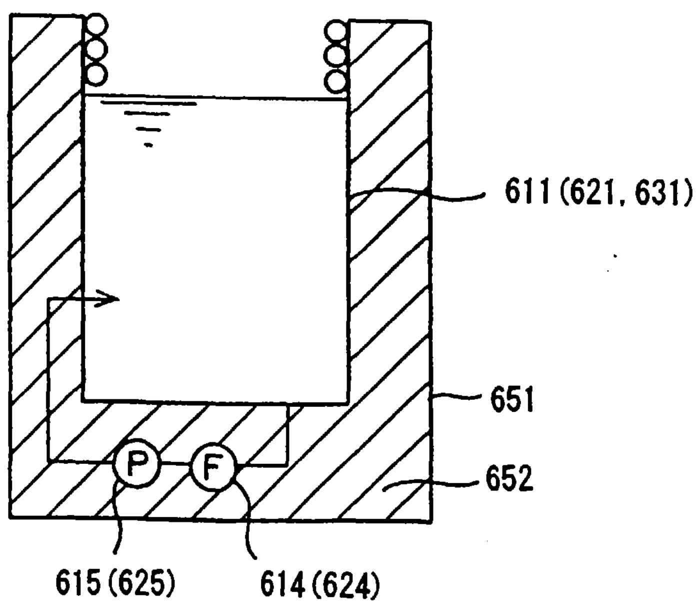

FIG.9

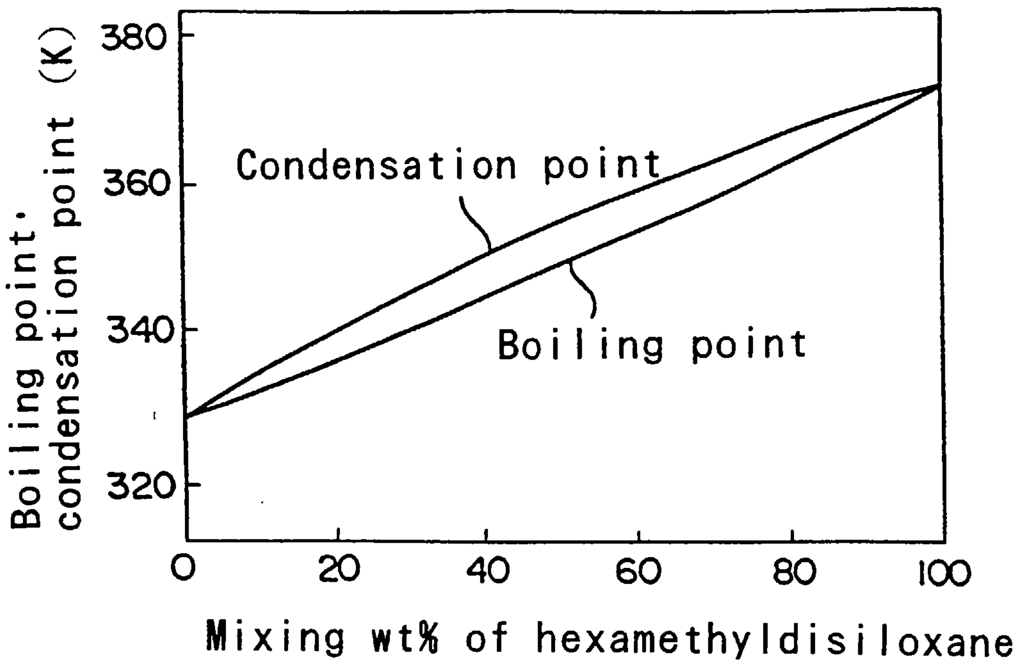
Boiling point·
condensation point (K)
380
360
340
320
Condensation point
Boiling point
0
20
40
60
80
100
Mixing wt% of hexamethyldisiloxane

FIG.10

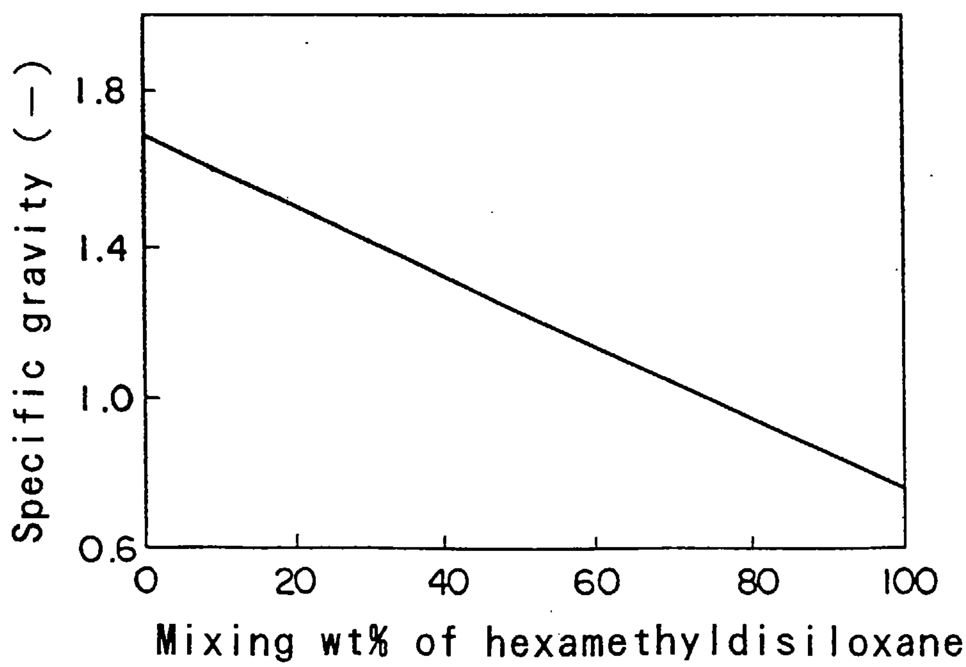
Specific gravity (—)
1.8
1.4
1.0
0.6
0
20
40
60
80
100
Mixing wt% of hexamethyldisiloxane

FIG. 11

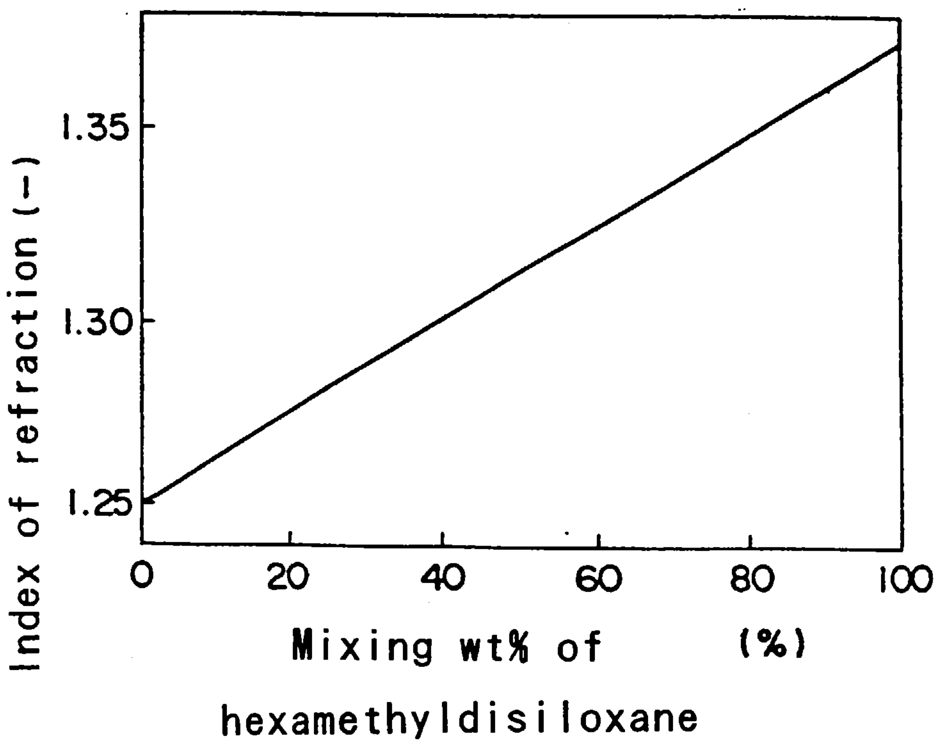
1.35
1.30
1.25
Index of refraction (−)
0
20
40
60
80
100
Mixing wt% of (%)
hexamethyldisiloxane

# INTERNATIONAL SEARCH REPORT

International application No.
PCT/JP95/02149

**A. CLASSIFICATION OF SUBJECT MATTER**

Int. $Cl^6$ B08B3/08

According to International Patent Classification (IPC) or to both national classification and IPC

**B. FIELDS SEARCHED**

Minimum documentation searched (classification system followed by classification symbols)

Int. $Cl^6$ B08B3/08, C11D7/50

Documentation searched other than minimum documentation to the extent that such documents are included in the fields searched

Jitsuyo Shinan Koho 1926 - 1995
Kokai Jitsuyo Shinan Koho 1971 - 1995

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP, 4-243503, A (Asahi Chemical Industry Co., Ltd.), May 3, 1991 (03. 05. 91)(Family: none) | 1-7, 42 |
| X | JP, 5-320693, A (Olympus Optical Co., Ltd.), December 3, 1993 (03. 12. 93) & WO, 93/14183, A1 & JP, 5-22240, A & EP, 576687, A1 & JP, 5-320693, A & JP, 5-339275, A & JP, 6-88093, A | 10 - 13, 24 - 25, 30 - 31, 33, 35, 40 - 41, 46 |
| Y | | 1-7, 14, 20 - 23, 55 |
| Y | JP, 3-252500, A (Showa Denko K.K.), November 11, 1991 (11. 11. 91)(Family: none) | 1 - 7, 22 - 23 |
| X | | 24 - 25, 42 |
| X | JP, 3-167298, A (Showa Denko K.K.), July 19, 1991 (19. 07. 91)(Family: none) | 24 - 25, 42 |

[X] Further documents are listed in the continuation of Box C. [ ] See patent family annex.

* Special categories of cited documents:
"A" document defining the general state of the art which is not considered to be of particular relevance
"E" earlier document but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| January 8, 1996 (08. 01. 96) | February 6, 1996 (06. 02. 96) |
| Name and mailing address of the ISA/ Japanese Patent Office | Authorized officer |
| Facsimile No. | Telephone No. |

Form PCT/ISA/210 (second sheet) (July 1992)

**INTERNATIONAL SEARCH REPORT**

International application No. PCT/JP95/02149

C (Continuation). DOCUMENTS CONSIDERED TO BE RELEVANT

| Category* | Citation of document, with indication, where appropriate, of the relevant passages | Relevant to claim No. |
|---|---|---|
| Y | | 1 - 7, 22 - 23 |
| X | JP, 3-21688, A (Daikin Industries, Ltd.), January 30, 1991 (30. 01. 91) (Family: none) | 15 - 19, 59 - 60 |
| Y | | 61 |
| Y | JP, 6-122898, A (Olympus Optical Co., Ltd.), May 6, 1994 (06. 05. 94) (Family: none) | 1-7, 14, 20 - 23, 48 - 58 |
| X | | 10 - 13, 24 - 31, 33 - 36, 39 - 40, 42 - 45, 47 |
| Y | JP, 6-71238, A (Olympus Optical Co., Ltd.), March 15, 1994 (15. 03. 94) (Family: none) | 1-7, 14, 20 - 23, 48 - 59 |
| X | | 10 - 13, 24 - 35, 42 - 44, 47 |
| A | JP, 4-224898, A (Central Glass Co., Ltd.), August 14, 1992 (14. 08. 92) (Family: none) | 8 - 9 |
| A | JP, 4-227695, A (Hoechst AG.), August 17, 1992 (17. 08. 92) (Family: none) | 8 - 9 |
| A | JP, 6-211718, A (Solvay Fluor und Derivate GmbH.), August 2, 1994 (02. 08. 94) & EP, 583719, A1 & DE, 4227130, A1 & FI, 9303605, A & TW, 251318, A | 18 - 19, 60 |
| Y | JP, 61-149204, A (Aska Seiki Sangyo K.K.), July 7, 1986 (07. 07. 86) (Family: none) | 48 - 53 |
| Y | JP, 4-145988, A (Japan Field Co., Ltd.), May 19, 1992 (19. 05. 92) (Family: none) | 48 - 53 |
| Y | JP, 3-238072, A (Japan Field Co., Ltd.), October 23, 1991 (23. 10. 91) (Family: none) | 54 - 56, 58 |

Form PCT/ISA/210 (continuation of second sheet) (July 1992)